(19) Europäisches Patentamt
European Patent Office
Office européen des brevets

(11) EP 3 850 680 B1

(12) **EUROPÄISCHE PATENTSCHRIFT**

(45) Veröffentlichungstag und Bekanntmachung des Hinweises auf die Patenterteilung:
**06.11.2024 Patentblatt 2024/45**

(21) Anmeldenummer: **19768793.2**

(22) Anmeldetag: **12.09.2019**

(51) Internationale Patentklassifikation (IPC):
***H10K 50/12*** *(2023.01)*

(52) Gemeinsame Patentklassifikation (CPC):
**H10K 50/121;** H10K 50/11; H10K 85/342; H10K 85/622; H10K 85/623; H10K 85/654; H10K 85/6572; H10K 2101/40

(86) Internationale Anmeldenummer:
**PCT/EP2019/074291**

(87) Internationale Veröffentlichungsnummer:
**WO 2020/053315 (19.03.2020 Gazette 2020/12)**

(54) **ELEKTROLUMINESZIERENDE VORRICHTUNGEN**

ELECTROLUMINESCENT DEVICES

DISPOSITIFS ÉLECTROLUMINESCENTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.09.2018 EP 18194122**

(43) Veröffentlichungstag der Anmeldung:
**21.07.2021 Patentblatt 2021/29**

(73) Patentinhaber: **Merck Patent GmbH**
**64293 Darmstadt (DE)**

(72) Erfinder:
- **STENGEL, Ilona**
  **64297 DARMSTADT (DE)**
- **MORHERR, Antonia**
  **63069 OFFENBACH (DE)**
- **MAY, Falk**
  **55124 MAINZ (DE)**
- **LACKNER, Aaron**
  **68165 MANNHEIM (DE)**
- **PFLUMM, Christof**
  **64291 DARMSTADT (DE)**
- **MEKIC, Amel**
  **64283 DARMSTADT (DE)**
- **HAASE, Nils**
  **64285 DARMSTADT (DE)**

(74) Vertreter: **Merck Patent Association**
**Merck Patent GmbH**
**64271 Darmstadt (DE)**

(56) Entgegenhaltungen:
**US-A1- 2011 303 903**

- **CHENG G ET AL: "Highly efficient white organic light-emitting devices based on a multiple-emissive-layer structure", THIN SOLID FILMS, ELSEVIER, AMSTERDAM, NL, vol. 516, no. 15, 2 June 2008 (2008-06-02), pages 5133 - 5136, XP022622360, ISSN: 0040-6090, [retrieved on 20071203], DOI: 10.1016/J.TSF.2007.10.115**
- **FREITAG P ET AL: "Lambertian white topemitting organic light emitting device with carbon nanotube cathode", JOURNAL OF APPLIED PHYSICS, AMERICAN INSTITUTE OF PHYSICS, US, vol. 112, no. 11, 1 December 2012 (2012-12-01), pages 114505 - 114505, XP012167226, ISSN: 0021-8979, [retrieved on 20121204], DOI: 10.1063/1.4767439**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

## Beschreibung

Die vorliegende Erfindung betrifft organische Elektrolumineszierende Vorrichtungen sowie Zusammensetzungen enthaltend unterschiedliche organische funktionelle Materialien.

Der Aufbau organischer Elektrolumineszenzvorrichtungen, insbesondere von OLEDs (organische lichtemittierende Dioden), in denen organische Halbleiter als funktionelle Materialien eingesetzt werden, ist beispielsweise in US 4539507, US 5151629, EP 0676461 und WO 98/27136 beschrieben. Als emittierende Materialien werden häufig metallorganische Komplexe, die Phosphoreszenz zeigen, und fluoreszierende Emitter eingesetzt. Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, insbesondere auch bei OLEDs, die Phosphoreszenz zeigen, immer noch Verbesserungsbedarf, beispielsweise im Hinblick auf Effizienz, Betriebsspannung und Lebensdauer. Ferner sind organische Elektrolumineszenzvorrichtungen bekannt, die fluoreszierende Emitter oder Emitter umfassen, die TADF (thermally activated delayed fluorescence) zeigen.

Die Eigenschaften organischer elektrolumineszierender Vorrichtungen werden nicht nur durch die eingesetzten Emitter bestimmt. Hier sind insbesondere auch die anderen verwendeten Materialien, wie Host-/Matrixmaterialien, Lochblockiermaterialien, Elektronentransportmaterialien, Lochtransportmaterialien und Elektronen- bzw. Exzitonenblockiermaterialien von besonderer Bedeutung. Verbesserungen dieser Materialien können zu deutlichen Verbesserungen elektrolumineszierender Vorrichtungen führen.

Gemäß dem Stand der Technik gibt es unterschiedliche Ansätze, die Leistungsdaten organischer Elektrolumineszenzvorrichtungen weiter zu verbessern. In WO 2015/091716 A1 und in WO 2016/193243 A1 werden OLEDs offenbart, die in der Emissionsschicht sowohl eine phosphoreszierende Verbindung als auch einen fluoreszierenden Emitter enthalten, wobei die Energie von der phosphoreszierenden Verbindung auf den fluoreszierenden Emitter übertragen wird. Die phosphoreszierende Verbindung verhält sich in diesem Zusammenhang demnach wie ein HostMaterial. Wie der Fachmann weiß, haben Hostmaterialien höhere Singulett und Triplett-Energien im Vergleich zu dem Emittern, damit die Energie des Host-Materials auch möglichst optimal auf den Emitter übertragen werden. Die im Stand der Technik offenbarten Systeme weisen genau solch eine Energierelation auf. Weitere OLEDs sind in US 2011/303903 A1, Cheng et al. (CHENG G ET AL: "Highly efficient white organic light-emitting devices based on a multiple-emissive-layer structure", THIN SOLID FILMS, ELSEVIER, AMSTERDAM, NL, Bd. 516, Nr. 15, 2. Juni 2008, Seiten 5133 - 5136) und Freitag et al. (FREITAG P ET AL: "Lambertian white topemitting organic light emitting device with carbon nanotube cathode", JOURNAL OF APPLIED PHYSICS, AMERICAN INSTITUTE OF PHYSICS, US, Bd. 112, Nr. 11, 1. Dezember 2012, Seiten 114505-1 - 114505-5) offenbart.

Die vorliegende Erfindung betrifft eine fluoreszierende elektronische Vorrichtung wie in Anspruch 1 definiert, enthaltend einen Sensitizer und einen fluoreszierenden Emitter, wobei der Sensitizer eine phosphoreszierende Verbindung ist und wobei der fluoreszierende Emitter eine sterisch abgeschirmte Verbindung ist, die einen *Shielding Factor* (SF) Faktor von größer oder gleich 0,5, besonders bevorzugt größer oder gleich 0,6 und insbesondere bevorzugt größer oder gleich 0,65 aufweist.

Ferner ist bevorzugt, wenn wenigstens eine der beiden folgenden Bedingungen (I) oder (II) erfüllt sein muss, wobei bevorzugt ist, wenn Bedingung (I) erfüllt ist:

$$S_1^K(FE) - S_1^K(S) \geq X \quad \text{(I)}$$

$$S_1^{max}(FE) - S_1^{max}(S) \geq Y \quad \text{(II)}$$

wobei für die verwendeten Parameter gilt:

X, Y, sind jeweils -0,5 eV;

$S_1^K(FE)$ ist die Energie des ersten angeregten Singulett-Zustandes des fluoreszierenden Emitters, die aus der Kante auf der Seite der kurzen Wellenlänge des normierten Photolumineszenzspektrums des fluoreszierenden Emitters ermittelt wird;

$S_1^K(S)$ ist die Energie des ersten angeregten Zustandes des Sensitizers, die aus der Kante auf der Seite der kurzen Wellenlänge des normierten Photolumineszenzspektrums des Sensitizers ermittelt wird;

$S_1^{max}(FE)$ ist die Energie des ersten angeregten Singulett-Zustandes des fluoreszierenden Emitters, die aus der Lage des ersten Maximums bei kurzen Wellenlängen des Photolumineszenzspektrums des fluoreszierenden Emit-

ters ermittelt wird;

$S_1^{max}(S)$ ist die Energie des ersten angeregten Zustandes des Sensitizers, die aus der Lage des ersten Maximums bei kurzen Wellenlängen des Photolumineszenzspektrums des Sensitizers ermittelt wird;

wobei die Photolumineszenzspektren des Sensitizers und des fluoreszierenden Emitters bei einer Konzentration von 1 mg in 100 ml Toluol bei Raumtemperatur aus Lösung bestimmt werden.

Weitere Einzelheiten zur Bestimmung der angegebenen Parameter können dem Beispielteil der vorliegenden Erfindung entnommen werden.

Die experimentelle Bestimmung der Energiewerte ist in den Beispielen offenbart. Die Energien sind nach diesem Verfahren zu bestimmen.

Wellenlängen haben in der vorliegenden Erfindung immer in der Einheit nm. Eine Formulierung wie "auf der Seite der kurzen Wellenlänge des normierten Photolumineszenzspektrums" bedeutet also, dass man sich von kleinen Wellenlängen in nm (z.B. von 300nm) zu größeren Wellenlängen in nm (z.B. 700nm) bewegt. Kürzere Wellenlängen bedeuten also immer auch höhere Energie. Für die hierin angegebenen Bedingungen werden die Wellenlängen von der Einheit nm in die Einheit eV umgerechnet.

Es hat sich gezeigt, dass solche erfindungsgemäßen Vorrichtungen besonders gute Leistungsdaten aufweisen, insbesondere sehr gute Effizienzen, Lebensdauern und auch niedrige Spannungen.

Gemäß der vorliegenden Erfindung handelt es sich bei dem fluoreszierenden Emitter um einen sterisch abgeschirmten fluoreszierenden Emitter.

Die sterische Abschirmung wird über den Parameter "Shielding Faktor (SF)" bestimmt. In der vorliegenden Erfindung wird der Shielding-Faktor (SF), auch Abschirmparameter genannt, nach dem folgenden Verfahren ermittelt.

Für dem fluoreszierenden Emitter (auch fluoreszierende Verbindung genannt) wird eine quantenchemische Rechnung durchgeführt, z.B. mit Hilfe des Programmpakets Gaussian09 Rev. E.01. Zuerst wird die Singulettgrundzustandsgeometrie mit B3PW91/6-31G(d) optimiert. Für diese optimierte Geometrie wird eine Triplett-Single-Point-Rechnung mit B3PW91/6-31G(d) (Multiplizität 3; UDFT) durchgeführt, aus welcher die Triplettelektronendichte erhalten wird. Die Singulettgrundzustandselektronendichte wird ebenfalls aus einer Single-Point-Rechnung mit B3PW91/631-G(d) für die optimierte Geometrie erhalten. Der Absolutwert der Differenz zwischen der Triplett- und der Singulettelektronendichte (Singulettelektronendichte = Elektronendichte des Singulettgrundzustands) ist eine ortsabhängige Größe und wird als Triplettdichte bezeichnet. Aus der Triplettdichte wird die Triplettfläche bestimmt. Dabei handelt es sich um jene Fläche, für welche die Triplettdichte $2*10^{-4}$ beträgt, d.h. es ist die Isofläche der Triplettdichte mit Isowert $2*10^{-4}$. Für alle Rechnungen werden die Standardkonvergenzkriterien von Gaussian09 verwendet.

Von der fluoreszierenden Verbindung wird weiterhin die "solvent-excluded surface" (auch bezeichnet als Connolly-Oberfläche) berechnet. Dies ist die Oberfläche des "solvent-excluded volume" (Micheal L. Connolly, "Computation of Molecular Volume", J. Am. Chem. Soc., 1985, Vol. 107, p. 1118-1124). Betrachtet man das Van-der-Waals Volumen der fluoreszierenden Verbindung als hart, d.h. als Volumen, das nicht durchdrungen werden kann, so ist das solvent-excluded volume im Sinne der vorliegenden Erfindung der Teil des Raums, der von einer harten Kugel mit Radius 0.4 nm nicht eingenommen werden kann. Die "solvent-excluded surface" kann z.B. nach dem in Xu D, Zhang Y (2009), "Generating Triangulated Macromolecular Surfaces by Euclidean Distance Transform" PLoS ONE 4(12): e8140 (doi: 10.1371/journal.pone.0008140) beschriebenen Algorithmus berechnet werden. Der Algorithmus ist z.B. im frei zugänglichen Programmpaket EDTSurf implementiert. Die Van-der-Waals Radien rVDW, die für die Berechnung verwendet werden, sind in folgender Tabelle zusammengefasst:

| Element | Ca | C | N | O | S | H | P | Ne | Fe | Alle anderen |
|---|---|---|---|---|---|---|---|---|---|---|
| $r_{VDW}$ (Å) | 1.9 | 1.88 | 1.63 | 1.48 | 1.78 | 1.2 | 1.97 | 1.63 | 0.74 | 1.8 |

Im nächsten Schritt wird auf der solvent-excluded surface der vorzeichenbehaftete Abstand d zwischen Triplettfläche und solvent-excluded surface berechnet. Die Vorzeichenkonvention ist wie folgt: Liegt die solvent-excluded surface außerhalb der Triplettfläche (vom Schwerpunkt der fluoreszierenden Verbindung aus betrachtet), so ist das Vorzeichen positiv, ansonsten negativ.

Im Anschluss wird das Oberflächenintegral I der skalaren Funktion e-d/0.2nm über die solvent-excluded surface gebildet. Weiterhin wird die Gesamtfläche A der solvent-excluded surface bestimmt. Der Abschirmparameter SF ist definiert als SF=1-I/A.

Der Fachmann kann das Verfahren ohne Schwierigkeiten mit Hilfe kommerzieller Software in den Routineprozess zur Bestimmung molekülrelevanter Parameter implementieren.

Es hat sich gezeigt, dass der Shielding Faktor einen signifikanten Einfluss auf die Effizienz der elektronischen Vorrichtung hat.

Weiterhin bevorzugt im Sinne der Erfindung ist, wenn X und/oder Y -0,4 eV sind, bevorzugt -0,3 eV, ganz bevorzugt -0,2 eV, ganz besonders bevorzugt -0,1 eV, insbesondere bevorzugt 0,0 eV und am meisten bevorzugt 0,1 eV sind.

Es ist ferner bevorzugt wenn X größer oder gleich -0,2 eV ist, ganz bevorzugt größer oder gleich -0,15 eV, besonders bevorzugt größer oder gleich -0,1 eV, ganz besonders bevorzugt größer oder gleich -0,05 eV und am meisten bevorzugt größer oder gleich 0,00 eV.

Es ist ferner bevorzugt wenn Y größer oder gleich 0,00 eV ist, ganz bevorzugt größer als 0,00 eV, ganz besonders bevorzugt größer oder gleich 0,01 eV, insbesondere bevorzugt größer oder gleich 0,02 eV, außerordentlich bevorzugt größer oder gleich 0,03 eV, ganz außerordentlich bevorzugt größer oder gleich 0,05 eV, noch mehr bevorzugt größer oder gleich 0,07 und am meisten bevorzugt größer oder gleich 0,10 eV.

In einer bevorzugten Ausführungsform ist X größer oder gleich -0,2 eV und Y ist größer oder gleich 0,00 eV, ganz bevorzugt größer als 0,00 eV, ganz besonders bevorzugt größer oder gleich 0,01 eV, insbesondere bevorzugt größer oder gleich 0,02 eV, außerordentlich bevorzugt größer oder gleich 0,03 eV, ganz außerordentlich bevorzugt größer oder gleich 0,05 eV, noch mehr bevorzugt größer oder gleich 0,07 und am meisten bevorzugt größer oder gleich 0,10 eV.

In einer bevorzugten Ausführungsform ist X größer oder gleich -0,1 eV und Y ist größer oder gleich 0,00 eV, ganz bevorzugt größer als 0,00 eV, ganz besonders bevorzugt größer oder gleich 0,01 eV, insbesondere bevorzugt größer oder gleich 0,02 eV, außerordentlich bevorzugt größer oder gleich 0,03 eV, ganz außerordentlich bevorzugt größer oder gleich 0,05 eV, noch mehr bevorzugt größer oder gleich 0,07 und am meisten bevorzugt größer oder gleich 0,10 eV.

In einer bevorzugten Ausführungsform ist X größer oder gleich -0,05 eV und Y ist größer oder gleich 0,00 eV, ganz bevorzugt größer als 0,00 eV, ganz besonders bevorzugt größer oder gleich 0,01 eV, insbesondere bevorzugt größer oder gleich 0,02 eV, außerordentlich bevorzugt größer oder gleich 0,03 eV, ganz außerordentlich bevorzugt größer oder gleich 0,05 eV, noch mehr bevorzugt größer oder gleich 0,07 und am meisten bevorzugt größer oder gleich 0,10 eV.

In einer bevorzugten Ausführungsform ist X größer oder gleich 0,0 eV und Y ist größer oder gleich 0,00 eV, ganz bevorzugt größer als 0,00 eV, ganz besonders bevorzugt größer oder gleich 0,01 eV, insbesondere bevorzugt größer oder gleich 0,02 eV, außerordentlich bevorzugt größer oder gleich 0,03 eV, ganz außerordentlich bevorzugt größer oder gleich 0,05 eV, noch mehr bevorzugt größer oder gleich 0,07 und am meisten bevorzugt größer oder gleich 0,10 eV.

Es ist ferner bevorzugt, wenn Bedingung (I) erfüllt ist. Weiterhin bevorzugt ist, wenn Bedingung (II) erfüllt ist. Schließlich ist bevorzugt, wenn sowohl Bedingung (I) als auch Bedingung (II) erfüllt sind.

Es ist bevorzugt wenn der Sensitizer seine Energie, die er in der elektronischen Vorrichtung aufnimmt direkt auf den fluoreszierenden Emitter überträgt und der fluoreszierende Emitter vom Sensitizer aufgenommene Anregungsenergie durch Fluoreszenz emittiert.

Die Energieübertragung vom Sensitizer auf den fluoreszierenden Emitter kann über verschiedene Mechanismen erfolgen. Ein wichtiger Weg zur Übertragung der Energie scheint der Förster Resonanz Energietransfer (FRET oder auch FET) zu sein.

In einer bevorzugten Ausführungsform der vorliegenden Erfindung überlappt das Absorptionsspektrum des fluoreszierenden Emitters mit dem Photolumineszenz(emissions)spektrum des Sensitizers.

Weiterhin ist bevorzugt, wenn das Absorptionsspektrum des fluoreszierenden Emitters mit dem Photolumineszenzspektrum des Sensitizers überlappt und der Betrag des Abstands der Triplett-Metal-to-*Ligand-Charge-Transfer* ($^3$MLCT)-Bande des Photolumineszenzspektrums des Sensitizers und dem Absorptionsmaximum des fluoreszierenden Emitters die folgende Bedingung (III) erfüllt

$$\left|\lambda_{em}^{^3MLCT}(S) - \lambda_{abs}^{max}(FE)\right| \leq V \qquad \text{(III)}$$

wobei V gleich 0,5 eV ist, bevorzugt ist eine V von 0,4 eV, ganz bevorzugt ist ein V von 0,3 eV, besonders bevorzugt ist ein V von 0,2 eV, ganz besonders bevorzugt ist ein V von 0,15 eV und insbesondere bevorzugt ist ein V von 0,1 eV.

Die *Triplett-Metal-to-Ligand-Charge-Transfer* ($^3$MLCT)-Bande, charakterisiert durch die Größe $\lambda_{em}^{^3MLCT}(S)$, des Photolumineszenzspektrums des Sensitizers ergibt sich dabei aus der Kante bei kleinen Wellenlängen im Photolumineszenzspektrum des Sensitizers. Der Wert $\lambda_{em}^{^3MLCT}(S)$ ist also identisch mit dem bereits genannten Wert $S_1^K(S)$.

$\lambda_{abs}^{max}(FE)$ ist die Peakabsorptionswellenlänge des ersten Maximums bei langen Wellenlängen des fluoreszierenden Emitters. Beide Werte sind jeweils in Elektronenvolt berechnet.

Besonders bevorzugt ist, wenn die Bedingung (IV) erfüllt ist

$$\lambda_{em}^{3MLCT}(S) - \lambda_{abs}^{max}(FE) \leq W \qquad \text{(IV)}$$

wobei W gleich 0,5 ist, bevorzugt ist W gleich 0,4 eV, ganz bevorzugt ist W gleich 0,3 eV, besonders bevorzugt ist W gleich 0,2 eV, ganz besonders bevorzugt ist W gleich 0,15 eV und insbesondere bevorzugt ist W gleich 0,1 eV.

Der Förster Resonanz Energietransfer zwischen dem Sensitizer und dem fluoreszierenden Emitter kann mit Hilfe des Försterradius, $R^6_{FRET}$, beschrieben werden, der durch folgende Gleichung gegeben ist:

$$R_{FRET}^{6} = \frac{9\ln(10)\,\kappa^2\phi_S}{128\pi^5 N_A n^4} J(\lambda)$$

wobei $\kappa$ der Dipol-Orientierungsfaktor, $\phi_S$ die Quantenausbeute des Sensitizers, n der Brechungsindex des Mediums, $N_A$ die Avogadrokonstante und $J(\lambda)$ das spektrale Überlappungsintegral ist. Das spektrale Überlappungsintegral ist durch die folgende Gleichung definiert:

$$J(\lambda) = \int_0^\infty F_S(\lambda)\varepsilon_{FE}(\lambda)\lambda^4 d\lambda$$

wobei $\lambda$ die Wellenlänge, $F_s(\lambda)$ die normalisierte Strahlungsintensität des Pholotumineszenzspektrums des Sensitizers und $\varepsilon_{FE}$ der molare Absorptionskoeffizient des fluoreszierenden Emitters ist. Sowohl das Photolumineszenzspektrum zur Bestimmung von $F_s(\lambda)$ als auch das Absorptionsspektrum zur Bestimmung von $\varepsilon_{FE}$ werden aus Lösung der jeweiligen Verbindungen in Toluol gemessen. Um den Försterradius zu berechnen werden n=1,7 und $\kappa^2$=2/3 gesetzt.

Ein kleiner Försterradius ist dabei bevorzugt. Es ist bevorzugt, wenn der Försterradius kleiner ist als 3 nm, ganz bevorzugt ist er kleiner oder gleich 2,5 nm, ganz besonders bevorzugt ist er kleiner oder gleich 2,3 nm und insbesondere bevorzugt ist er kleiner oder gleich 2,1 nm. Es hat sich gezeigt, dass sich mit kleiner werdenden Försterradius die Lebensdauer elektronische Vorrichtungen deutlich verbessert.

In einer anderen Ausführungsform der vorliegenden Erfindung ist ein größerer Försterradius bevorzugt. Dieser führt zu einer größeren Effizienz der elektronischen Vorrichtung. Es ist bevorzugt, wenn der Försterradius größer oder gleich 2,5 nm, ganz bevorzugt größer oder gleich 2,7 nm, ganz besonders bevorzugt größer oder gleich 2,8 nm und insbesondere bevorzugt größer oder gleich 3,0 nm ist.

Eine phosphoreszierende Verbindung im Sinne der vorliegenden Erfindung ist vorzugsweise eine Verbindung, die in der Lage ist, unter optischer oder elektro-chemischer Anregung in einer Umgebung, wie sie in der organischen Elektrolumineszenzvorrichtung vorliegt, bei Raumtemperatur Licht zu emittieren, wobei die Emission aus einem spinverbotenen Übergang erfolgt, beispielsweise einem Übergang aus einem angeregten Triplett-Zustand oder einem gemischten Singulett-/Triplett-Zustand.

Als phosphoreszierende Verbindungen (im Folgenden auch kurz Triplettemitter genannt) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl.

Erfindungsgemäß handelt es sich bei dem Sensitizer um eine phosphoreszierende Verbindung aus der Gruppe der Organometallkomplexe, insbesondere aus der Gruppe der Übergangsmetallkomplexe, die Kupfer, Ruthenium, Osmium, Rhodium, Iridium, Palladium, oder Platin, enthalten, insbesondere Verbindungen, die Kupfer, Iridium oder Platin, und ganz bevorzugt Iridium und Platin enthalten. Im Sinne der vorliegenden Erfindung werden alle lumineszierenden Verbindungen, die die oben genannten Metalle enthalten, als phosphoreszierende Verbindungen angesehen.

Besonders bevorzugt werden phosphoreszierende Oranometallkomplexe die in der Patentanmeldung WO2015/091716 beschrieben sind. Insbesondere phosphoreszierende Organometallkomplexe die beschrieben sind in WO00/70655, WO2001/41512, WO2002/02714, WO2002/15645, EP1191612, WO2005/033244, WO2005/019373, US2005/0258742, WO2006/056418, WO2007/115970, WO2007/115981, WO2008/000727, WO2009/050281, WO2009/050290, WO2011/051404, WO2011/073149, WO2012/121936, US2012/0305894, WO2012/170571, WO2012/170461, WO2012/170463, WO2006/121811, WO2007/095118, WO2008/156879, WO2008/156879,

WO2010/068876, WO2011/106344, WO2012/172482, EP3126371, WO2015/014835, WO2015/014944, WO2016/020516, US2016/0072081, WO2010/086089, WO2011/044988, WO2014/008982, WO2014/023377, WO2014/094961, WO2010/069442, WO2012/163471, WO2013/020631, US2015/0243912, WO2008/000726, WO2010/015307, WO2010/054731, WO2010/054728, WO2010/099852, WO2011/032626, WO2011/157339, WO2012/007086, WO2015/036074, WO2015/104045, WO2015/117718, WO2016/015815, wobei es sich vorzugsweise um Iridium und Platinkomplexe handelt.

Dazu gehören insbesondere auch Organometallkomplexe mit polypodalen Liganden wie sie beschrieben sind in WO2004081017, WO2005042550, US20050170206, WO2009/146770, WO2010/102709, WO2011/066898, WO2016124304, WO2017032439, WO2018019688, EP3184534, WO2018/011186, WO 2016/193243 und WO 2015/091716A1.

Des Weiteren gehören dazu auch binucleare Organometallkomplexe wie sie beschrieben sind in WO2011/045337, US2015/0171350, WO2016/079169, WO2018/019687, WO2018/041769, WO2018/054798, WO2018/069196, WO2018/069197, WO2018/069273.

Des Weiteren gehören dazu auch Kupferkomplexe wie sie beschrieben sind in WO2010/031485, US2013/150581, WO2013/017675, WO2013/007707, WO2013/001086, WO2012/156378, WO2013/072508, EP2543672.

Beispiele für geeignete phosphoreszierende Palladiumkomplexe sind beschrieben in WO2014/109814.

Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

In einer bevorzugten Ausführungsform der Erfindung liegt bei Herstellung der emittierenden Schicht durch Aufdampfen die phosphoreszierende Verbindung in einer Konzentration von 5 bis 99,9 Vol.-% in der emittierenden Schicht vor, bevorzugt von 5 bis 60 Vol.-%, besonders bevorzugt von 10 bis 50 Vol.-%, ganz besonders bevorzugt 20 bis 40 Vol.-%, wobei sich die angegebenen Volumen-% (Vol.-%) auf das Gesamtvolumen der emittierenden Schicht beziehen.

In einer weiterhin bevorzugten Ausführungsform der Erfindung liegt bei Herstellung der emittierenden Schicht durch Aufdampfen die phosphoreszierende Verbindung in einer Konzentration von 5 bis 99,9 Vol.% in der emittierenden Schicht vor, bevorzugt von 5 bis 60 Vol.-%, besonders bevorzugt von 5 bis 45 Vol.-%, ganz besonders bevorzugt 5 bis 30 Vol.-%, wobei sich die angegebenen Volumen-% (Vol.-%) auf das Gesamtvolumen der emittierenden Schicht beziehen.

In noch einer weiterhin bevorzugten Ausführungsform der Erfindung liegt bei Herstellung der emittierenden Schicht durch Aufdampfen die phosphoreszierende Verbindung in einer Konzentration von 1 bis 50 Vol.-% in der emittierenden Schicht vor, bevorzugt von 2 bis 40 Vol.-%, besonders bevorzugt von 3 bis 30 Vol.-%, ganz besonders bevorzugt 4 bis 25 Vol.-%, wobei sich die angegebenen Volumen-% (Vol.-%) auf das Gesamtvolumen der emittierenden Schicht beziehen.

In einer bevorzugten Ausführungsform der Erfindung liegt bei Herstellung der emittierenden Schicht aus Lösung die phosphoreszierende Verbindung in einer Konzentration von 5 bis 99,9 Gew.-% in der emittierenden Schicht vor, bevorzugt von 5 bis 60 Gew.-%, besonders bevorzugt von 10 bis 50 Gew.-%, ganz besonders bevorzugt 20 bis 40 Gew.-%, wobei sich die angegebenen Massen-% (Gew.-%) auf die Gesamtmasse der emittierenden Schicht beziehen.

In einer weiterhin bevorzugten Ausführungsform der Erfindung liegt bei Herstellung der emittierenden Schicht aus Lösung die phosphoreszierende Verbindung in einer Konzentration von 5 bis 99,9 Gew.-% in der emittierenden Schicht vor, bevorzugt von 5 bis 60 Gew.-%, besonders bevorzugt von 5 bis 45 Gew.-%, ganz besonders bevorzugt 5 bis 30 Gew.%, wobei sich die angegebenen Massen-% (Gew.-%) auf die Gesamtmasse der emittierenden Schicht beziehen.

In noch einer weiterhin bevorzugten Ausführungsform der Erfindung liegt bei Herstellung der emittierenden Schicht aus Lösung die phosphoreszierende Verbindung in einer Konzentration von 1 bis 50 Gew.% in der emittierenden Schicht vor, bevorzugt von 2 bis 40 Gew.-%, besonders bevorzugt von 3 bis 30 Gew.-%, ganz besonders bevorzugt 4 bis 25 Gew.-%, wobei sich die angegebenen Massen-% (Gew.-%) auf die Gesamtmasse der emittierenden Schicht beziehen.

Explizite Beispiele für phosphoreszierende Sensitizer sind $Ir(ppy)_3$ und dessen Derivate sowie die in der folgenden Übersichte aufgeführten Strukturen.

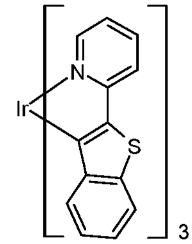

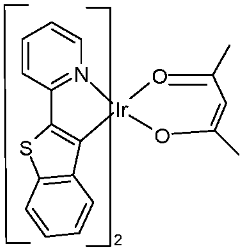

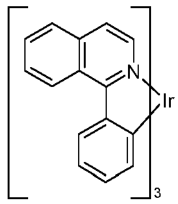

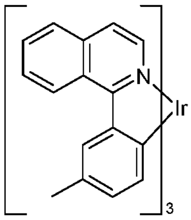

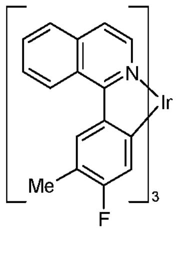

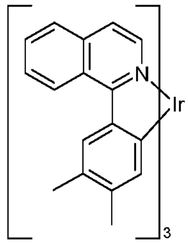

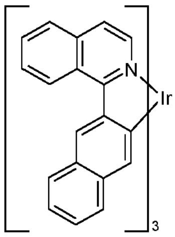

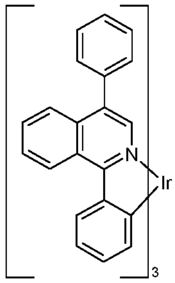

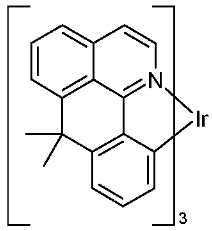

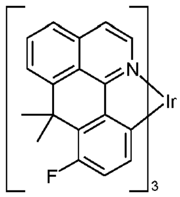

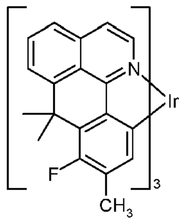

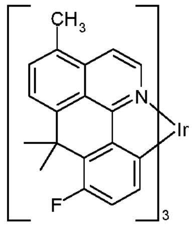

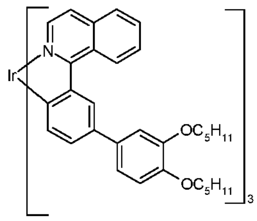

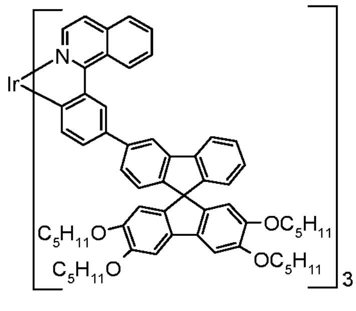

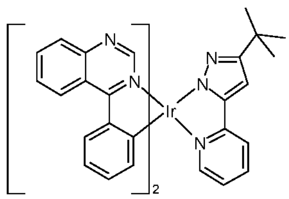

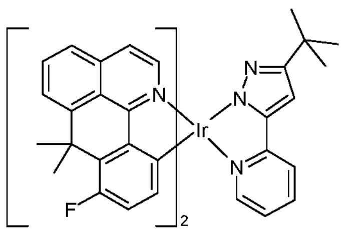

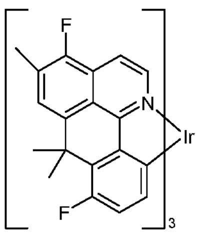

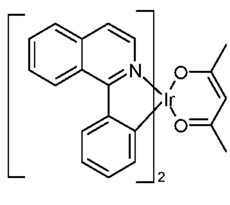

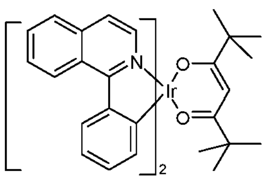
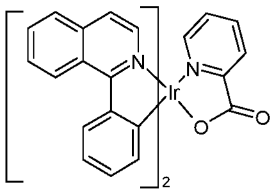
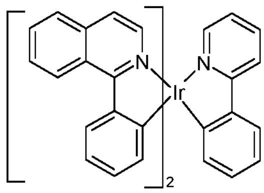

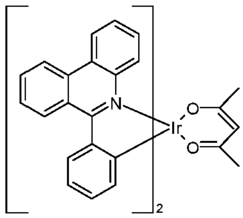
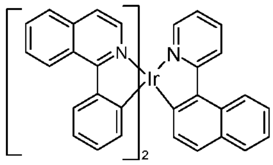
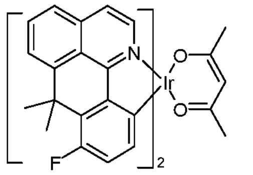

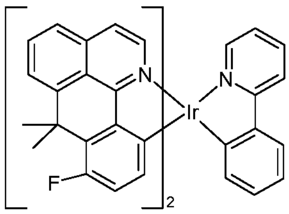
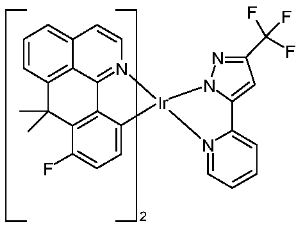
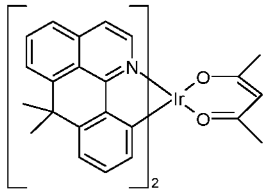

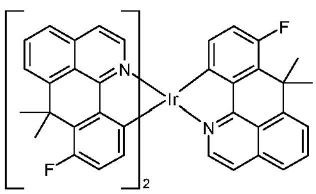
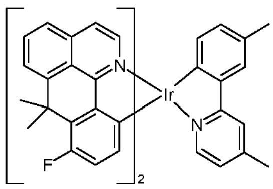
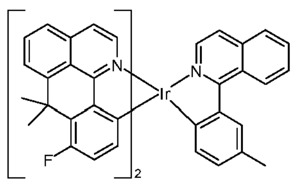

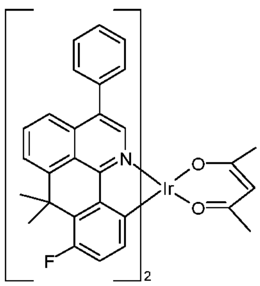
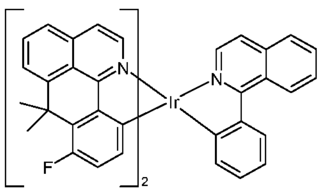
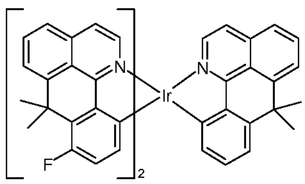

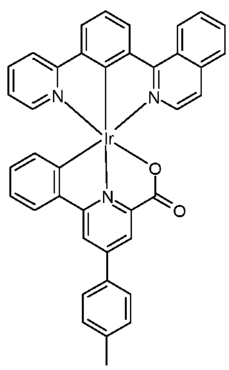
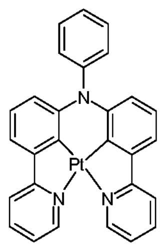
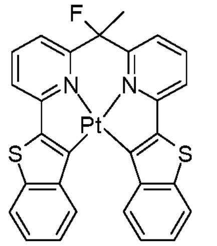

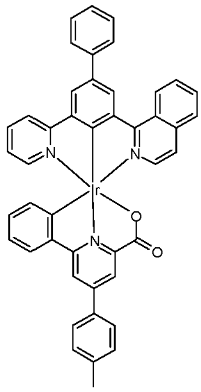

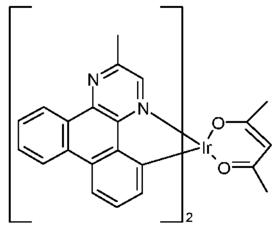

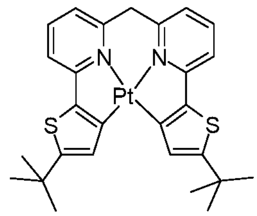

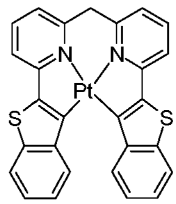

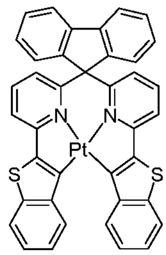

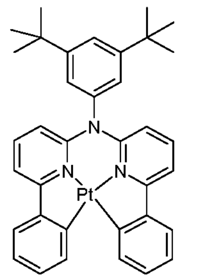

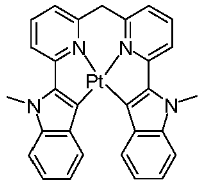

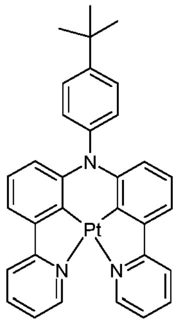

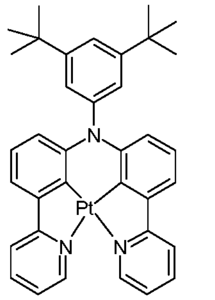

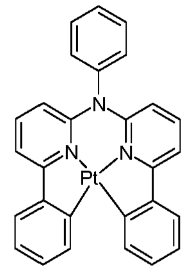

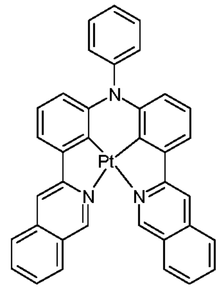

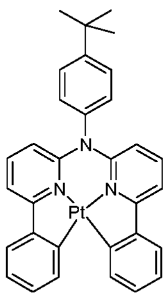

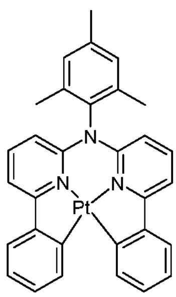

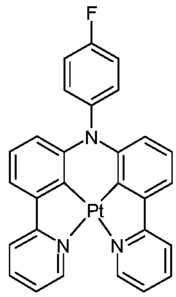

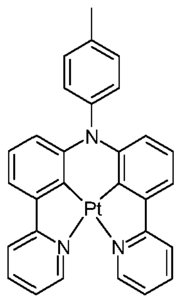

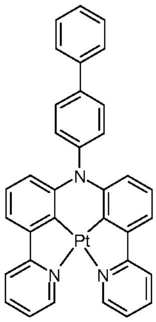

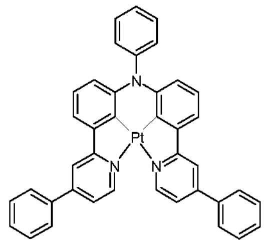

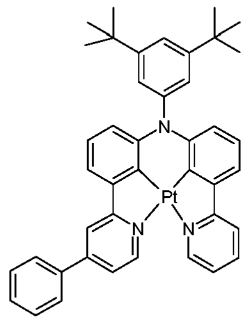

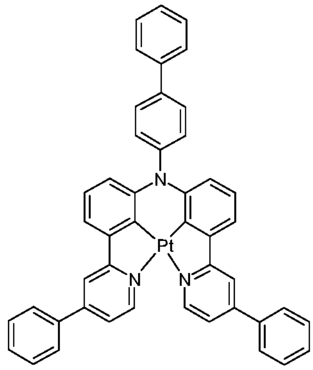

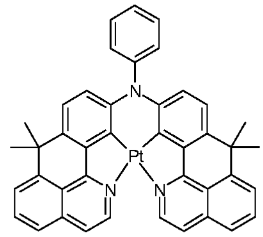

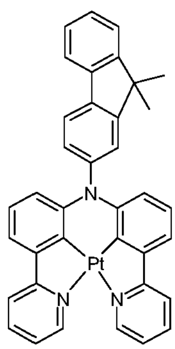

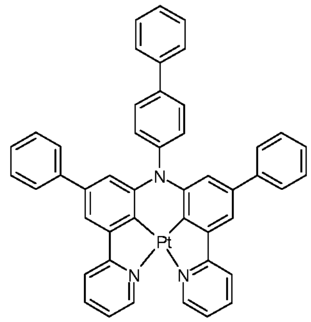

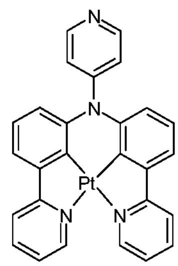

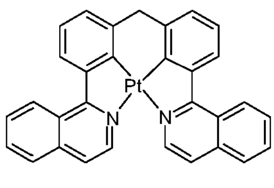

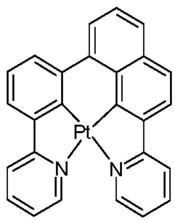

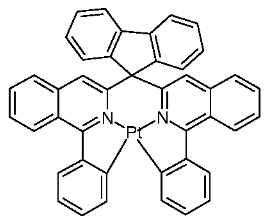

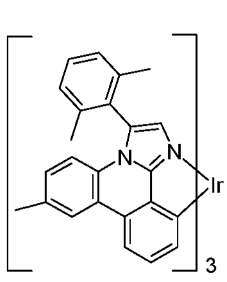

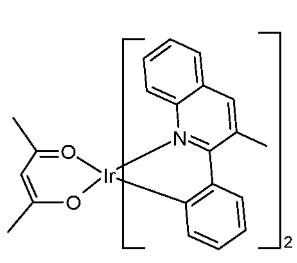

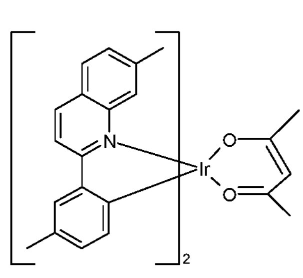

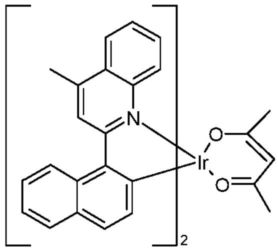

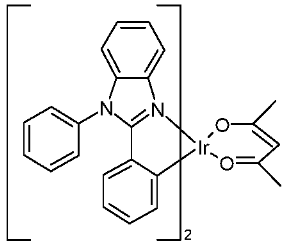

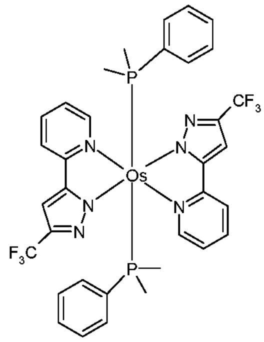

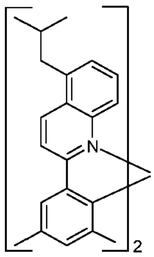

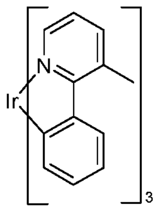

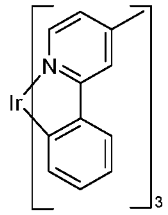

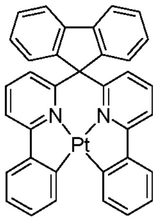

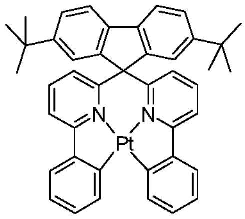

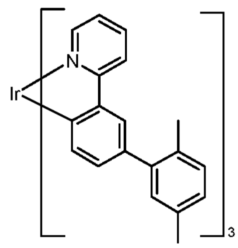

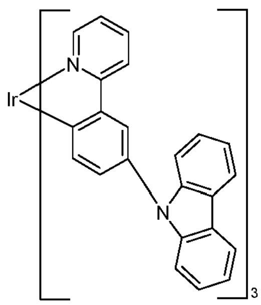

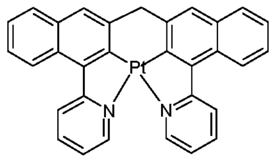

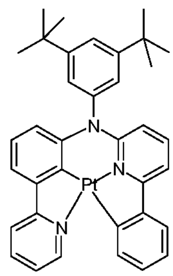

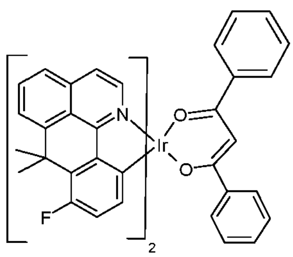

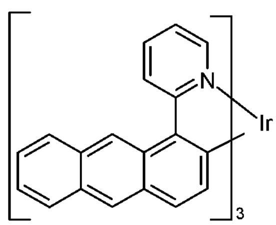

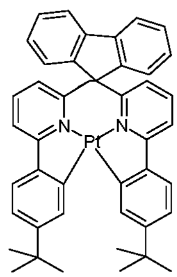

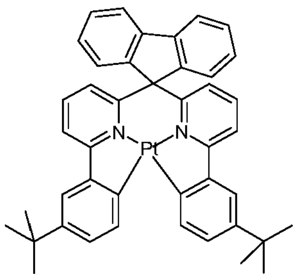
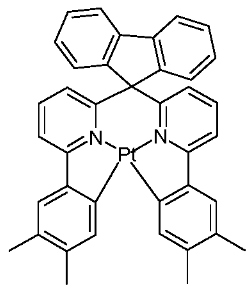
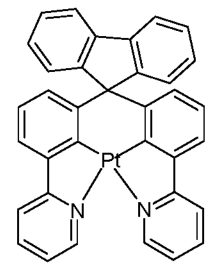

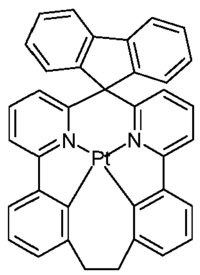
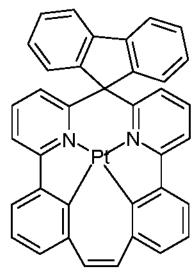
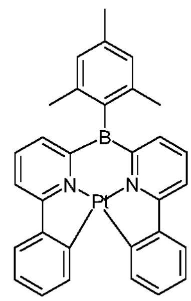

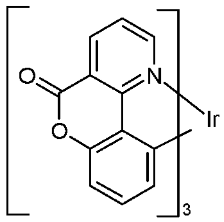
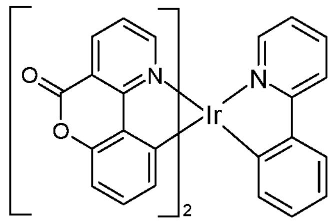
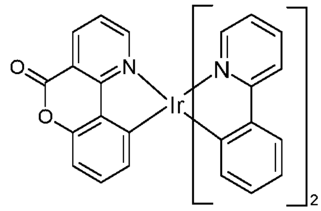

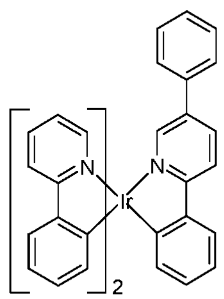
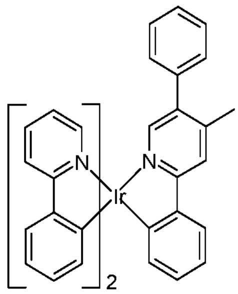
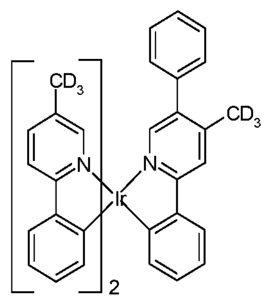

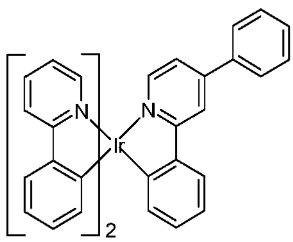
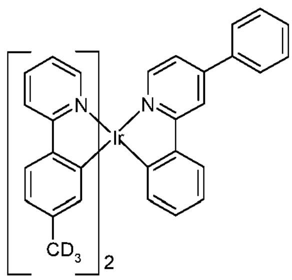
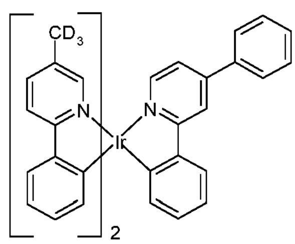

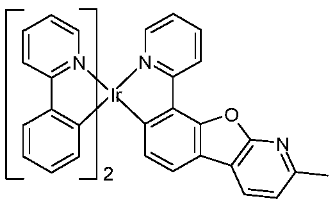
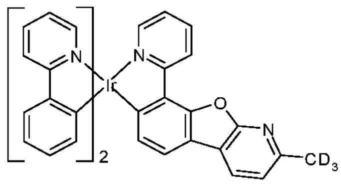
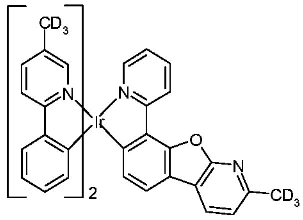

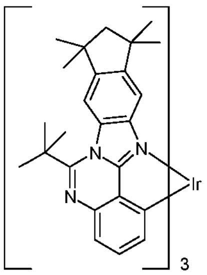
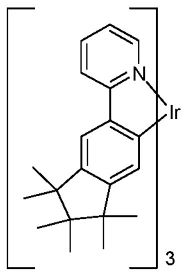
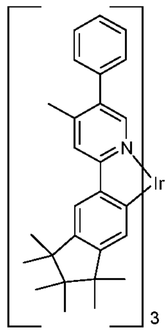

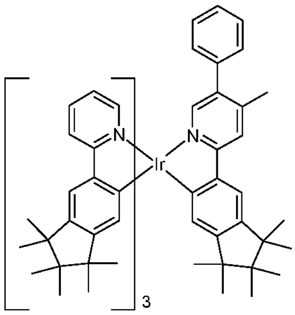
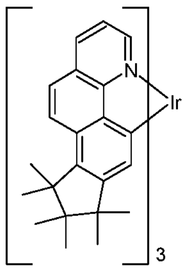
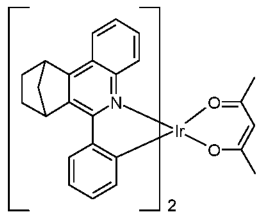

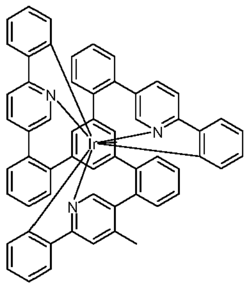
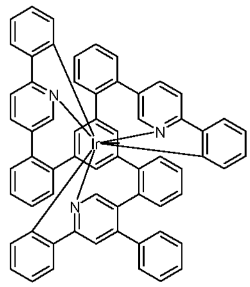
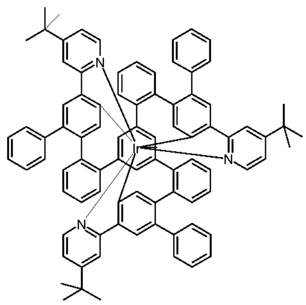

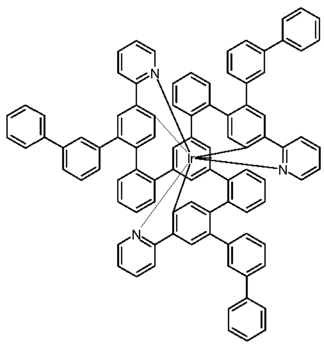
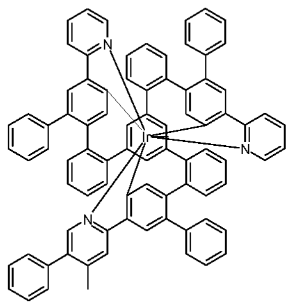
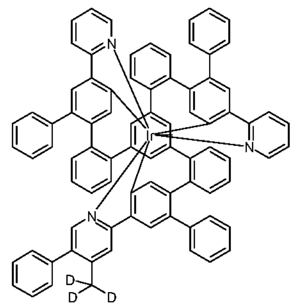

Weitere explizite Beispiele für phosphoreszierende Sensitizer sind Iridium- und Platinkomplexe enthaltend

Carbeneliganden sowie die in der folgenden Übersichte aufgeführten Strukturen, wobei homoleptische sowie heteroleptische Komplexe und meridonale sowie faciale Isomere geeignet sind:

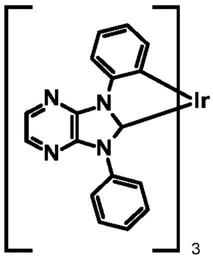
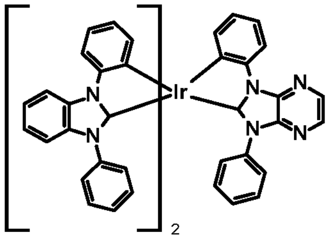
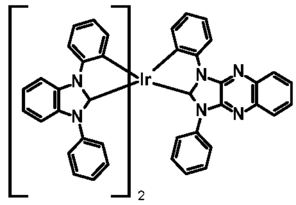

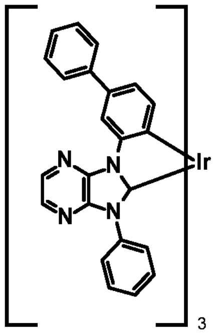
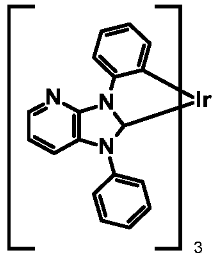
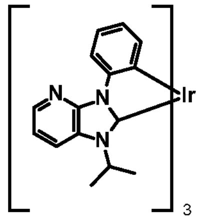

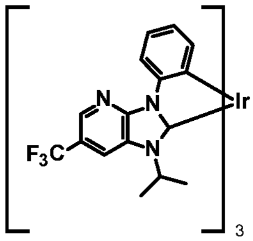
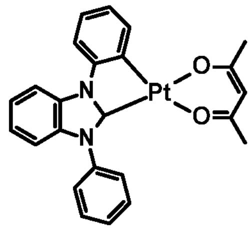
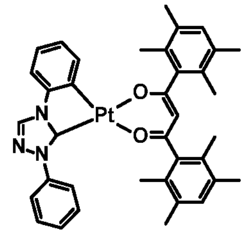

Weitere explizite Beispiele für phosphoreszierende Sensitizer sind Kupferkomplexe sowie die in der folgenden Übersichte aufgeführten Strukturen:

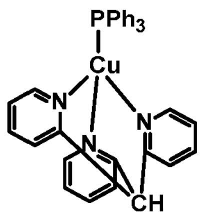
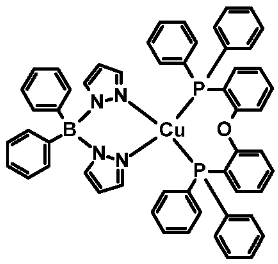
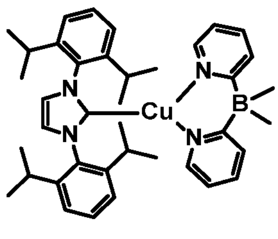

Erfindungsgemäß handelt es sich bei den fluoreszierenden Emittern um rein organische Verbindungen ohne Metalle oder Metallionen, die sterisch abgeschirmt ist.

Im Folgenden wird der erfindungsgemäße fluoreszierende Emitter, auch fluoreszierende Verbindung genannt, genauer beschrieben.

Bei dem fluoreszierenden Emitter handelt es sich erfindungsgemäß um eine organische Verbindung, die entweder ausgewählt ist aus der Gruppe der kondensierten Aromaten mit 6 bis 60 aromatischen Ringatomen, wobei der aromatische Grundkörper aus den untenstehend aufgeführten Gruppen der Formeln (1) bis (50) ausgewählt ist, oder aus Verbindungen mit einem heteroaromatischen Grundkörper der untenstehend aufgeführten Gruppen der Formeln (51) bis (73). Eine organische Verbindung im Sinne der vorliegenden Erfindung ist eine kohlenstoffhaltige Verbindung, die keine Metalle enthält. Insbesondere ist die organische Verbindung aus den Elementen C, H, D, B, Si, N, P, O, S, F, Cl, Br und I aufgebaut.

Eine fluoreszierende Verbindung im Sinne der vorliegenden Erfindung ist eine Verbindung, die in der Lage ist, unter optischer Anregung in einer Umgebung, wie sie in der organischen Elektrolumineszenzvorrichtung vorliegt, bei Raumtemperatur Licht zu emittieren, wobei die Emission aus einem angeregten Singulettzustand erfolgt. Dabei weist die Verbindung bevorzugt eine Lumineszenzquanteneffizienz von mindestens 60 % auf, besonders bevorzugt von mindestens 80 %, ganz besonders bevorzugt von mindestens 90 % und insbesondere bevorzugt von mindestens 95 %. Dabei wird die Lumineszenzquanteneffizienz in einer Lösung in Toluol bestimmt. Wie die Bestimmung der Lumineszenzquantenausbeute im Sinne der vorliegenden Erfindung durchgeführt wird, ist im Teil "Allgemeine Beschreibung der Bestimmung der relevanten Parameter Teil 4" von WO 2015/135624 A1 ausführlich allgemein beschrieben.

In einer bevorzugten Ausführungsform liegt die Peakemissionswellenlänge der fluoreszierenden Verbindung zwischen 430 und 650 nm. Wie die Bestimmung der Peakemissionswellenlänge im Sinne der vorliegenden Erfindung durchgeführt wird, ist in den Beispielen der vorliegenden Erfindung beschrieben.

Aufgrund der unterschiedlichen Herstellung der organischen Elektrolumineszenzvorrichtung wird die Dotierkonzentration der fluoreszierenden Verbindung bei Herstellung der emittierenden Schicht durch Aufdampfen in Vol.-% und bei Herstellung der emittierenden Schicht aus Lösung in Gew.-% angegeben.

In einer bevorzugten Ausführungsform der Erfindung liegt bei Herstellung der emittierenden Schicht durch Aufdampfen die fluoreszierende Verbindung in einer Dotierkonzentration von 0,1 bis 25 Vol.-% in der emittierenden Schicht vor, bevorzugt von 1 bis 20 Vol.-%, besonders bevorzugt von 3 bis 10 Vol.-%.

In einer bevorzugten Ausführungsform der Erfindung liegt bei Herstellung der emittierenden Schicht aus Lösung die fluoreszierende Verbindung in einer Dotierkonzentration von 0,1 bis 25 Gew.-% in der emittierenden Schicht vor, bevorzugt von 1 bis 20 Gew.-%, besonders bevorzugt von 3 bis 10 Gew.-%.

Dabei ist es möglich, dass insbesondere bei einer geringen Dotierkonzentration der fluoreszierenden Verbindung die OLED eine Mischemission aus der fluoreszierenden Verbindung und einer Restemission der phosphoreszierenden Verbindung zeigt. Dies kann auch gezielt zur Erzeugung von Mischfarben genutzt werden.

Der fluoreszierende Emitter wird vorzugsweise ausgewählt aus den folgenden Gruppe der fluorezierenden Verbindungen: Styrylamine, Indenofluorene, ppolyaromatische Verbindungen, Anthracene, Tetracene, Xanthene, Perylene, Phenylene, Fluorene, Arylpyrene, Arylenevinylene, Rubrene, Coumarine, Rhodamine, Chinacridone, Dicyanomethylenpyrane, Thiopyrane, Polymethine, Pyrylium und Thiapyrylium Salze, Periflanthene, Indenoperylene, Bis(azinyl)imineborone, Bis(azinyl)methine, Carbostyryle, Monostyrylamine, Distyrylamine, Tristyrylamine, Tetrastyrylamine, Styrylphosphine, Styrylether, Arylamine, Indenofluorenamine und Indenofluorendiamines, Benzoindenofluorenamine, Benzoindenofluorendiamine, Dibenzoindenofluorenamine, Dibenzoindenofluorendiamine, substituierte oder unsubstituierte Tristilbenamine, Distyrylbenzene und Distyrylbiphenyle, Triarylamine, Triazolo Verbindungen, Naphthalene, Phenanthrene, Pyrene, Triazine, Chrysene, Decacyclene, Coronene, Tetraphenylcyclopentadiene, Pentaphenylcyclopentadiene, Spirofluorene, Pyrane, Oxazone, Benzoxazole, Benzothiazole, Benzimidazole, Pyrazine, Zimtsäureester, Diketopyrrolopyrrole und Acridone.

Weitere bevorzugte fluoreszierende Emitter werden bspw. in C. H. Chen et al.: "Recent developments in organic electroluminescent materials" Macromol. Symp. 125, (1997), 1-48 und "Recent progress of molecular organic electroluminescent materials and devices" Mat. Sci. and Eng. R, 39 (2002), 143-222 offenbart.

Die sterische Abschirmung dieser Verbindungen erfolgt dabei durch elektronisch inerte, sterisch anspruchsvolle Substituenten, die den elektronisch aktiven Kern der fluoreszierenden Verbindung umgeben und so weitgehend vom Kontakt zu benachbarten Molekülen in der Schicht abschirmen.

Der Grad der sterischen Abschirmung kann durch einen Abschirmparameter SF bestimmt werden.

Bevorzugt als fluoreszierende Verbindungen sind steife $\pi$-Systeme, die mit großen aliphatischen oder cycloaliphatischen Resten substituiert sind. Weiterhin kommen auch aromatische Substituenten, die durch aliphatische oder cycloaliphatische Reste substituiert sein können, in Frage, wenn diese sterisch so angeordnet sind, dass es sich nicht um aktive Gruppen im Sinne der vorliegenden Erfindung handeln, dass deren Anteil an den relevanten Molekülorbitalen also unter einem Grenzwert, wie hinten beschrieben, liegt. Dagegen sind beispielsweise Arylaminosubstituenten oder Heteroarylgruppen zu stark an HOMO (highest occupied molecular orbital) oder LUMO (lowest unoccupied molecular orbital) beteiligt und eignen sich somit nicht als abschirmende Gruppen.

Erfindungsgemäße aromatische Grundkörper fluoreszierender Verbindungen aus der Gruppe der kondensierten Aromaten mit 6 bis 60 aromatischen Ringatomen sind die im Folgenden aufgeführten Gruppen der Formeln (1) bis (50),

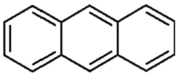

Formel (1)

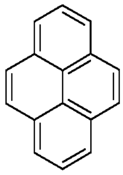

Formel (2)

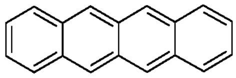

Formel (3)

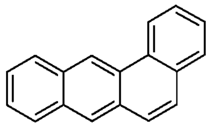

Formel (4)

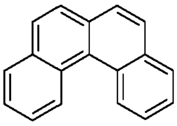

Formel (5)

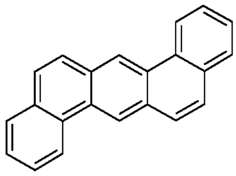

Formel (6)

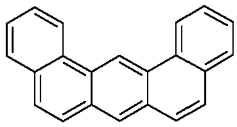

Formel (7)

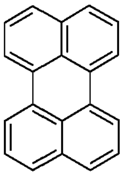

Formel (8)

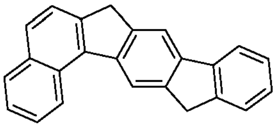

Formel (9)

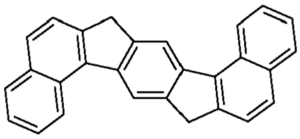

Formel (10)

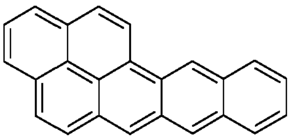

Formel (11)

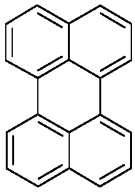

Formel (12)

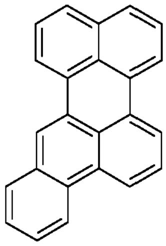

Formel (13)

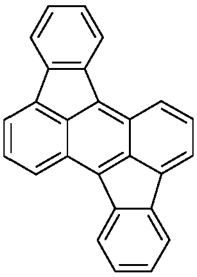

Formel (14)

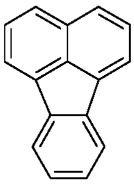

Formel (15)

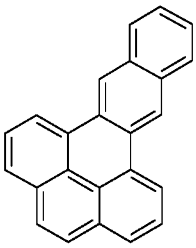

Formel (16)

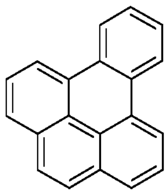

Formel (17)

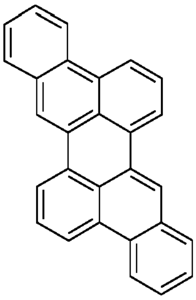

Formel (18)

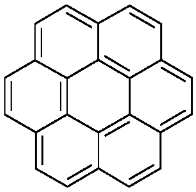

Formel (19)

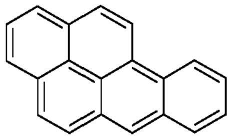

Formel (20)

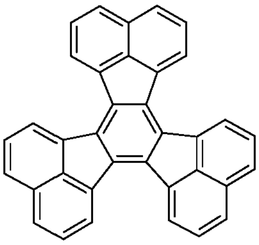

Formel (21)

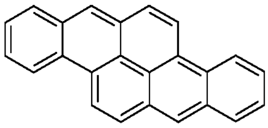

Formel (22)

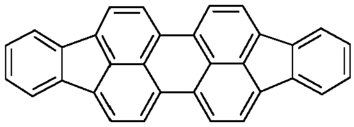

Formel (23)

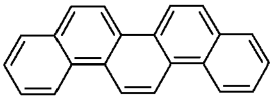

Formel (24)

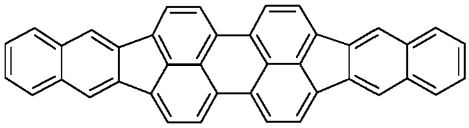

Formel (25)

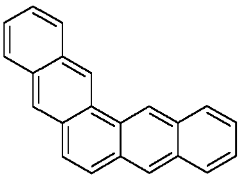

Formel (26)

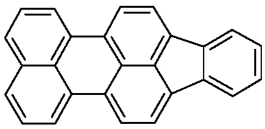

Formel (27)

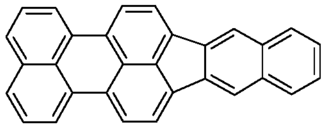

Formel (28)

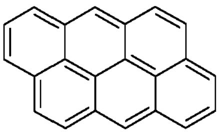

Formel (29)

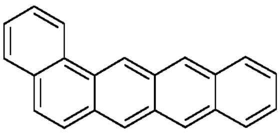

Formel (30)

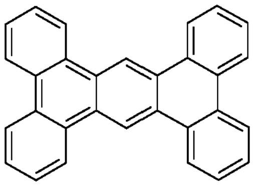

Formel (31)

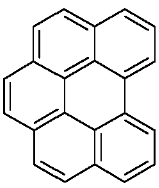

Formel (32)

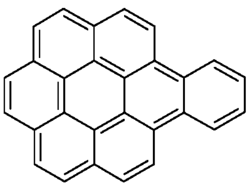

Formel (33)

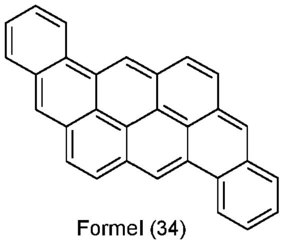

Formel (34)

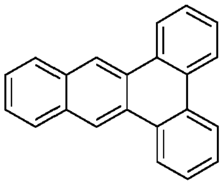

Formel (35)

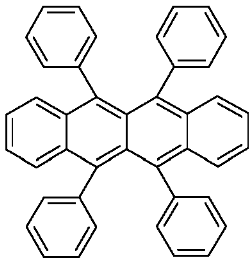

Formel (36)

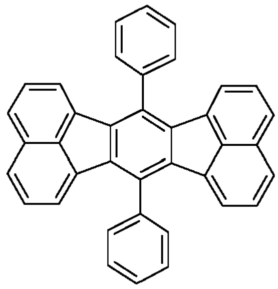

Formel (37)

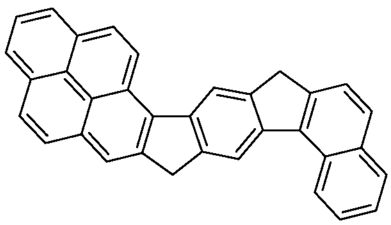

Formel (38)

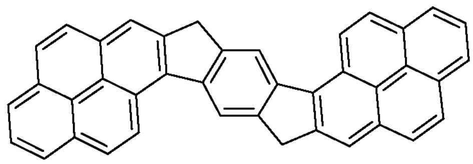

Formel (39)

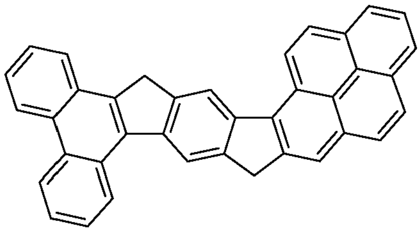

Formel (40)

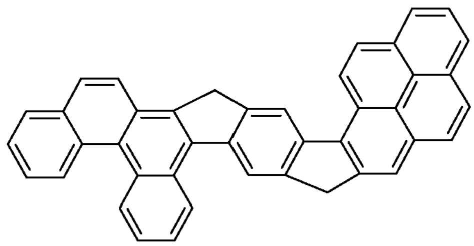

Formel (41)

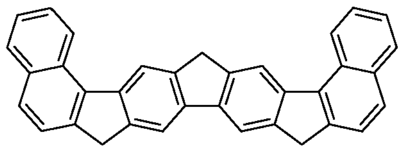

Formel (42)

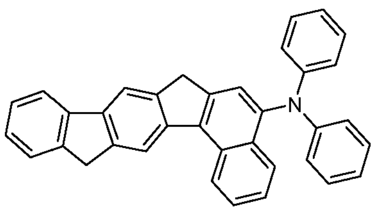

Formel (43)

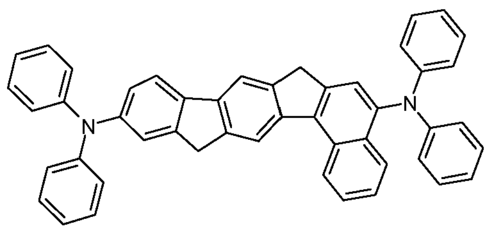

Formel (44)

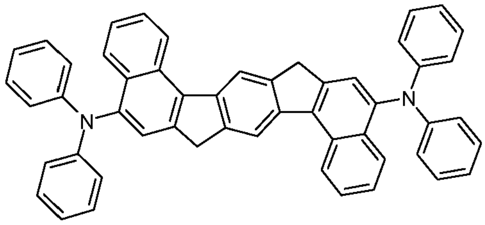

Formel (45)

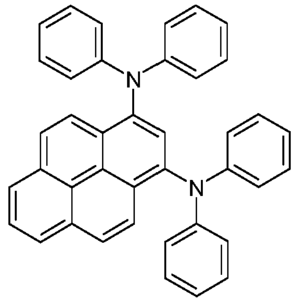

Formel (46)

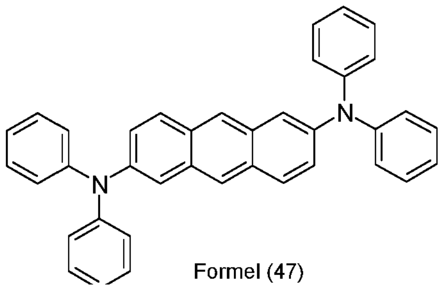

Formel (47)

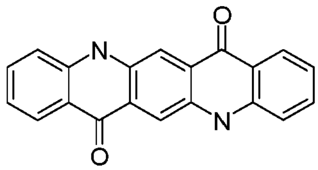

Formel (48)

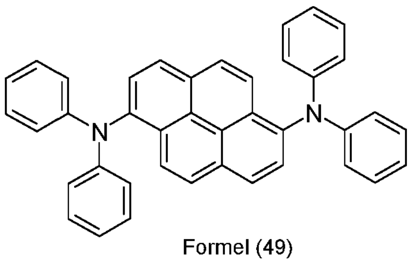

Formel (49)

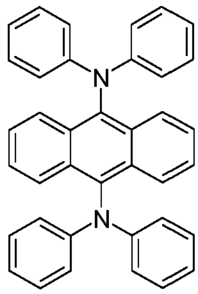

Formel (50)

Erfindungsgemäße heteroaromatische Grundkörper fluoreszierender Verbindungen sind weiterhin die im Folgenden aufgeführten Gruppen der Formeln (51) bis (73),

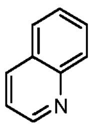

Formel (51)

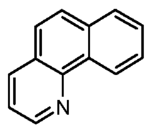

Formel (52)

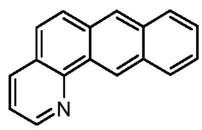

Formel (53)

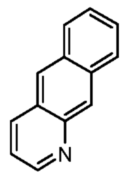

Formel (54)

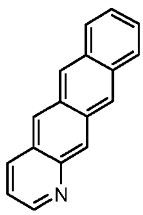

Formel (55)

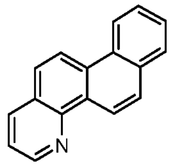

Formel (56)

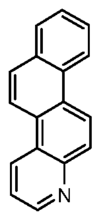

Formel (57)

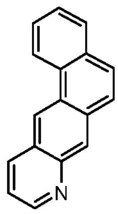

Formel (58)

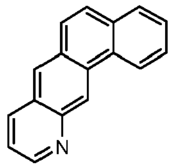

Formel (59)

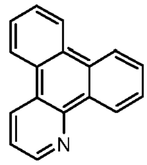

Formel (60)

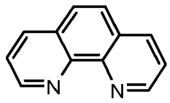

Formel (61)

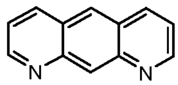

Formel (62)

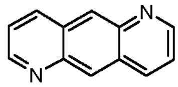

Formel (63)

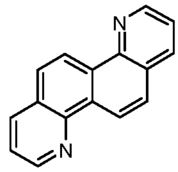

Formel (64)

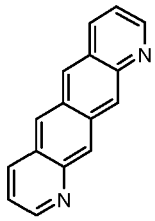

Formel (65)

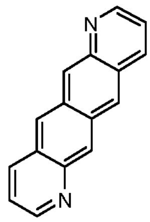

Formel (66)

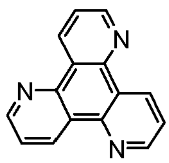

Formel (67)

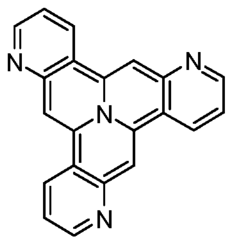

Formel (68)

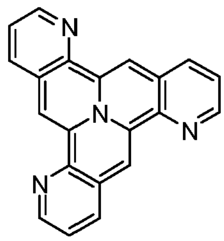

Formel (69)

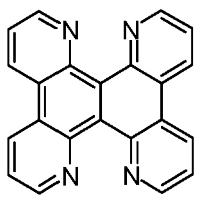

Formel (70)

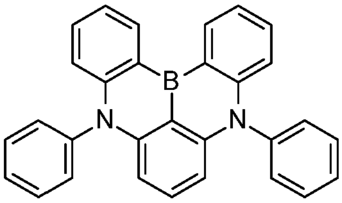

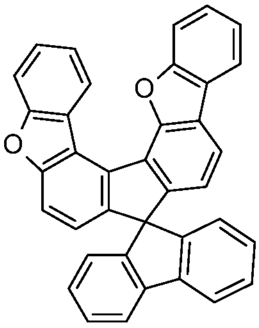

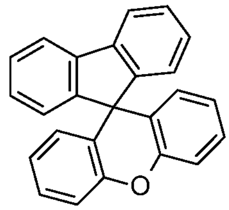

Formel (73)

Formel (71) Formel (72)

Dabei sind diese Strukturen, wie oben beschrieben, durch sterisch anspruchsvolle Substituenten substituiert und können auch durch weitere Substituenten, die nicht als sterisch anspruchsvoll angesehen werden können, substituiert sein, sofern diese Substituenten nicht elektronisch aktiv sind bzw. wiederum durch sterisch abgeschirmte Substituenten substituiert sind.

Im Folgenden werden geeignete, sterisch anspruchsvolle Substituenten beschrieben, die verwendet werden können, um die fluoreszierenden Kerne, z. B. die oben genannten Aromaten und Heteroaromaten, zu substituieren und so zu sterisch abgeschirmten fluoreszierenden Verbindungen zu gelangen.

Geeignete sterisch anspruchsvolle Substituenten sind beispielsweise Alkylgruppen, insbesondere mit 3 bis 20 C-Atomen, bevorzugt mit 4 bis 10 C-Atomen, in denen auch H-Atome durch F ersetzt sein können, Alkoxygruppen, insbesondere mit 3 bis 20 C-Atomen, bevorzugt mit 4 bis 10 C-Atomen, Aralkylgruppen, insbesondere mit 7 bis 30 C-Atomen, und aromatische Ringsysteme, insbesondere mit 6 bis 30 C-Atomen, wobei in den Aralkylgruppen und aromatischen Ringsystemen die Arylgruppen auch durch ein oder mehrere Alkylgruppen mit 1 bis 10 C-Atomen substituiert sein können. Dabei können auch mehrere benachbarte Substituenten ein Ringsystem miteinander bilden.

Wenn es sich bei dem Substituenten um eine Aralkylgruppe oder ein aromatisches Ringsystem handelt, so ist es bevorzugt, wenn diese keine kondensierten Arylgruppen mit mehr als 10 Kohlenstoffatomen aufweisen, in denen Arylgruppen über eine gemeinsame Kante direkt aneinander ankondensiert sind. Besonders bevorzugt weist dieses überhaupt keine kondensierten Arylgruppen auf, in denen Arylgruppen über eine gemeinsame Kante direkt aneinander ankondensiert sind. So ist es also bevorzugt, wenn das aromatische Ringsystem beispielsweise keine Anthracen- oder Pyrengruppen aufweist, und besonders bevorzugt, wenn das aromatische Ringsystem auch keine Naphthalingruppen aufweist. Dagegen kann es beispielsweise Biphenyl- oder Terphenylgruppen aufweisen, da diese keine kondensierten Arylgruppen aufweisen. Weiterhin kann es auch beispielsweise Fluoren- oder Spirobifluorengruppen aufweisen, da in diesen Gruppen keine Arylgruppen direkt über eine gemeinsame Kante aneinander ankondensiert sind.

Wenn der sterisch anspruchsvolle Substituent für eine Alkylgruppe steht, dann weist diese Alkylgruppe bevorzugt 4 bis 10 C-Atome auf. Bevorzugt handelt es sich um eine sekundäre, tertiäre oder cyclische Alkylgruppe, bei der das sekundäre oder tertiäre C-Atom entweder direkt an den fluoreszierenden Grundkörper gebunden ist oder über eine $CH_2$-Gruppe an den fluoreszierenden Grundkörper gebunden ist. Besonders bevorzugt ist diese Alkylgruppe ausgewählt aus den Strukturen der folgenden Formeln (R-1) bis (R-33):

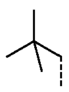 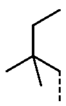 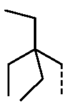 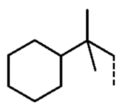 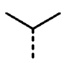 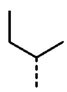 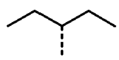 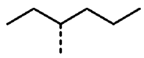

(R-1) (R-2) (R-3) (R-4) (R-5) (R-6) (R-7) (R-8)

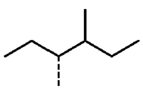 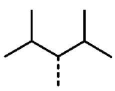 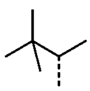 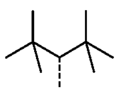 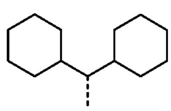 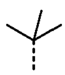 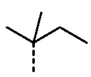 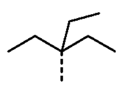

(R-9) (R-10) (R-11) (R-12) (R-13) (R-14) (R-15) (R-16)

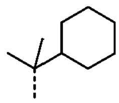
(R-17)

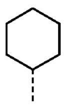
(R-18)

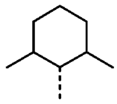
(R-19)

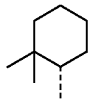
(R-20)

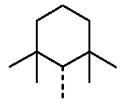
(R-21)

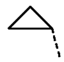
(R-22)

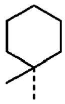
(R-23)

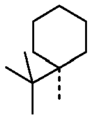
(R-24)

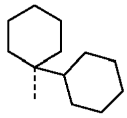
(R-25)

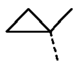
(R-26)

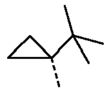
(R-27)

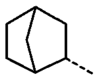
(R-28)

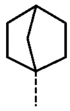
(R-29)

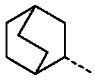
(R-30)

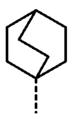
(R-31)

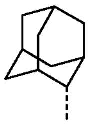
(R-32)

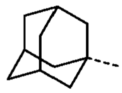
(R-33)

wobei die gestrichelte Bindung die Anknüpfung dieser Gruppen an den fluoreszierenden Grundkörper kennzeichnet.

Wenn der sterisch anspruchsvolle Substituent für eine Alkoxygruppe steht, dann weist diese Alkoxygruppe bevorzugt 3 bis 10 C-Atome auf und ist bevorzugt verzweigt oder cyclisch. Bevorzugt ist diese Alkoxygruppe ausgewählt aus den Strukturen der folgenden Formeln (R-34) bis (R-47):

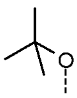
(R-34)

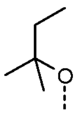
(R-35)

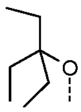
(R-36)

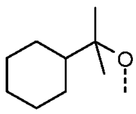
(R-37)

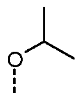
(R-38)

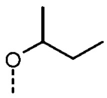
(R-39)

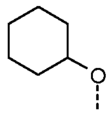
(R-40)

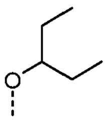
(R-41)

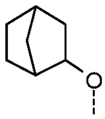
(R-42)

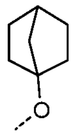
(R-43)

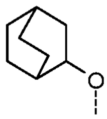
(R-44)

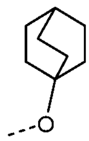
(R-45)

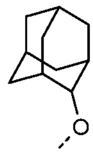
(R-46)

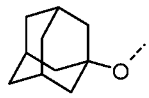
(R-47)

wobei die gestrichelte Bindung die Anknüpfung dieser Gruppen an den fluoreszierenden Grundkörper kennzeichnet.

Wenn der sterisch anspruchsvolle Substituent für eine Aralkylgruppe steht, dann ist diese Aralkylgruppe bevorzugt ausgewählt aus den Strukturen der folgenden Formeln (R-48) bis (R-61):

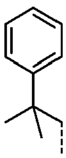
(R-48)

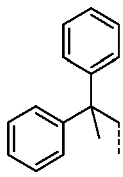
(R-49)

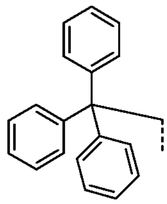
(R-50)

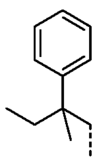
(R-51)

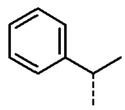
(R-52)

wobei die gestrichelte Bindung die Anknüpfung dieser Gruppen an den fluoreszierenden Grundkörper kennzeichnet und die Phenylgruppen jeweils durch einen oder mehrere Reste $R^a$ substituiert sein können, wobei gilt:

$R^a$ ist bei jedem Auftreten gleich oder verschieden ausgewählt aus der Gruppe bestehend aus H, D, F, einer geradkettigen Alkylgruppe mit 1 bis 40 C-Atomen oder einer verzweigten oder cyclischen Alkylgruppe mit 3 bis 40 C-Atomen, die jeweils mit einem oder mehreren Resten $R^b$ substituiert sein kann, einem aromatischen Ringsystem mit 5 bis 60 aromatischen Ringatomen, das jeweils mit einem oder mehreren Resten $R^b$ substituiert sein kann, oder einer Aralkylgruppe mit 5 bis 60 aromatischen Ringatomen, die mit einem oder mehreren Resten $R^b$ substituiert sein kann, wobei optional zwei oder mehr benachbarte Substituenten $R^a$ ein Ringsystem bilden können, das mit einem oder mehreren Resten $R^b$ substituiert sein kann;

$R^b$ ist ausgewählt aus der Gruppe bestehend aus H, D, F, einem aliphatischem Kohlenwasserstoffrest mit 1 bis 20 C-Atomen, einem aromatischem Ringsystem mit 5 bis 30 aromatischen Ringatomen, wobei zwei oder mehr benachbarte Substituenten $R^b$ miteinander ein Ringsystem bilden können;

Besonders gute Leistungsdaten elektronischer Vorrichtungen, insbesondere sehr gute Effizienzen, werden erreicht, wenn die fluoreszierenden Verbindung mit einem aromatischen Ringsystem sterisch abgeschirmt wird. Wenn der sterisch anspruchsvolle Substituent für ein aromatisches Ringsystem steht, dann weist dieses aromatische Ringsystem 6 bis 60 und bevorzugt 6 bis 30 aromatische Ringatome auf, besonders bevorzugt 6 bis 24 aromatische Ringatome. Weiterhin enthält dieses aromatische Ringsystem bevorzugt nur Phenylgruppen. Dabei ist das aromatische Ringsystem bevorzugt ausgewählt aus den Strukturen der folgenden Formeln (R-62) bis (R-76):

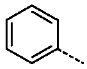
(R-62)
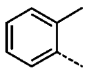
(R-63)
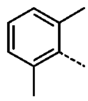
(R-64)
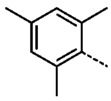
(R-65)
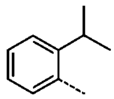
(R-66)
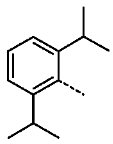
(R-67)

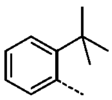
(R-68)
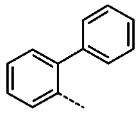
(R-69)
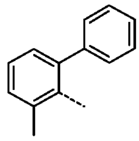
(R-70)
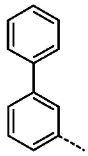
(R-71)
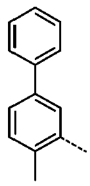
(R-72)

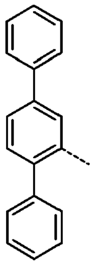
(R-73)
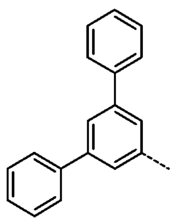
(R-74)
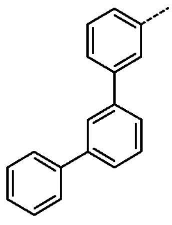
(R-75)
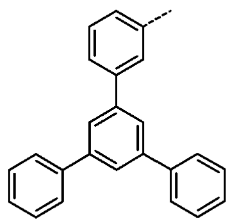
(R-76)

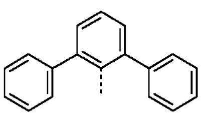
(R-77)
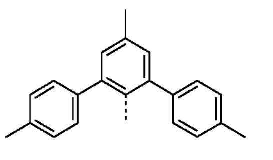
(R-78)
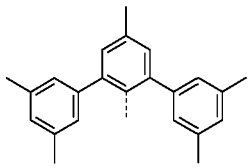
(R-79)
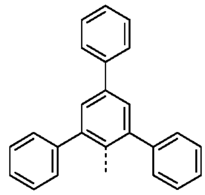
(R-80)

wobei die gestrichelte Bindung die Anknüpfung dieser Gruppen an den fluoreszierenden Grundkörper kennzeichnet und die Phenylgruppen jeweils durch einen oder mehrere Reste $R^a$ substituiert sein können, wobei $R^a$ wie oben angegeben definiert ist.

Weitere Beispiele für Gruppen, die sich zur sterischen Abschirmung der fluoreszierenden Verbindung eignen sowie bevorzugte Ausführungsformen für die Substituenten $R^a$ und $R^b$ sind in WO 2015/135624 offenbart.

In einer ganz besonders bevorzugten Ausführungsform der vorliegenden Erfindung handelt es sich bei dem fluoreszierenden Emitter um eine rein organische Verbindung ohne Metalle oder Metallionen, die aus der Gruppe der polycyclischen, kondensierten Aromaten mit 6 bis 60 aromatischen Ringatomen.

Unter den polycyclischen, kondensierten Aromaten sind dabei Pyrene, Perylene, Rubrene, Anthracene, Tetracene, Phenanthrene, Fluorene und Indenofluorene insbesondere bevorzugt, wobei die Aromaten vorzugsweise, wie bereits ausführlich an anderer Stelle dargelegt, mit aromatischen Ringsystemen substituiert sein können. Die Perylene und Rubrene sind im Sinne der vorliegenden Erfindung am meisten bevorzugt.

Im Folgenden sind exemplarisch einige bevorzugte substituierte Perylene gezeigt, die sich besonders für den Einsatz als abgeschirmte fluoreszierende Emitter eignen:

| | |
|---|---|
| 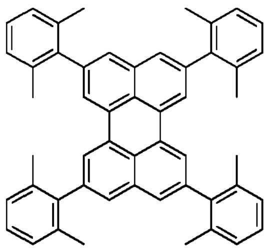 | 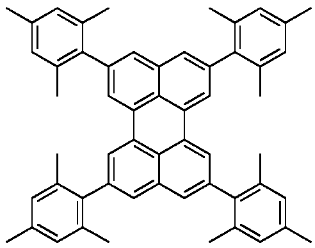 |
| 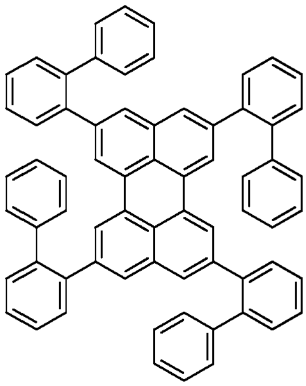 | 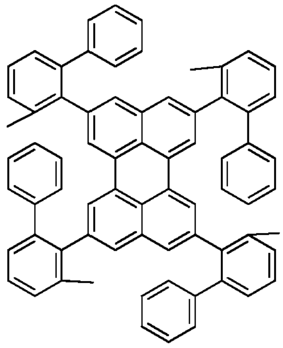 |
| 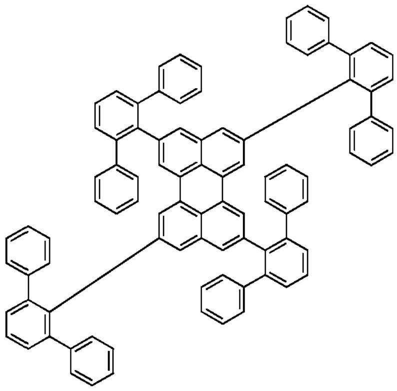 | 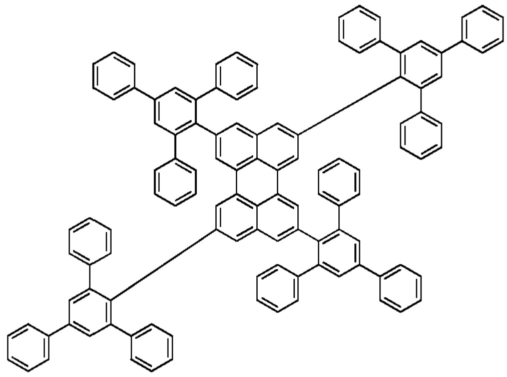 |
| 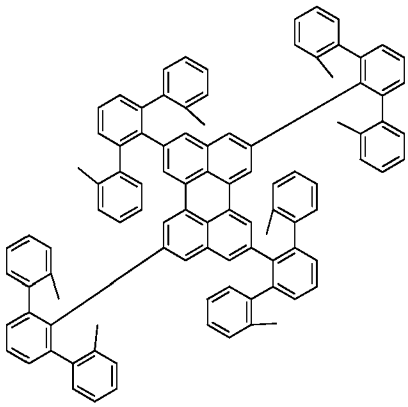 | 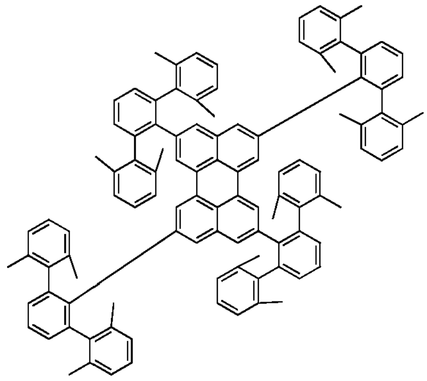 |

| | |
|---|---|
| 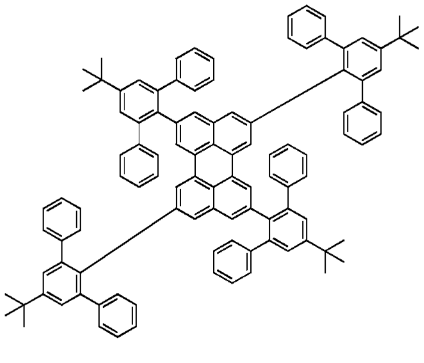 | 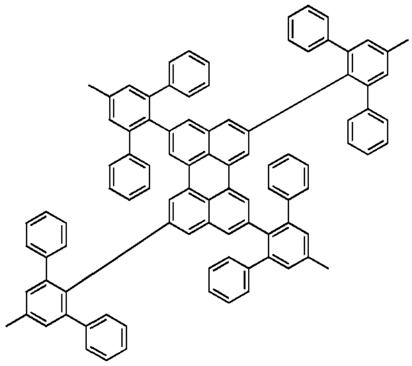 |
| 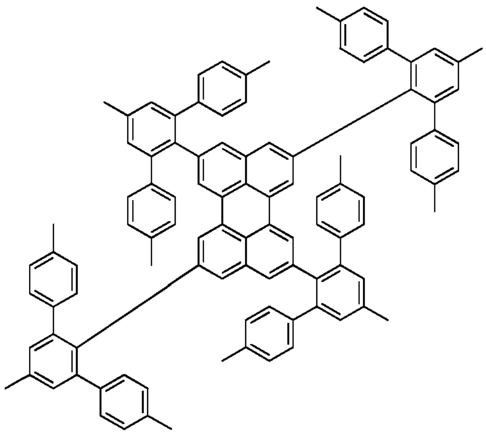 | 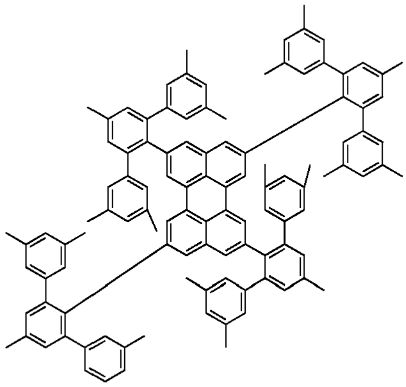 |
| 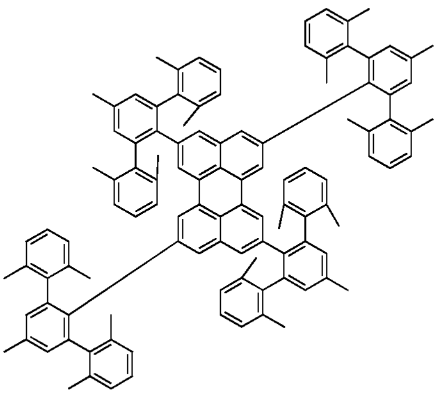 | 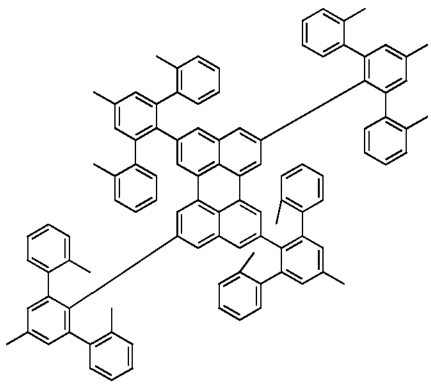 |
| 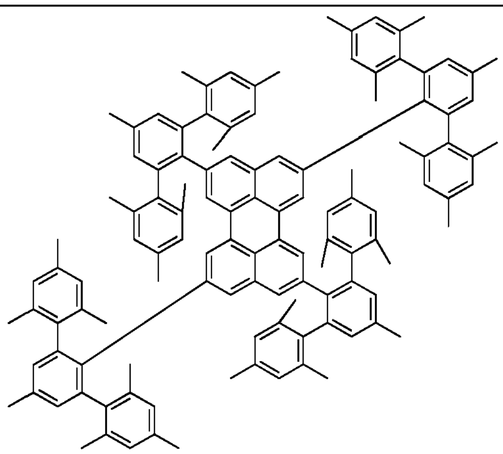 | 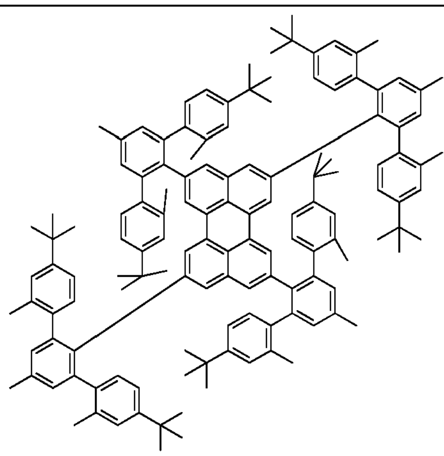 |

| | |
|---|---|
| 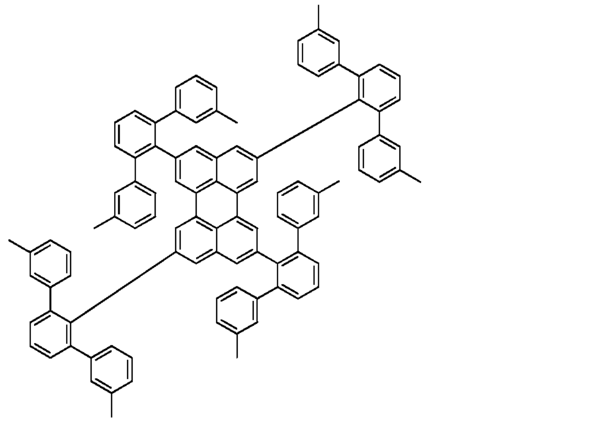 | 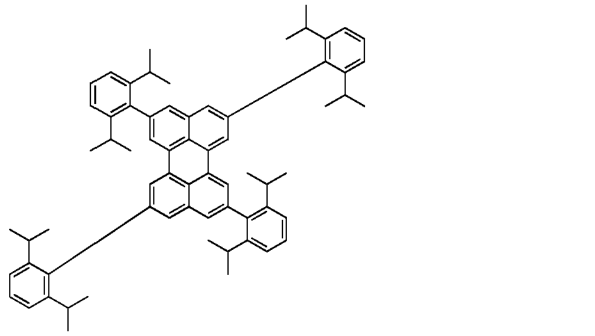 |
| 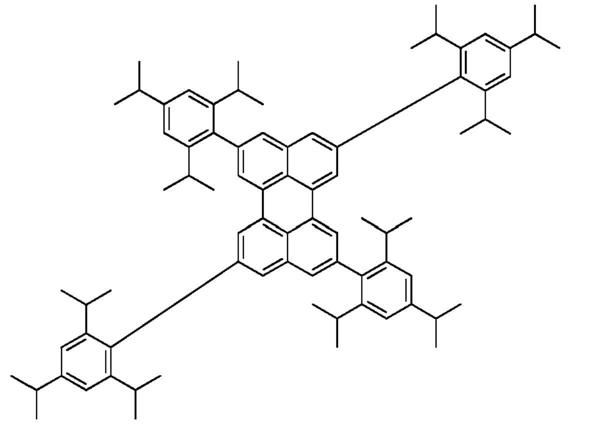 | 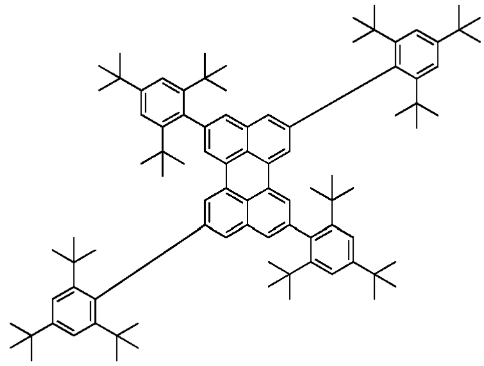 |
| 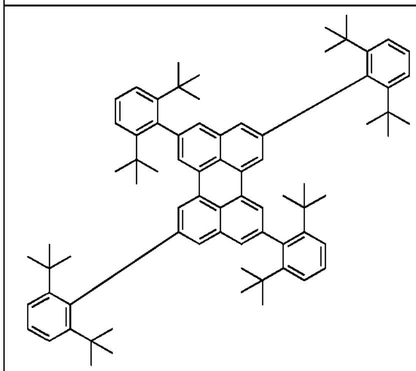 | 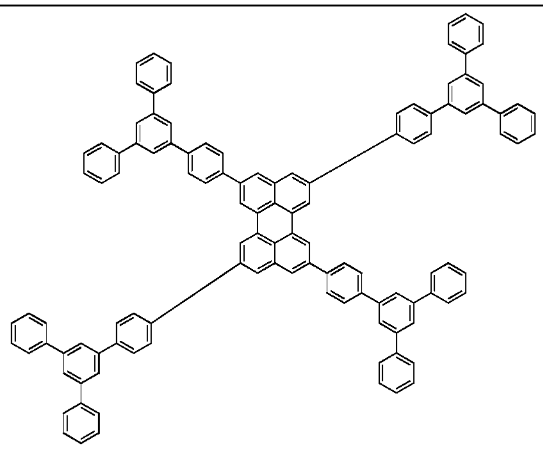 |

| | |
|---|---|
| 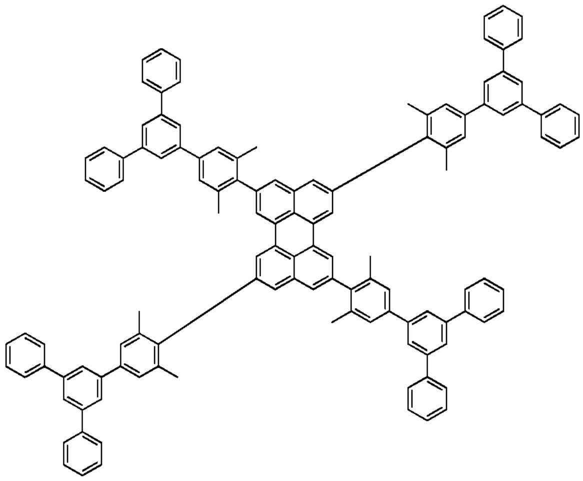 | 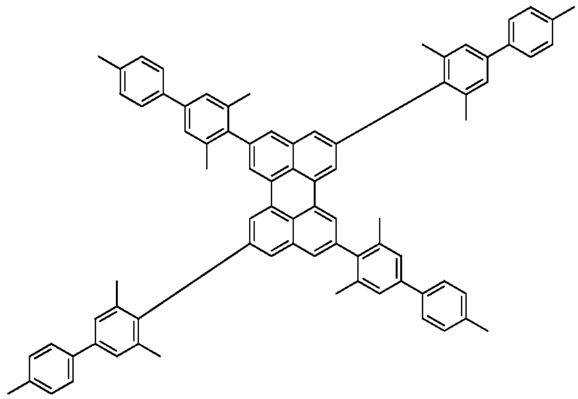 |
| 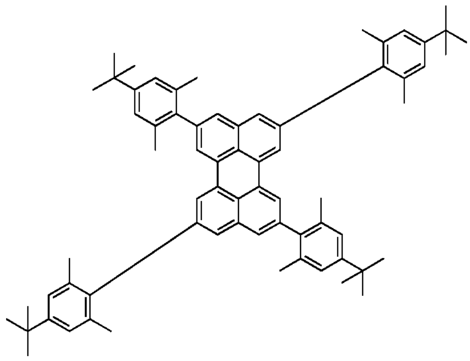 | 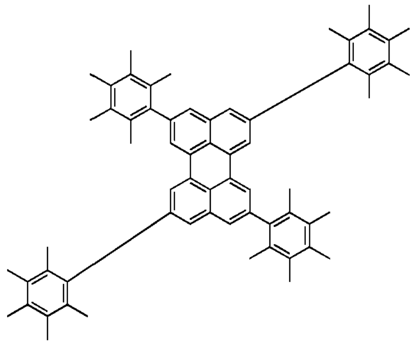 |
| 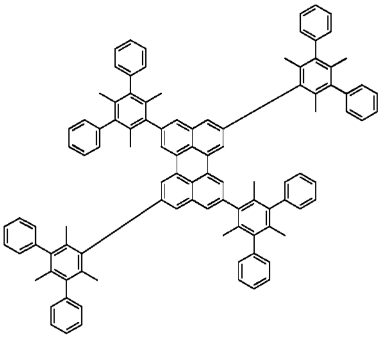 | 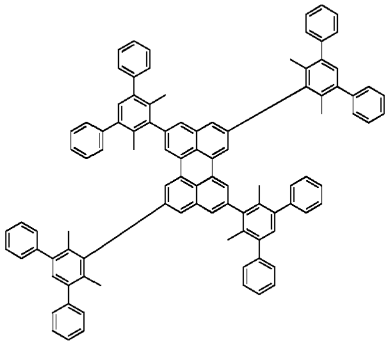 |
| 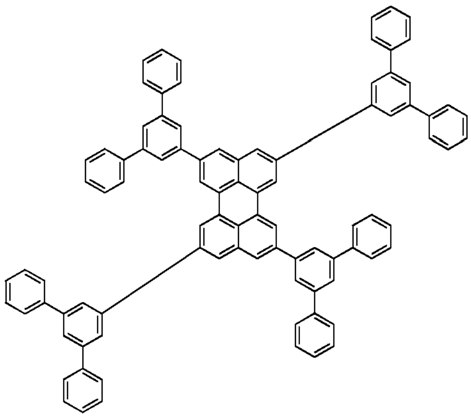 | 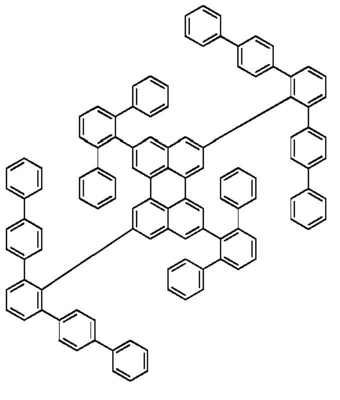 |

| | |
|---|---|
| 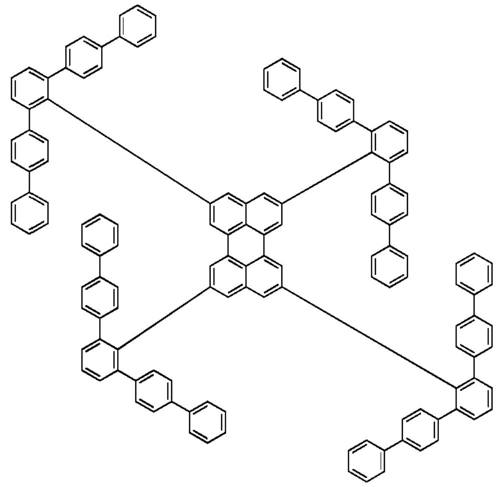 | 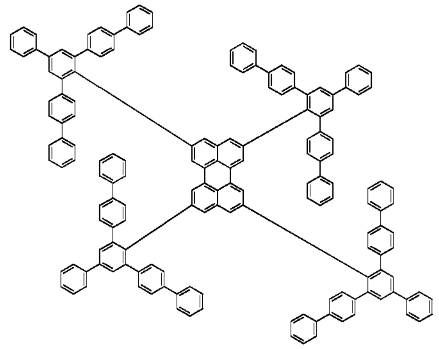 |
| 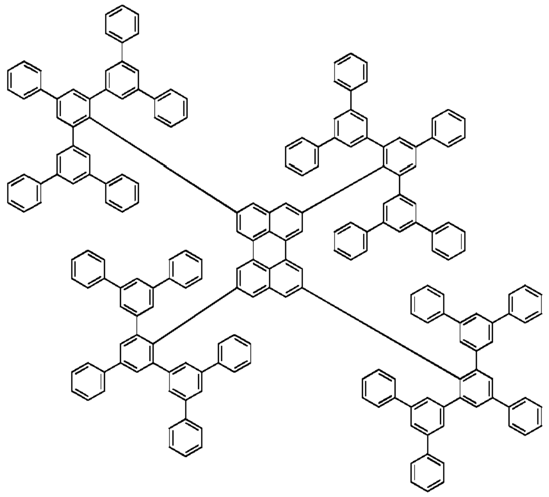 | 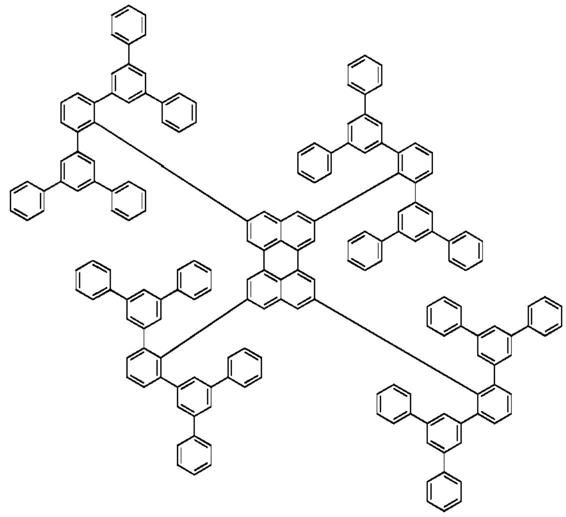 |

Einzelheiten zu den Perylenen als fluoreszierende Emitter können auch der Patentanmeldung EP18194083.4 entnommen werden.

Die erfindungsgemäße Lehre deckt die gesamte Farbpalette an Emissionen ab, sowohl hinsichtlich der fluoreszierenden Emitter (im Photolumineszenzspektrum) als auch die Emission der erfindungsgemäßen elektronischen Vorrichtung (im Elektrolumineszenzspektrum).

Es ist bevorzugt, wenn die fluoreszierenden Emitter eine blaue Emission aufweisen, wobei unter blauer Emission des fluoreszierenden Emitters vorzugsweise eine Emission verstanden wird, bei der das globale Emissionsmaximum im Phololumineszenzspektrum der fluoreszierenden Emitter im Bereich von 380 bis 500 nm liegt.

Es ist auch bevorzugt, wenn die erfindungsgemäße elektronische Vorrichtungen eine blaue Emission aufweist, wobei unter blauer Emission der elektronischen Vorrichtung vorzugsweise eine Emission verstanden wird, bei der das globale Emissionsmaximum im Elektrolumineszenzspektrum der erfindungsgemäßen elektronischen Vorrichtung im Bereich von 380 bis 500 nm liegt.

Es ist ferner bevorzugt, wenn die fluoreszierenden Emitter eine grüne Emission aufweisen, wobei unter grüner Emission des fluoreszierenden Emitters vorzugsweise eine Emission verstanden wird, bei der das globale Emissionsmaximum im Phololumineszenzspektrum der fluoreszierenden Emitter im Bereich von 501 bis 570 nm liegt.

Es ist auch bevorzugt, wenn die erfindungsgemäße elektronische Vorrichtungen eine grüne Emission aufweist, wobei unter grüner Emission der elektronischen Vorrichtung vorzugsweise eine Emission verstanden wird, bei der das globale Emissionsmaximum im Elektrolumineszenzspektrum der erfindungsgemäßen elektronischen Vorrichtung im Bereich von 501 bis 570 nm liegt.

Es ist weiterhin bevorzugt, wenn die fluoreszierenden Emitter eine gelbe Emission aufweisen, wobei unter gelber Emission des fluoreszierenden Emitters vorzugsweise eine Emission verstanden wird, bei der das globale Emissionsmaximum im Phololumineszenzspektrum der fluoreszierenden Emitter im Bereich von 571 bis 590 nm liegt.

Es ist auch bevorzugt, wenn die erfindungsgemäße elektronische Vorrichtungen eine gelbe Emission aufweist, wobei unter gelber Emission der elektronischen Vorrichtung vorzugsweise eine Emission verstanden wird, bei der das

globale Emissionsmaximum im Elektrolumineszenzspektrum der erfindungsgemäßen elektronischen Vorrichtung im Bereich von 571 bis 590 nm liegt.

Schließlich ist auch bevorzugt, wenn die fluoreszierenden Emitter eine rote Emission aufweisen, wobei unter roter Emission des fluoreszierenden Emitters vorzugsweise eine Emission verstanden wird, bei der das globale Emissionsmaximum im Phololumineszenzspektrum der fluoreszierenden Emitter im Bereich von 591 bis 750 nm liegt.

Es ist auch bevorzugt, wenn die erfindungsgemäße elektronische Vorrichtungen eine rote Emission aufweist, wobei unter roter Emission der elektronischen Vorrichtung vorzugsweise eine Emission verstanden wird, bei der das globale Emissionsmaximum im Elektrolumineszenzspektrum der erfindungsgemäßen elektronischen Vorrichtung im Bereich von 591 bis 750 nm liegt.

Der Sensitizer und der fluoreszierende Emitter können sich in derselben Schicht einer elektronischen Vorrichtung oder in unterschiedlichen Schichten befinden.

In einer Ausführungsform der vorliegenden Erfindung befinden sich Sensitizer und fluoreszierender Emitter in der selben Schicht, wobei diese Schicht vorzugsweise die Emissionsschicht einer elektrolumineszierenden Vorrichtung ist.

Die Schicht oder die unten genannte erfindungsgemäße Zusammensetzung enthaltend den Sensitizer und den fluoreszierenden Emitter enthält vorzugsweise wenigstens ein weiteren Material aus der Gruppe der Elektronentransportmaterialien, Lochleitermaterialien, Quantenmaterialien (vorzugsweise Quantenpunkten), bipolaren Hosts, Host Materialien mit großer Bandlücke (wide band gap Materialien), phosphoreszierenden Verbindungen, fluoreszierenden Verbindungen und Materialien, die eine verzögerte Fluoreszenz aufweisen.

Mit wide band gap Materialien sind hierbei solche Materialien gemeint, die eine große Bandlücke zwischen dem HOMO und dem LUMO Energieniveau aufweisen. Besonders bevorzugt sind solche Materialien, die eine Bandlücke von 2,5 eV oder mehr, ganz besonders bevorzugt von 3,0 eV oder mehr und insbesondere bevorzugt von 3,5 eV oder mehr aufweisen. Die HOMO- und LUMO-Werte sind dabei nach dem im Folgenden angegeben quantenchemischen Verfahren zu berechnen. Materialien mit verzögerter Fluoreszenz sind vorzugsweise solche, die eine thermisch induzierte zeitlich verzögerte Fluoreszenz (TADF) aufweisen. TADF-Materialien weisen einen kleinen Abstand zwischen dem $S_1$ und $T_1$-Energieneiveau auf, der bevorzugt 0,3 eV oder kleiner, ganz bevorzugt 0,2 eV oder kleiner und ganz besonders bevorzugt 0,1 eV oder kleiner ist. Die $S_1$- und $T_1$- Energien sind dabei nach dem im Folgenden angegeben quantenchemischen Verfahren zu berechnen. Beispiele gängiger TADF-Materialien können dem Stand der Technik entnommen werden (z.B Y. Liu et al., Nature Reviews Materials, Vol. 3, 18020, 2018; Z. Yang et al., Chem. Soc. Rev., 2017, 46, 915).

Energieniveaus sowie die Energie des niedrigsten Triplettzustands $T_1$ bzw. des niedrigsten angeregten Singulettzustands $S_1$ der Materialien werden, sofern nicht anderweitig angegeben, über quantenchemische Rechnungen bestimmt. Zur Berechnung organischer Substanzen ohne Metalle wird zuerst eine Geometrieoptimierung mit der Methode "Ground State/Semiempirical/Default Spin/AM1/Charge 0/Spin Singlet" durchgeführt. Im Anschluss erfolgt auf Grundlage der optimierten Geometrie eine Energierechnung. Hierbei wird die Methode "TD-SCF/DFT/Default Spin/B3PW91" mit dem Basissatz "6-31G(d)" verwendet (Charge 0, Spin Singlet). Für metallhaltige Verbindungen wird die Geometrie über die Methode "Ground State/ Hartree-Fock/Default Spin/LanL2MB/Charge 0/Spin Singlet" optimiert. Die Energierechnung erfolgt analog zu der oben beschriebenen Methode für die organischen Substanzen mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

Geeignete, bevorzugte Matrixmaterialien, welche in Kombination mit dem Sensitizer und dem fluoreszierenden Emitter in der Emissionsschicht der elektronischen Vorrichtung oder den unten genannten erfindungsgemäßen Zusammensetzungen eingesetzt werden können, sind aromatische Ketone, aromatische Phosphinoxide oder aromatische Sulfoxide oder Sulfone, z. B. gemäß WO 2004/013080, WO 2004/093207, WO 2006/005627 oder WO 2010/006680,

Triarylamine, insbesondere Monoamine, z. B. gemäß WO 2014/015935, Carbazolderivate, z. B. CBP (N,N-Biscarbazolylbiphenyl) oder die in WO 2005/039246, US 2005/0069729, JP 2004/288381, EP 1205527 oder WO 2008/086851 offenbarten Carbazolderivate, Indolocarbazolderivate, z. B. gemäß WO 2007/063754 oder WO 2008/056746, Indenocarbazolderivate, z. B. gemäß WO 2010/136109 und WO 2011/000455, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, überbrückte Carbazol-Derivate, z. B. gemäß US 2009/0136779, WO 2010/050778, WO 2011/042107, WO 2011/088877 oder WO 2012/143080, Triphenylenderivate, z. B. gemäß WO 2012/048781, Lactame, z. B. gemäß WO 2011/116865, WO 2011/137951 oder WO 2013/064206, 4-Spirocarbazol-Derivate, z. B. gemäß WO 2014/094963 oder WO 2015/192939, oder Dibenzofuran-Derivate, z. B. gemäß WO 2015/169412, WO 2016/015810, WO 2016/023608 oder den noch nicht offen gelegten Anmeldungen EP 16158460.2 und EP 16159829.7. Ebenso kann ein weiterer phosphoreszierender Emitter, welcher kürzerwellig als der eigentliche Emitter emittiert, in der Emissionsschicht oder der Zusammensetzung vorhanden sein.

Das weitere Material ist dabei bevorzugt ausgewählt aus der Gruppe der Elektronentransportmaterialien und hieraus insbesondere aus der Gruppe der Pyridine, Pyrimidine, Pyrazine, Pyridazine, Triazine, Chinazoline, Chinoxaline, Chinoline, Isochinoline, Imidazole, Lactame, Dibenzofurane, Dibenzothiophene und/oder Benzimidazole ausgewählt ist, wobei Pyrimidine und Triazine ganz besonders bevorzugt sind.

Es ist ferner bevorzugt, wenn das weitere Material aus der Gruppe der Lochleitransportmaterialien ausgewählt ist, wobei hierbei die Carbazole, Biscarbazole, Arlyamine, Triarylamine, Indenocarbazole und Indolocarbazole ganz besonders bevorzugt sind.

Es ist ferner bevorzugt, wenn die Schicht enthaltend den Sensitizer und den fluoreszierenden Emitter und dem weiteren Material wenigstens ein viertes Material enthält, wobei das wieder ausgewählt werden kann aus der Gruppe der oben bereits genannten bevorzugten weiteren Materialien.

In einer weiteren Ausführungsform der vorliegenden Erfindung befinden besteht die Schicht, die den Sensitizer und den fluoreszierenden Emitter enthält, ausschließlich aus dem Sensitizer und dem fluoreszierenden Emitter, wobei die Schicht vorzugsweise die Emissionsschicht ist.

In einer weiteren Ausführungsform der vorliegenden Erfindung befinden sich Sensitizer und fluoreszierender Emitter in unterschiedlichen Schichten, wobei die beiden Schichten direkt aneinander grenzen.

Es können auch mehrere Schichten enthaltend jeweils einen Sensitizer und jeweils einen fluoreszierenden Emitter in alternierender Form aneinander grenzen. Gegenstand der vorliegenden Erfindung ist daher auch eine elektronische Vorrichtung die einen Bereich mit der Schichtenfolge $[SL/FEL]_n$-SL enthält, wobei n eine ganze Zahl von 1 bis 5 ist, SL ist eine Schicht enthaltend den Sensitizer und FEL ist Schicht enthaltend den fluoreszierenden Emitter, und wobei die Sensitizer in den unterschiedlichen Schichten SL verschieden voneinander sein können und wobei die die fluoreszierenden Emitter in unterschiedlichen Schichten FEL verschieden voneinander sein können.

Bei der erfindungsgemäßen elektronischen Vorrichtung handelt es sich bevorzugt um eine organische elektronische Vorrichtung und ganz bevorzugt um eine organische elektronisch Vorrichtung aus der Gruppe der organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laser-dioden.

Ganz besonders bevorzugt ist die elektronische Vorrichtung eine organische Elektrolumineszenzvorrichtung. Noch mehr bevorzugt ist, wenn die elektronische Vorrichtung eine organische Elektrolumineszenzvorrichtung aus der Gruppe der OLEDs oder OLECs ist, wobei die OLEDs am meisten bevorzugt sind.

Eine bevorzugte Ausführungsform der Erfindung sind organische Elektrolumineszenzvorrichtungen. Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoOs oder $WO_3$ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt

insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Weiterhin bevorzugt sind auch Tandem-OLEDs. Es kann sich auch um ein Hybrid-System handeln, wobei eine oder mehrere Schichten fluoreszieren und eine oder mehrere andere Schichten phosphoreszieren.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. $Al/Ni/NiO_x$, $Al/PtO_x$) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoOs oder $WO_3$, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Weiterhin betrifft die vorliegende Erfindung eine Zusammensetzung enthaltend wenigstens einen Sensitizer sowie wenigstens einen fluoreszierenden Emitter, wobei der Sensitizer und der fluoreszierende Emitter die in der vorliegenden Erfindung genannten Verbindungen sind. Ferner gelten für die im Sinne der vorliegenden Erfindung bevorzugten Ausführungsformen der beiden Komponenten der Zusammensetzung, d.h. für den Sensitizer und den fluoreszierender Emitter, dieselben hierin bereits offenbarten Bevorzugungen, die im Zusammenhang mit der elektronischen Vorrichtung beschrieben wurden.

Erfindungsgemäß ist der fluoreszierende Emitter der Zusammensetzung eine sterisch abgeschirmte Verbindung, die einen *Shielding Factor* (SF) von größer oder gleich 0,5, bevorzugt größer oder gleich 0,6 und besonders bevorzugt größer oder gleich 0,65 aufweist.

Ferner bevorzugt ist daher auch, wenn der fluoreszierende Emitter und der Sensitizer der Zusammensetzung wenigstens eine der oben genannten Bedingungen (I) oder (II) erfüllt sein muss, wobei bevorzugt ist, wenn Bedingung (I) erfüllt ist:

und wobei auch hier die oben genannten Bevorzugungen, beispielsweise, hinsichtlich X und Y gelten.

In diesem Sinne ganz bevorzugt ist daher, beispielsweise, auch eine Zusammensetzung enthaltend wenigstens einen Sensitizer, der einen phosphoreszierenden Organometallkomplex enthaltend Ir oder Pt sowie einen sterisch abgeschirmten fluoreszierenden Emitter mit einem der oben aufgeführten Shielding Faktoren.

In diesem Sinne ganz bevorzugt ist daher auch eine Zusammensetzung enthaltend wenigstens einen Sensitizer, der einen phosphoreszierenden Organometallkomplex enthaltend Ir oder Pt sowie einen fluoreszierenden Emitter, wobei wenigstens eine der beiden Bedingungen (I) oder (II) erfüllt sein müssen.

Die genannten Zusammensetzungen enthalten vorzugsweise wenigstens ein weiteres Material, das bevorzugt ausgewählt ist aus der Gruppe der Elektronentransportmaterialien, Elektroneninjektionsmaterialien, Elektronenblockiermaterialien, Lochtransportmaterialien, Lochinjektionsmaterialien, Lochblockiermaterialien, n-Dotanden, p-Dotanden,, Quantenmaterialien (vorzugsweise Quantenpunkte), Host- oder Matrixmaterialien, wide band gap Materialien, phosphoreszierenden Emittern, fluoreszierenden Emittern oder Emittern, die eine verzögerte Fluoreszenz, wobei die Materialien die im Zusammenhang der elektronischen Vorrichtung genannten Materialien sind.

Die genannten Materialien sind dem Fachmann gut bekannt. Er kann dabei aus einer Vielzahl ihm bekannter und gut zugänglicher Materialien auswählen.

Die erfindungsgemäße Zusammensetzung enthält den Sensitizer bevorzugt in einer Konzentration von 5 bis 99,9 Gew.-%, ganz bevorzugt von 5 bis 60 Gew.-%, besonders bevorzugt von 10 bis 50 Gew.-%, ganz besonders bevorzugt 20 bis 40 Gew.-%, wobei sich die Angaben auf die gesamte Zusammensetzung beziehen.

Die erfindungsgemäße Zusammensetzung enthält den fluoreszierenden Emitter bevorzugt in einer Konzentration von 0,1 bis 25 Gew.-%, ganz bevorzugt von 1 bis 20 Gew.-%, besonders bevorzugt von 3 bis 10 Gew.-%, wobei sich die Angaben auf die gesamte Zusammensetzung beziehen.

Gegenstand der vorliegenden Erfindung ist auch eine Formulierung enthaltend die genannte Zusammensetzung sowie wenigstens ein Lösungsmittel.

Geeignete Lösungsmittel sind bevorzugt organische Lösungsmittel, wie beispielsweise Alkohole, Aldehyde, Ketone, Ether, Ester, Amide, Di $C_1$-$C_{-2}$-Alkylformamide, Schwefelverbindungen, Stickstoffverbindungen, Kohlenwasserstoffe, halogenierte Kohlenwassersstoffe (z.B. chlorierte Kohlenwassersstoffe), aromatische oder heteroaromatische Kohlenwassersstoffe und halogenierte aromatische oder heteroaromatische Kohlenwassersstoffe.

Bevorzugte Lösungsmittel können aus der folgenden Gruppe ausgewählt werden: substituierte und nicht substituierte aromatische oder linerare Esther, z.B. Ethylbenzoat, Butylbenzoat, Octyloctanoat, Diethylsebacat; substituierte und unsubstituierte aromatische oder lineare Esther, z.B.3-Phenoxytoluol, 3,4-Dimethylanisol, Phenetol oder Anisol; substituierte und unsubstituierte Arene wie Toluol, Xylen, Pentylbenzen, Hexylbenzen, Cyclohexylbenzen, 2-Methylbiphenyl, 2,2'-Dimethylbiphenyl; Indane, z.B. Hexamethylindan; substituierte und unsubstituierte aromatische oder lineare Ketone; substituierte und unsubstituierte Heterocyclen, z.B. Pyrrolidinone, cyclische oder nicht-cyclische Siloxane, Pyridine, Pyrazine; oder andere fluorierte oder chlorierte aromatische Kohlenwasserstoffe.

Besonders bevorzugte Lösungsmittel sind, z.B., 1,2,3,4-Tetramethylbenzen, 1,2,3,5-Tetramethylbenzen, 1,2,3-Trimethylbenzen, 1,2,4,5-Tetramethylbenzen, 1,2,4-Trichlorobenzen, 1,2,4-Trimethyl-benzen, 1,2-Dihydronaphthalen, 1,2-Dimethylnaphthalen, 1,3-Benzo-dioxolan, 1,3-Diisopropylbenzen, 1,3-Dimethylnaphthalen, 1,4-Benzo-dioxan, 1,4-Diisopropylbenzen, 1,4-Dimethylnaphthalen, 1,5-Dimethyl-tetralin, 1 Benzothiophen, Thianaphthalen, 1 Bromonaphthalen, 1-Chloromethylnaphthalen, 1 Ethylnaphthalen, 1 Methoxynaphthalen, 1 Methylnaphthalen, 1 Methylindol, 2,3-Benzofuran, 2,3-Dihydro¬benzo-furan, 2,3-Dimethylanisole, 2,4-Dimethylanisol, 2,5-Dimethylanisol, 2,6-Dimethylanisol, 2,6-Dimethylnaphthalene, 2 Bromo-3-bromomethyl¬naphthalen, 2 Bromomethylnaphthalen, 2 Bromonaphthalen, 2 Ethoxy¬naph-th¬alen, 2 Ethylnaphthalen, 2 Isopropylanisol, 2 Methylanisol, 2 Methylindol, 3,4-Dimethylanisol, 3,5-Dimethylanisol, 3 Bromoquinolin, 3-Methylanisol, 4 Methylanisol, 5 Decanolid, 5 Methoxyindan, 5-Methoxyindol, 5 Tert-butyl-m-xylen, 6 Methylquinolin, 8 Methyl¬quino¬lin, Acetophenon, Anisol, Benzonitril, Benzothiazol, Benzylacetat, Bromobenzen, Butylbenzoat, Butylphenylether, Cyclohexylbenzen, Decahydronaphthol, Dimethoxytoluen, 3-Phenoxytoluen, Diphenylether, Propiophenon, Ethylbenzen, Ethylbenzoat, Hexylbenzen, Indan, Hexamethylindan, Inden, Isochroman, Cumen, m Cymen, Mesitylen, Methylbenzoat, o , m , p Xylen, Propylbenzoat, Propylbenzen, o Dichlorobenzen, Pentylbenzen, Phenetol, Ethoxybenzen, Phenylacetat, p Cymol, Propiophenon, sec-Butylbenzen, t Butylbenzen, Thiophen, Toluol, Veratrol, Monochlorobenzen, o Dichlorobenzen, Pyridin, Pyrazin, Pyrimidin, Pyrrolidinon, Morpholin, Dimethylacetamid, Dimethylsulfoxid, Decalin und/oder Mischungen dieser Lösungsmittel.

Hierin offenbart ist auch eine elektronische Vorrichtung, vorzugsweise die oben genannten elektronischen Vorrichtungen und deren Bevorzugungen, enthaltend die Zusammensetzung, insbesondere in der Emissionsschicht einer organischen elektrolumineszierenden Vorrichtung.

Hierin offenbart ist ferner ein Verfahren zur Herstellung einer elektronischen Vorrichtung, wobei die erfindungsgemäße Formulierung verwendet wird, um wenigstens eine Schicht der elektronischen Vorrichtung aus Lösung herzustellen.

Hierin offenbart ist außerdem ein Verfahren zur Herstellung einer elektronischen Vorrichtung, wobei die erfindungsgemäße Zusammensetzung verwendet wird, um wenigstens eine Schicht der elektronischen Vorrichtung aus dem Vakuum aufzudampfen.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine elektronischen Vorrichtung, insbesondere eine organische Elektrolumineszenzvorrichtung, welche dadurch gekennzeichnet ist, dass eine oder mehrere Schichten mit einem Sublimationsverfahren beschichtet werden. Dabei werden die Materialien in Vakuum-Sublimationsanlagen bei einem Anfangsdruck von üblicherweise kleiner $10^{-5}$ mbar, bevorzugt kleiner $10^{-6}$ mbar aufgedampft. Es ist auch möglich, dass der Anfangsdruck noch geringer oder noch höher ist, beispielsweise kleiner $10^{-7}$ mbar.

Bevorzugt ist ebenfalls eine elektronischen Vorrichtung, insbesondere eine organische Elektrolumineszenzvorrichtung, welche dadurch gekennzeichnet ist, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic

Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine elektronischen Vorrichtung, insbesondere eine organische Elektrolumineszenzvorrichtung, welche dadurch gekennzeichnet ist, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die elektronischen Vorrichtung, insbesondere die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine erfindungsgemäße Zusammensetzung aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf die erfindungsgemäßen elektronischen Vorrichtungen, insbesondere organische Elektrolumineszenzvorrichtungen angewandt werden.

**Abbildungen:**

Abbildung 1 zeigt die Photolumineszenzspektren der Verbindungen FE-03 und PS-01.

Abbildung 2 zeigt das Elektrolumineszenzspektrum aus Experiment 6.

Die erfindungsgemäßen Vorrichtungen und Vorrichtungen enthaltend die erfindungsgemäßen Zusammensetzungen zeichnen sich durch folgende überraschende Vorteile gegenüber dem Stand der Technik aus:

1. Die erfindungsgemäßen Vorrichtungen weisen verbesserte Leistungsdaten, insbesondere Effizienz, Lebensdauer und Betriebsspannung gegenüber Verbindungen und Zusammensetzungen aus dem Stand der Technik.

2. Die erfindungsgemäßen Vorrichtungen ermöglichen es eine praktikable bzw. etwas erhöhte Konzentration des fluoreszierenden Emitters einzusetzen, im Vergleich zum Stand der Technik, was den Vorteil einer besseren Prozessierbarkeit der emittierenden Schicht hat.

3. Die erfindungsgemäßen Zusammensetzungen und Formulierungen erlauben eine einfache, kostengünstige Prozessierung elektronischer Vorrichtungen, beispielsweise auch eine einfach Prozessierung aus Lösung. Sie eignen sich daher für die kommerzielle Nutzung und die Massenproduktion.

4. Die erfindungsgemäßen Zusammensetzungen und erfindungsgemäßen Formulierungen weisen eine verbesserte Stabilität auf, was das Lagern der Zusammensetzungen und Formulierungen erleichtert.

Es sei darauf hingewiesen, dass Variationen der in der vorliegenden Erfindung beschriebenen Ausführungsformen unter den Umfang dieser Erfindung fallen, der durch die Ansprüche definiert wird. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbartes Merkmal, sofern nichts anderes gesagt wurde, als Beispiel einer generischen Reihe oder als äquivalentes oder ähnliches Merkmal zu betrachten.

Alle Merkmale der vorliegenden Erfindung können in jeder Art miteinander kombiniert werden, es sei denn dass sich bestimmte Merkmale und/oder Schritte sich gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Es sei ferner darauf hingewiesen, dass viele der Merkmale, und insbesondere die der bevorzugten Ausführungsformen der vorliegenden Erfindung selbst erfinderisch und nicht lediglich als Teil der Ausführungsformen der vorliegenden Erfindung zu betrachten sind. Für diese Merkmale kann ein unabhängiger Schutz zusätzlich oder alternativ zu jeder gegenwärtig beanspruchten Erfindung begehrt werden.

Die mit der vorliegenden Erfindung offengelegte Lehre zum technischen Handeln kann abstrahiert und mit anderen Beispielen kombiniert werden.

Die Erfindung wird durch die nachfolgenden Beispiele näher erläutert, ohne sie dadurch einschränken zu wollen.

Der Fachmann kann aus den Schilderungen ohne erfinderisches Zutun weitere erfindungsgemäße elektronische Vorrichtungen herstellen und somit die Erfindung im gesamten beanspruchten Bereich ausführen.

## Beispiele

### Beispiel 1: Photophysikalische Messungen

#### 1.1) Bestimmung von $S_1^{max}$ aus der Peakemissionswellenlänge $\lambda_{max}$

Zur Bestimmung der Peakemissionswellenlänge des Sensitizers und des fluoreszierenden Emitters wird das jeweilige Material in Toluol gelöst. Hierbei wird eine Konzentration von 1 mg/100 ml verwendet. Die Lösung wird in einem Fluoreszenzspektrometer Hitachi F-4500 mit einer auf das jeweilige zu untersuchende Material angepassten Wellenlänge angeregt. Die Messung erfolgt bei Raumtemperatur. Die Peakemissionswellenlänge $\lambda_{max}$ ist die Wellenlänge, bei der das dabei erhaltenen Emissionsspektrum sein erstes Maximum, ausgehend von kleinen Wellenlängen, erreicht (Abbildung 1). Dabei ist das erste Maximum typischerweise auch das globale Maximum des Spektrums. Sofern das erste Maximum des Emissionsspektrums jedoch nicht dem globalem Maximum entspricht, weist das erste Maximum allerdings eine hohe Intensität im normierten Emissionsspektrum auf, wobei die Intensität des ersten Maximums dann wenigstens 0,5 oder mehr beträgt.

#### 1.2) Bestimmung von $S_1^K$ aus der Emissionskante

Zur Bestimmung der Emissionskante des Sensitizers und des fluoreszierenden Emitters wird eine Tangente an das normierte Photolumineszenzspektrum bei steilstem Anstieg vor dem ersten Maximum bei kleinen Wellenlängen angelegt. Der Schnittpunkt dieser Tangente mit der x-Achse liefert die Wellenlänge der Emissionskante $\lambda_{Kante}$ (wie in Abbildung 1 gezeigt).

Nach den oben beschriebenen photophysikalischen Messungen ergeben sich die Peakemissionswellenlängen und Emissionskanten für die Sensitizer und fluoreszenten Emitter in Tabelle 1. Für die fluoreszierenden Emitter ist ebenfalls der Shielding-Faktor (SF) aufgelistet.

Tabelle 1: Emissionswellenlängen, Energien der angeregten Zustände und Shielding Faktoren

| Sensitizer | $\lambda_{max}$ [nm] | $\lambda_{Kante}$ [nm] | $S_1^{max}$ (eV) | $S_1^K$ (eV) | SF |
|---|---|---|---|---|---|
| PS-01 | 465 | 442 | 2.67 | 2.81 | |
| PS-02 | 473 | 458 | 2.62 | 2.71 | |
| PS-03 | 509 | 486 | 2.44 | 2.55 | |
| PS-04 | 494 | 448 | 2.51 | 2.77 | |
| PS-05 | 460 | 408 | 2.70 | 3.04 | |
| FE-01 | 459 | 441 | 2.70 | 2.81 | 0.41 |
| FE-02 | 457 | 443 | 2.71 | 2.8 | 0.55 |
| FE-03 | 469 | 455 | 2.64 | 2.73 | 0.72 |
| FE-04 | 556 | 527 | 2.23 | 2.35 | 0.47 |
| FE-05 | 566 | 529 | 2.19 | 2.34 | 0.60 |
| FE-06 | 575 | 535 | 2.16 | 2.32 | 0.67 |
| FE-07 | 573 | 535 | 2.16 | 2.32 | 0.65 |

### Beispiel 2: Synthese fluoreszierender Emitter

Die hierin verwendeten Perylene können nach dem im Folgenden dargestellten Prinzip hergestellt werden.

**Syntheseschema:**

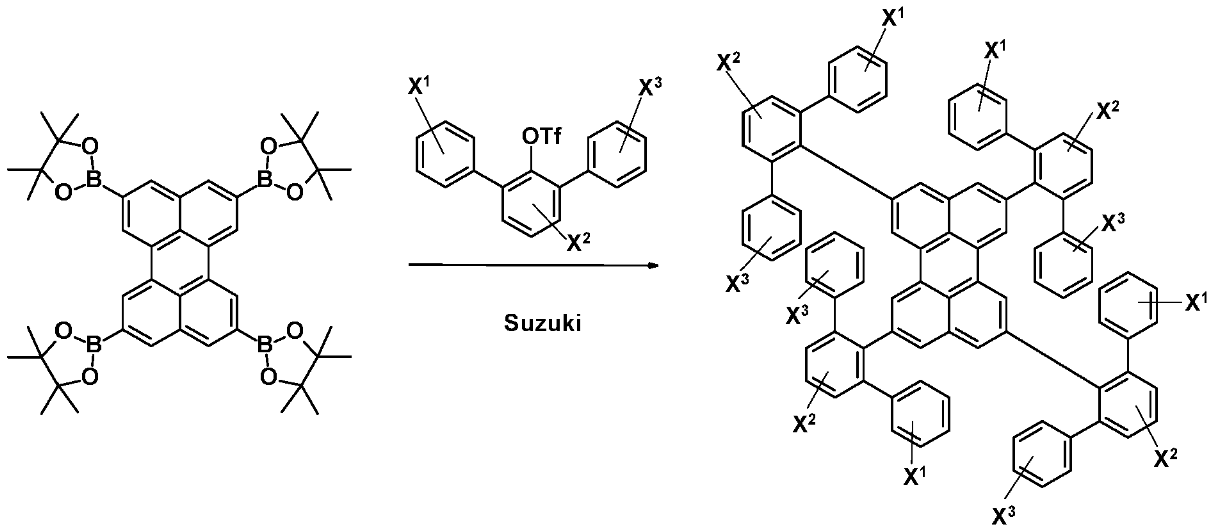


wobei $X^1$ bis $X^3$ für beliebige Substituenten stehen.

**Synthese des Triflats:**

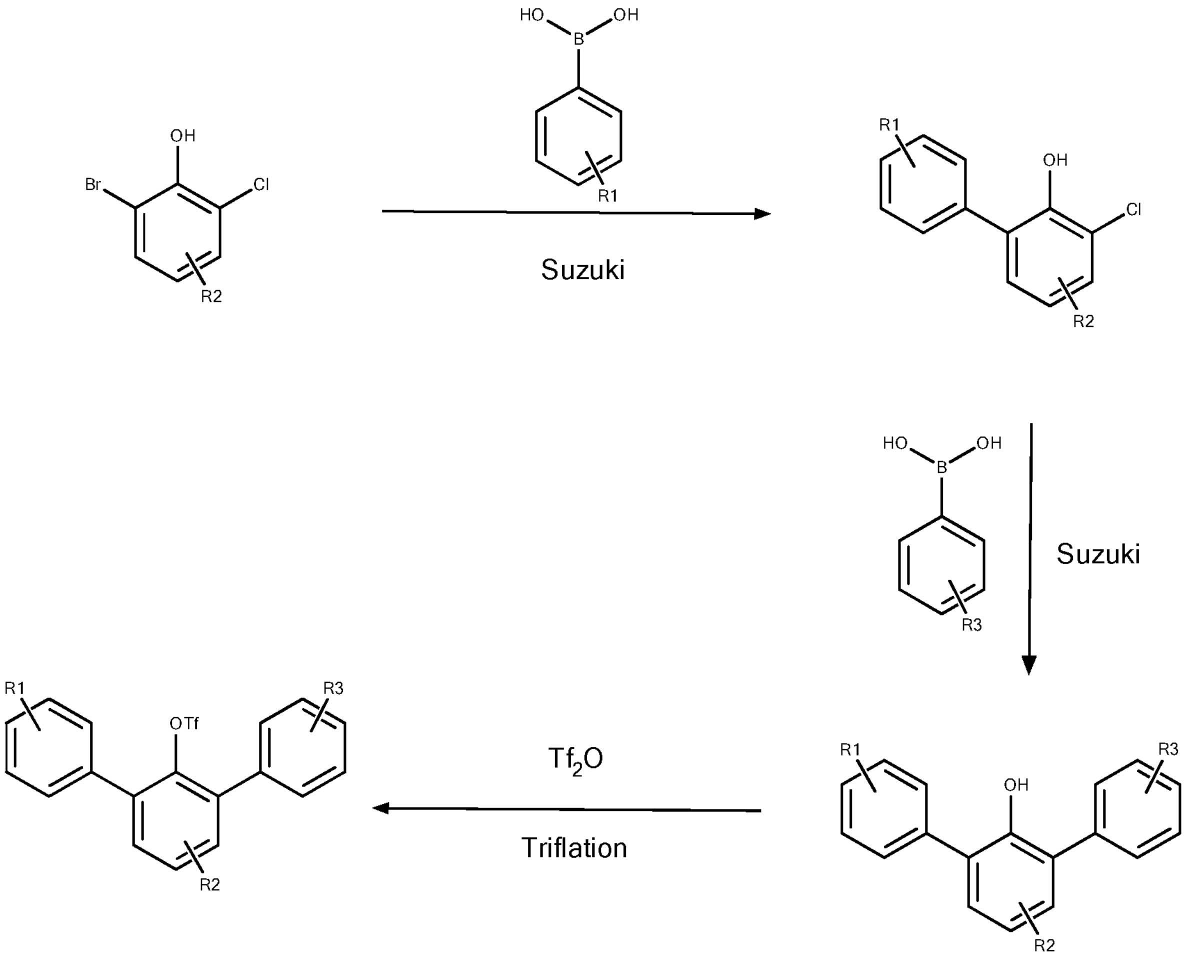


wobei die Gruppen $R^1$ bis $R^3$ die gleiche Bedeutung haben wie die Gruppen $X^1$ bis $X^3$.

In einem ausgeheizten, mit Ar gefluteten und mit einem KPG-Rührer ausgestatteten Kolben wird 2,5,8,11-Tetra-(4,4,5,5-tetramethyl-1,3,2-Dioxaborolan-2-yl)-Perylen (38.0 g, 50.3 mmol, 1.0 equiv.), 3-Phenyl-[1,1'-Biphenyl]-2-yl-Trifluoromethanesulfonat (95.1 g, 251.3 mmol, 5.0 equiv.), Tetrakis-(triphenylphosphin)-Palladium (5.81 g, 5.0 mmol, 0.1 equiv.) und Natirum-Metaborate-tetrahydrate (69.3 g, 502.5 mmol, 10.0 equiv.) vorgelegt. THF (1500 mL) und Wasser (500 mL) werdenhinzugegeben und die Reaktionsmischung für 3d unter Reflux gerührt. Das Rohprodukt wird mittels Säulenchromatigraphie gereinigt. Das gewünschte Produkt wird als gelber Feststoff isoliert (16 g, 13.7 mmol, 27.3 %).

**Synthese von 2,5,8,11-Tetrakis(2,6-dimethyl-phenyl)-perylen [FE-02]**

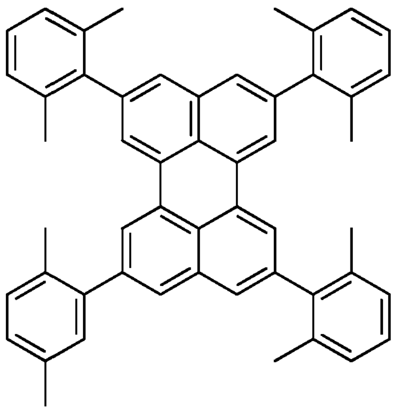

In einem ausgeheizten, mit Ar gefluteten und mit einem KPG-Rührer ausgestatteten Vierhalskolben wird 2,5,8,11-tetra-(4,4,5,5-tetramethyl-1,3,2-dioxaborolan-2-yl)-perylen (40.0 g, 52.9 mmol, 1.0 equiv.), 2-Bromo-1,3-dimethyl-benzol (293.7 g, 212.8 mL, 1587.0 mmol, 30.0 equiv.) und Cäsiumcarbonat (137.9 g, 423.2 mmol, 8.0 equiv.) vorgelegt. Toluol (2000 mL) wird zugegeben und die Reaktionsmischung wird 20 min lang mit Ar entgast. Anschließend wird Tetrakis(triphenylphoshin)palladium (6.11 g, 5.3 mmol, 0.1 equiv.) zugeben und die Reaktionsmischung wird für weitere 20 min entgast. Anschließend wird die Reaktion 72 h lang unter Rückfluss gerührt. Die Reaktionsmischung wird abfiltriert. Die Mutterlauge wird eingeengt, die daraus resultierende Suspension wird filtriert und zu der daraus entstehenden Mutterlauge wird Methanol (1000 mL) zugegeben. Dabei fällt ein Feststoff aus. Alle Feststoffe werden kombiniert und dreimal über AlOx mit Toluol heiß extrahiert. Noch eine weitere Heißextraktion wird über AlOx mit einem Gemisch aus Toluol und Heptan (1:1) durchgeführt. Der resultierende Feststoff wird zweimal aus Toluol und einmal aus 1-4-Dioxan umkristallisiert. Das gewünschte Produkt wird als gelber Feststoff (5.0 g, 7.47 mmol, 14.1 %) isoliert. Anschließend wird der Feststoff sublimiert (4.5 g, 6.73 mmol, 12.7%).

**Synthese von 2,5,8,11-Tetrakis(2,6-diphenyl-phenyl)-perylen [FE-03]**

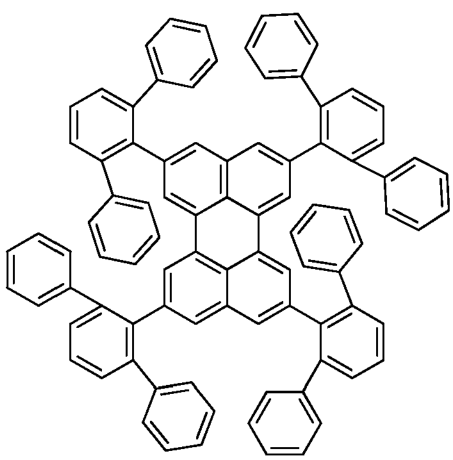

In einem ausgeheizten, mit Ar gefluteten und mit einem KPG-Rührer ausgestatteten Vierhalskolben wird 2,5,8,11-Tetra-(4,4,5,5-tetramethyl-1,3,2-dioxaborolan-2-yl)-perylen (38.0 g, 50.3 mmol, 1.0 equiv.), 1,3-Diphenylphenyl Triflat (95.1 g, 251.3 mmol, 5.0 equiv.) und Natriummetaborat Tetrahydrat (69.3 g, 502.5 mmol, 10.0 equiv.) vorgelegt. THF (1500 mL) und Wasser (500 mL) werden zugegeben und die Reaktionsmischung wird 20 min lang mit Ar entgast. Anschließend wird Tetrakis(triphenylphoshin)-palladium (5.81g, 5.0 mmol, 0.1 equiv.) zugegeben und die Reaktionsmischung für weitere 20 min mit Ar entgast. Anschließend wird die Reaktion für 72h unter Rückfluss gerührt. Die Reaktionsmischung wird abgekühlt und mit Toluol über AlOx heiß extrahiert. Dieser Vorgang wird noch zweimal wiederholt, bevor der Feststoff aus Toluol (700mL) umkristallisiert wird. Die Umkristallisation wird noch weitere fünf Mal durchgeführt, bevor das gewünschte Produkt als gelber Feststoff (16 g, 13.7 mmol, 27.3%) isoliert werden kann. Anschließend wird der Feststoff sublimiert (6.8 g, 5.8 mmol, 11.6%).

**Beispiel 3: Organische Elektrolumineszenzvorrichtungen**

**Herstellung der OLEDs**

Glasplättchen, die mit strukturiertem ITO (Indium Zinn Oxid) der Dicke 50 nm beschichtet sind, werden nass gereinigt (Spülmaschine, Reiniger Merck Extran). Die Substrate werden darauf 15 Minuten mit UV/Ozon behandelt. Eine 20 nm PEDOT:PSS-Schicht wird danach auf die Substrate aufgeschleudert (2800 U/min). Die Substrate werden nochmal für 10 Minuten auf der Heizplatte bei 180°C ausgeheizt. Nach der Herstellung werden die OLEDs zum Schutz gegen Sauerstoff und Wasserdampf verkapselt. Der genaue Schichtaufbau der elektrolumineszierenden OLEDs *(organic light emitting diodes)* ist den Beispielen zu entnehmen. Die zur Herstellung der OLEDs benötigten Materialien sind in Tabelle 4 gezeigt.

Alle Materialien werden in einer Vakuumkammer thermisch aufgedampft. Dabei besteht die Emissionsschicht bzw. die Emissionsschichten immer aus mindestens einem Matrixmaterial (Hostmaterial), einem (phosphoreszierenden) Sensitizer (PS) und einem fluoreszierenden Emitter (FE). Sensitizer und fluoreszierender Emitter (FE) werden dem Hostmaterial (H) durch Coverdampfung in einem bestimmten Volumenanteil beigemischt. Eine Angabe wie H-01:PS-01 (5%):FE-01(3%) bedeutet hierbei, dass das Material H-01 in einem Volumenanteil von 92%, PS-01 in einem Anteil von 5% und FE-01 in einem Anteil von 3% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren (EL), sowie Spannungs-Strom-Leuchtdichte (UIL) Kennlinien gemessen, woraus sich unter Annahme einer lambertschen Abstrahlcharakteristik die externe Quanteneffizienz (EQE, gemessen in Prozent) bestimmen lässt. Die Angabe U100 bezeichnet die Spannung, die für eine Leuchtdichte von 100 $cd/m^2$ benötigt wird. EQE100 bezeichnet die externe Quanteneffizienz bei einer Betriebsleuchtdichte von 100 $cd/m^2$.

Als Lebensdauer LD wird die Zeit definiert, nach der die Leuchtdichte bei Betrieb mit konstantem Strom von der Startleuchtdichte auf einen gewissen Anteil L1 absinkt. Eine Angabe von j0 = 10 $mA/cm^2$, L1 = 80% bedeutet, dass die Leuchtdichte bei Betrieb mit 10 $mA/cm^2$ nach der Zeit LD auf 80% ihres Anfangswertes absinkt.

Als phosphoreszierende Sensitizer werden die Verbindungen PS-01, PS-02, PS-03, PS-04 und PS-05 eingesetzt. Als fluoreszierende Emitter werden die Materialien FE-01, FE-02, FE-03, FE-04, FE-05, FE-06 und FE-07 verwendet.

**OLEDs mit blauer Emission:**

Die OLEDs bestehen aus folgender Schichtabfolge, die nach der PEDOT:PSS-Behandlung auf das Substrat aufgebracht wird:

Für Exp. 1-16: 20 nm HTM:p-D (95%:5%), 30nm HTM, 10 nm H-02, 25 nm H-01:PS:FE, 10 nm H-01, 20 nm ETM:LiQ (50%:50%), Aluminium (100 nm).

Für Exp. 17-22: 20 nm HTM:p-D (95%:5%), 20nm HTM, 10 nm H-03, 30 nm H-01:PS:FE, 10 nm H-01, 20 nm ETM:LiQ (50%:50%), 3nm LiQ, Aluminium (100 nm).

Für Exp. 23-28 werden Substrate mit 50nm ITO verwendet, die nass gereinigt werde (Spülmaschine, Reiniger Merck Extran). Danach werden die Substrate für 15min bei 250° in einer Stickstoffatmosphäre ausgeheizt. Die OLEDs bestehen aus folgender Schichtabfolge, die nach dem Ausheizen auf das Substrat aufgebracht werden: 20 nm HTM:p-D (95%:5%), 180nm HTM, 20 nm H-03, 25 nm H-01:PS-04:FE, 10 nm H-01, 20 nm ETM:LiQ (50%:50%), Aluminium (100 nm).

In Tabelle 2 sind die Ergebnisse für verschiedene Kombinationen von Host, Sensitizer und fluoreszentem Emitter aufgeführt. Die EQE und Spannung bei 100 $cd/m^2$ sind für die entsprechenden Versuche angegeben. X steht dabei für $S_1^K(FE)-S_1^K(S)$ und Y für $S_1^{max}(FE)-S_1^{max}(S)$.

Tabelle 2: Experimente mit blau emittierenden OLEDs (* Referenzbeispiele)

| Exp. | Host | Sensitizer | FE | EQ.E100 [%] | U100 [V] | LD [h] | X [eV] | Y [eV] | SF |
|---|---|---|---|---|---|---|---|---|---|
| 1* | H-01 | PS-01 (15%) | FE-01 (1%) | 10.16 | 3.78 | 3.5 | 0.0 | 0.03 | 0.41 |
| 2* | H-01 | PS-01 (15%) | FE-01 (2%) | 6.77 | 3.91 | 7 | 0.0 | 0.03 | 0.41 |
| 3* | H-01 | PS-01 (15%) | FE-01 (3%) | 5.34 | 4 | 12.5 | 0.0 | 0.03 | 0.41 |
| 4 | H-01 | PS-01 (15%) | FE-02 (2%) | 9.32 | 3.89 | 3.5 | -0.1 | 0.04 | 0.55 |
| 5 | H-01 | PS-01 (15%) | FE-02 (3%) | 7.7 | 4.06 | 4 | -0.1 | 0.04 | 0.55 |
| 6 | H-01 | PS-01 (15%) | FE-03 (1%) | 19.67 | 3.63 | 1.8 | -0.08 | -0.03 | 0.72 |
| 7 | H-01 | PS-01 (15%) | FE-03 (2%) | 17.93 | 3.67 | 2.75 | -0.08 | -0-03 | 0.72 |
| 8 | H-01 | PS-01 (15%) | FE-03 (3%) | 14.77 | 3.68 | 4 | -0.08 | -0.03 | 0.72 |
| 9* | H-01 | PS-02 (5%) | FE-01 (1%) | 13 | 3.33 | 12.5 | 0.1 | 0.08 | 0.41 |
| 10* | H-01 | PS-02 (5%) | FE-01 (2%) | 9.5 | 3.37 | 26 | 0.1 | 0.08 | 0.41 |
| 11* | H-01 | PS-02 (5%) | FE-01 (3%) | 8.4 | 3.4 | 34 | 0.1 | 0.08 | 0.41 |
| 12 | H-01 | PS-02 (5%) | FE-02 (2%) | 12.3 | 3.28 | 12 | 0.09 | 0.09 | 0.55 |
| 13 | H-01 | PS-02 (5%) | FE-02 (3%) | 11.2 | 3.28 |  | 0.09 | 0.09 | 0.55 |
| 14 | H-01 | PS-02 (5%) | FE-03 (1%) | 18.7 | 3.23 | 8.5 | 0.02 | 0.02 | 0.72 |
| 15 | H-01 | PS-02 (5%) | FE-03 (2%) | 15.8 | 3.24 | 38 | 0.02 | 0.02 | 0.72 |
| 16 | H-01 | PS-02 (5%) | FE-03 (3%) | 13.5 | 3.28 | 16 | 0.02 | 0.02 | 0.72 |
| 17* | H-01 | PS-05 (20%) | FE-01 (1%) | 4.43 | 2.70 | 2.5 | -0.23 | 0 | 0.41 |
| 18* | H-01 | PS-05 (20%) | FE-01 (2%) | 3.52 | 2.78 | 4.5 | -0.23 | 0 | 0.41 |
| 19* | H-01 | PS-05 (20%) | FE-01 (3%) | 3.10 | 2.78 | 6.5 | -0.23 | 0 | 0.41 |
| 20 | H-01 | PS-05 (20%) | FE-03 (1%) | 8.14 | 2.56 | 1.4 | -0.31 | -0.06 | 0.72 |
| 21 | H-01 | PS-05 (20%) | FE-03 (2%) | 7.46 | 2.58 | 1.9 | -0.31 | -0.06 | 0.72 |
| 22 | H-01 | PS-05 (20%) | FE-03 (3%) | 7.01 | 2.59 | 2.5 | -0.31 | -0.06 | 0.72 |
| 23* | H-01 | PS-04 (20%) | FE-01 (1%) | 10.17 | 2.79 | 39 | 0.04 | 0.19 | 0.41 |
| 24* | H-01 | PS-04 (20%) | FE-01 (2%) | 7.42 | 2.85 | 72 | 0.04 | 0.19 | 0.41 |
| 25* | H-01 | PS-04 (20%) | FE-01 (3%) | 5.68 | 2.92 | 119 | 0.04 | 0.19 | 0.41 |
| 26 | H-01 | PS-04 (20%) | FE-03 (1%) | 15.54 | 2.73 | 29 | -0.04 | 0.13 | 0.72 |
| 27 | H-01 | PS-04 (20%) | FE-03 (2%) | 14.14 | 2.73 | 40 | -0.04 | 0.13 | 0.72 |
| 28 | H-01 | PS-04 (20%) | FE-03 (3%) | 12.95 | 2.75 | 54 | -0.04 | 0.13 | 0.72 |

**Fluoreszente Verbindungen mit höherem Abschirmparameter** SF in **der Emissionsschicht enthaltend einen phosphoreszierenden Sensitizer**

Im Vergleich mit FE-01, das einen SF-Wert von nur 0.41 aufweist erhält man mit dem fluoreszierenden Emitter FE-02 (SF=0.55) eine deutlich höhere Effizienz (Exp. 4 mit EQE100 = 9.32% vs. Exp. 2 mit EQE100 = 6.77%). Noch stärker steigt die Effizienz bei der Verwendung des fluoreszierenden Emitters FE-03 (SF=0.72) an (Exp. 7 mit EQE100 = 17.9%).

In einem Referenzexperiment mit PS-01 und ohne Einsatz von FE erhält man eine phosphoreszierende Vorrichtung mit EQE100 = 21.72% und U100 = 3.67 V. Erstaunlicherweise ist die Effizienz der erfindungsgemäßen Vorrichtung nur etwas geringer als die der phosphoreszierenden Vorrichtung. Außerdem kann die Lebensdauer mit einem FE allerdings deutlich verbessert werden. In Experiment 6 erzielt man mit der erfindungsgemäßen Vorrichtung eine um den Faktor 2 verbesserte Lebensdauer als die Vorrichtung ohne fluoreszenten Emitter bei $j_0$ = 10 mA/cm$^2$, L1 = 80%.

Man erhält eine höhere Effizienz bei höherem Shielding Factor auch bei Verwendung von PS-05 als Sensitizer. Vergleicht man die Beispiele 17 und 20 bzw. 18 und 21 bzw. 19 und 22, so sieht man, dass man mit FE-03 in gleichem Aufbau deutlich bessere EQE100 Werte erhält als mit FE-01.

**Einfluss der Konzentration des fluoreszierenden Emitters**

Mit steigender Konzentration des fluoreszierenden Emitters steigt die Lebensdauer der OLED signifikant an (bspw. Exp. 8 vs. Exp. 6)

Verwendet man FE-01 als Emitter zusammen mit einem anderen phosphoreszenten Sensitizer (PS-02) wie in Experiment 9, so erhält man eine EQE100 = 13%, U100 = 3.33 V.

Die Ergebnisse aus Tabelle 2 machen deutlich, dass die Effizienz (EQE) unerwartet, physikalisch und statistisch signifikant steigt, wenn der Shielding Faktor (Tabelle 1) steigt. Ferner kann überraschend festgestellt werden, dass die Effizienz (EQE) noch immer auf einem sehr hohen Niveau liegt, obwohl der Wert X bzw. der Wert Y größer und sogar positiv wird. Ferner steigt die Lebensdauer mit zunehmenden X- bzw. Y-Werten. Dies kann auch bei Einsatz der Sensitizer / Emitter Kombinationen PS-04 mit FE-01 und FE-03 (Exp. 23-28) gezeigt werden.

**OLEDs mit gelber Emission**

Die OLEDs bestehen aus folgender Schichtabfolge, die auf das Substrat aufgebracht wird: 20 nm HTM:p-D (95%:5%), 30nm HTM, 10 nm H-02, 15 nm H-01:PS-03:FE, 10 nm H-01, 40 nm ETM:LiQ (50%:50%), Aluminium (100 nm). Die unterschiedlichen Kombinationen in der Emissionsschicht sind in Tabelle 3 zusammengefasst:

Tabelle 3: Experimente mit gelb emittierenden OLEDs (* Referenzbeispiele)

| Exp. | Host | Sensitizer | FE | EQE100 [%] | U100 [V] | LD [h] | X [eV]] | Y [eV] | SF |
|---|---|---|---|---|---|---|---|---|---|
| 17* | H-01 | PS-03 (10%) | FE-04 (1%) | 11.15 | 3.8 | 238 | -0.2 | -0.21 | 0.47 |
| 18* | H-01 | PS-03 (10%) | FE-04 (2%) | 7.44 | 3.86 | 509 | -0.2 | -0.21 | 0.47 |
| 19* | H-01 | PS-03 (10%) | FE-04 (3%) | 5.92 | 4 | 772 | -0.2 | -0.21 | 0.47 |
| 20 | H-01 | PS-03 (10%) | FE-05 (1%) | 20.17 | 3.75 | 207 | -0.21 | -0.25 | 0.6 |
| 21 | H-01 | PS-03 (10%) | FE-05 (2%) | 18.5 | 3.72 | 270 | -0.21 | -0.25 | 0.6 |
| 22 | H-01 | PS-03 (10%) | FE-05 (3%) | 18.7 | 3.79 | 302 | -0.21 | -0.25 | 0.6 |
| 23 | H-01 | PS-03 (10%) | FE-06 (1%) | 19.59 | 3.52 | 17 | -0.23 | -0.28 | 0.67 |
| 24 | H-01 | PS-03 (10%) | FE-06 (2%) | 19.17 | 3.75 | 26 | -0.23 | -0.28 | 0.67 |
| 25 | H-01 | PS-03 (10%) | FE-06 (3%) | 18.8 | 3.68 | 31 | -0.23 | -0.28 | 0.67 |
| 26 | H-01 | PS-03 (10%) | FE-07 (1%) | 23.1 | 3.73 | 90 | -0.23 | -0.28 | 0.65 |
| 27 | H-01 | PS-03 (10%) | FE-07 (2%) | 21.06 | 3.75 | 27 | -0.23 | -0.28 | 0.65 |
| 28 | H-01 | PS-03 (10%) | FE-07 (3%) | 19.6 | 3.75 | 25 | -0.23 | -0.28 | 0.65 |

Ganz analog zu den blau emittierenden OLEDs kann man die gleichen Effekte bei den gelb emittierenden OLEDs, die eine andere Klasse von fluoreszierenden Emittern enthalten, beobachten.

Tabelle 4: Strukturformeln der Materialien für die OLEDs

| | |
|---|---|
| 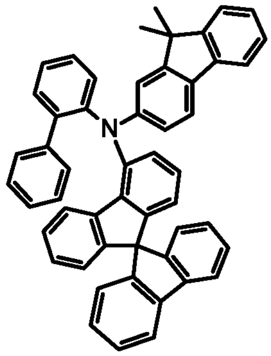 | 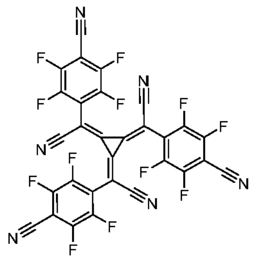 [US2010102709A1; WO2015007729A1] |
| HTM | p-D |
| 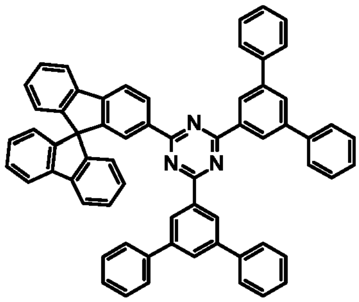 | 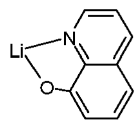 |
| ETM | LiQ |
| 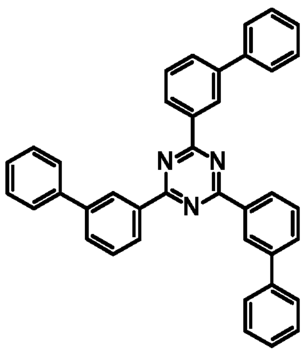 | 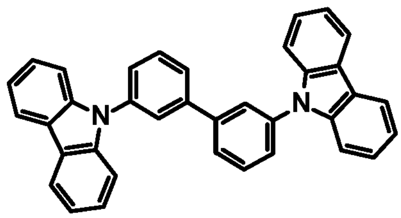 |
| H-01 | H-02 |
| 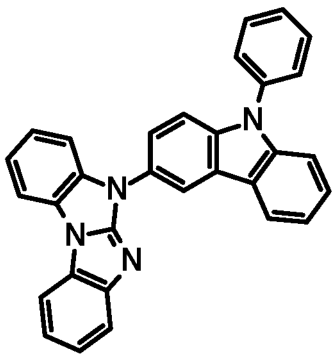 US2012241681A | |
| H-03 | |

(fortgesetzt)

| | |
|---|---|
| 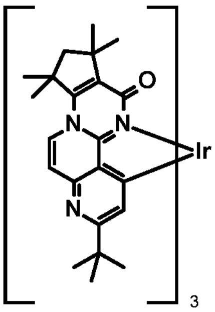 WO2014094961 | 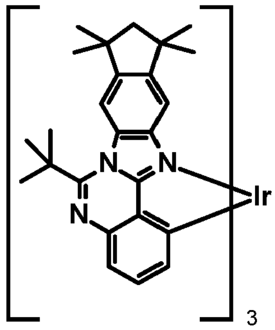 WO2014008982 |
| PS-01 | PS-02 |
| 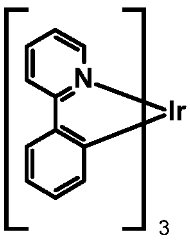 CAS [94928-86-6] | 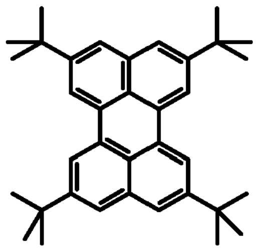 CAS [80663-92-9] |
| PS-03 | FE-01 |
| 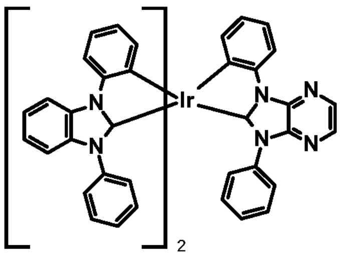 WO11073149A1 | 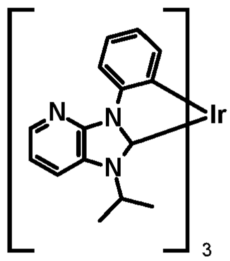 WO12172482A1 |
| PS-04 | PS-05 |
| 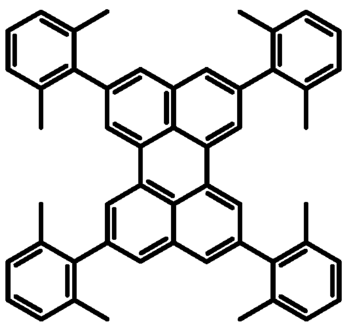 | 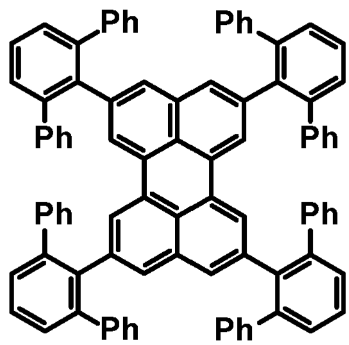 |
| FE-02 | FE-03 |

(fortgesetzt)

| | |
|---|---|
| 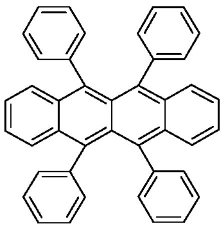 CAS [517-51-1] US2006/0025642 | 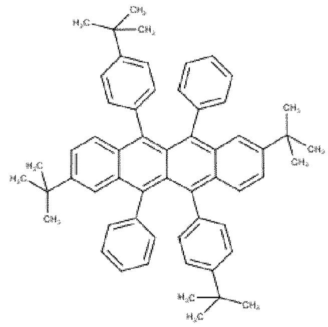 CAS [682806-51-5] Synthese analog zu der in Eur. J. Org. Chem. 2011, 4160, aus kommerziell erhältlichen Ausgangsmaterialien. |
| FE-04 | FE-05 |
| | |
| 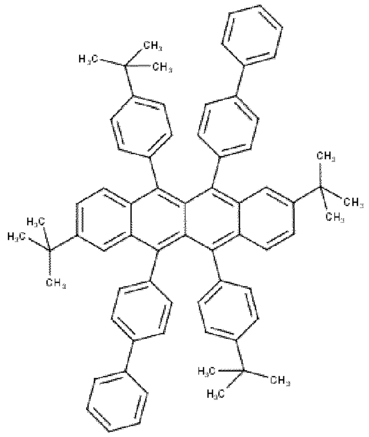 CAS [850797-15-8] US2006/0025617 | 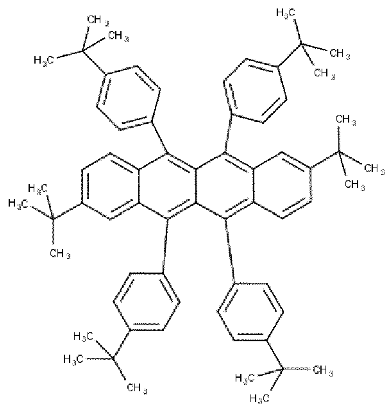 CAS [850797-14-7] US2006/0025617 |
| FE-06 | FE-07 |

**Patentansprüche**

1. Fluoreszierende elektronische Vorrichtung enthaltend einen Sensitizer und einen fluoreszierenden Emitter, wobei der Sensitizer eine phosphoreszierende Verbindung ist und wobei es sich bei dem fluoreszierenden Emitter um eine sterisch abgeschirmte Verbindung handelt, die einen *Shielding Factor* (SF) von größer oder gleich 0,5, besonders bevorzugt größer oder gleich 0,6 und insbesondere bevorzugt größer oder gleich 0,65 aufweist, wobei der *Shielding Factor* (SF) durch das in der Beschreibung beschriebene Verfahren bestimmt wird,

   wobei es sich bei dem Sensitizer um eine phosphoreszierende Verbindung aus der Gruppe der Organometallkomplexe handelt, die Cu, Ir, Pt, Rh, Ru, Os, oder Pd und bevorzugt Ir und Pt enthalten, und
   wobei es sich bei dem fluoreszierenden Emitter um eine rein organische Verbindung ohne Metalle oder Metallionen handelt, die entweder ausgewählt ist aus der Gruppe der kondensierten Aromaten mit 6 bis 60 aromatischen Ringatomen, wobei der aromatische Grundkörper aus den im Folgenden aufgeführten Gruppen der Formeln (1) bis (50) ausgewählt ist:

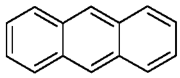
Formel (1)

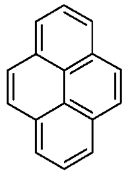
Formel (2)

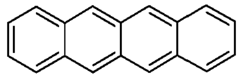
Formel (3)

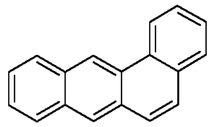
Formel (4)

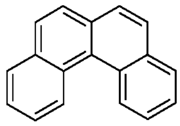
Formel (5)

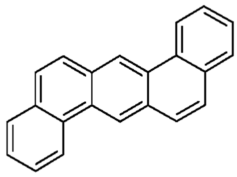
Formel (6)

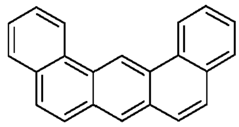
Formel (7)

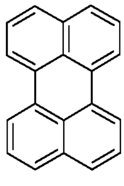
Formel (8)

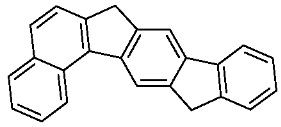
Formel (9)

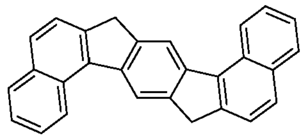
Formel (10)

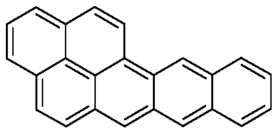
Formel (11)

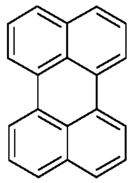
Formel (12)

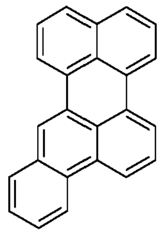
Formel (13)

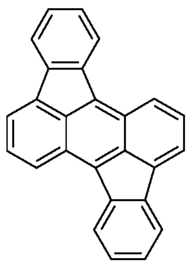
Formel (14)

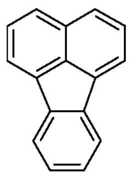
Formel (15)

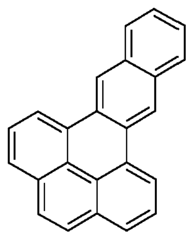
Formel (16)

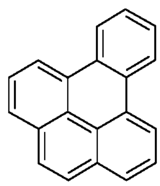
Formel (17)

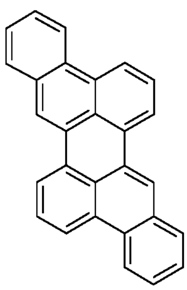
Formel (18)

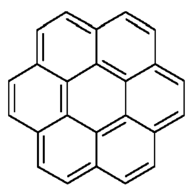
Formel (19)

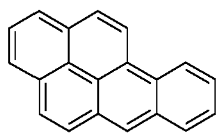
Formel (20)

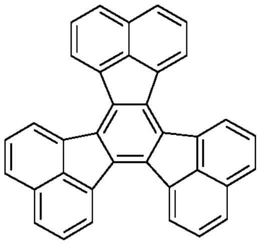
Formel (21)

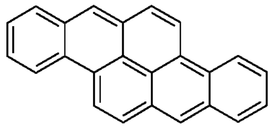
Formel (22)

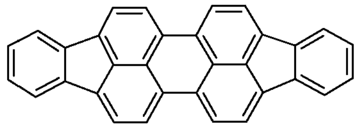
Formel (23)

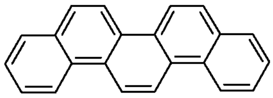
Formel (24)

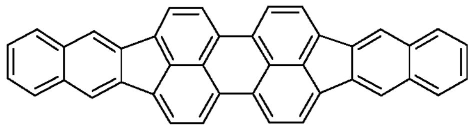
Formel (25)

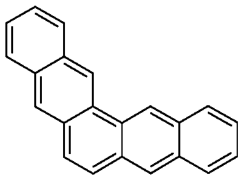
Formel (26)

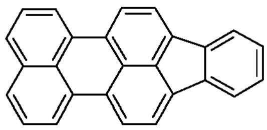
Formel (27)

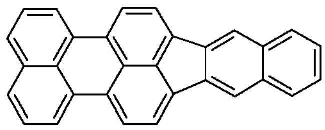
Formel (28)

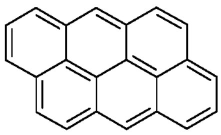
Formel (29)

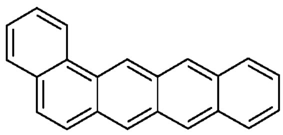
Formel (30)

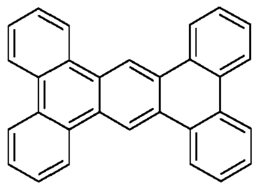
Formel (31)

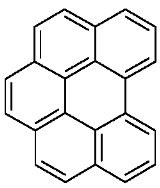
Formel (32)

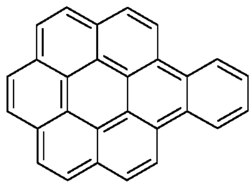
Formel (33)

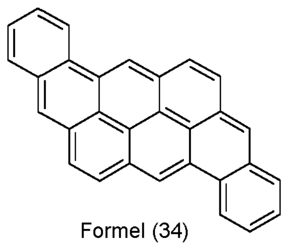
Formel (34)

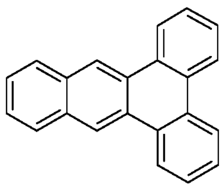
Formel (35)

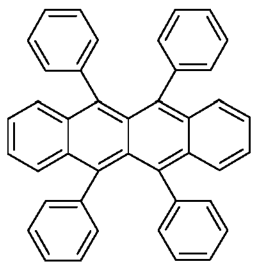
Formel (36)

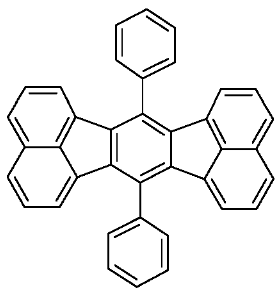
Formel (37)

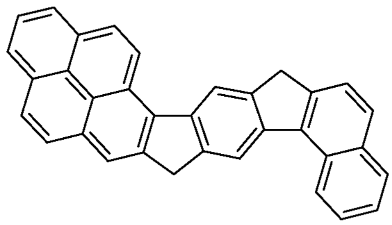

Formel (38)

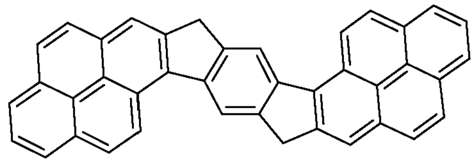

Formel (39)

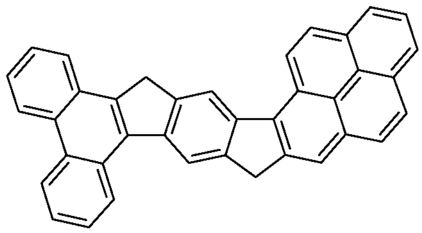

Formel (40)

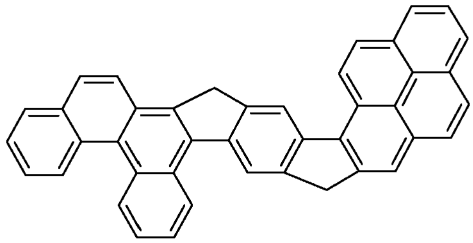

Formel (41)

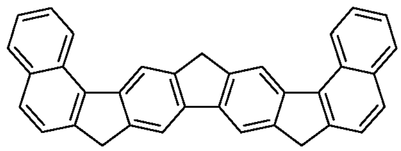

Formel (42)

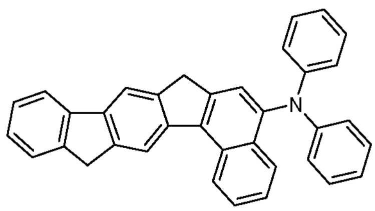

Formel (43)

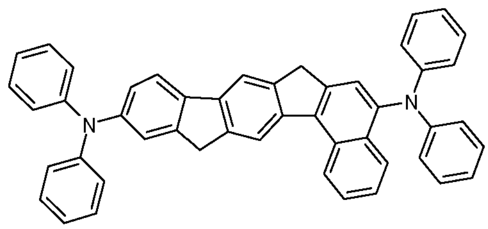

Formel (44)

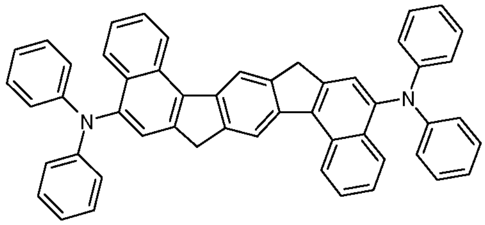

Formel (45)

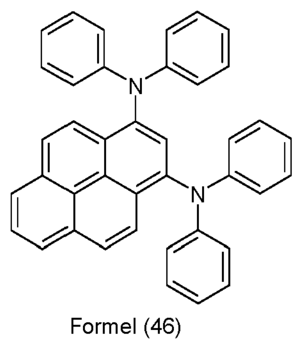

Formel (46)

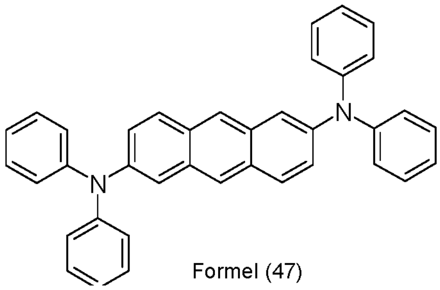

Formel (47)

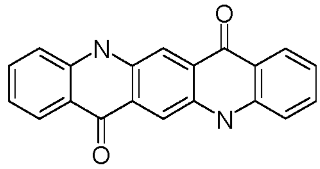

Formel (48)

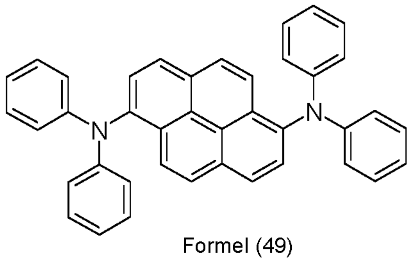

Formel (49)

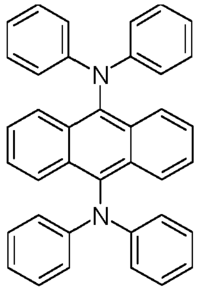

Formel (50) ;

oder aus Verbindungen mit einem heteroaromatischen Grundkörper der im Folgenden aufgeführten Gruppen der Formeln (51) bis (73):

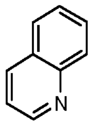

Formel (51)

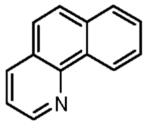

Formel (52)

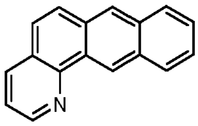

Formel (53)

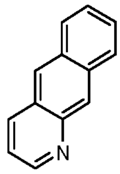

Formel (54)

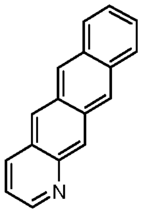

Formel (55)

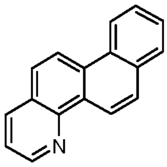

Formel (56)

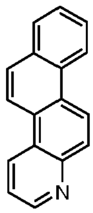

Formel (57)

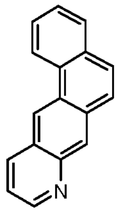

Formel (58)

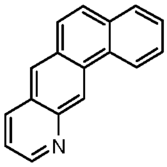

Formel (59)

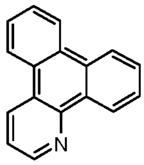

Formel (60)

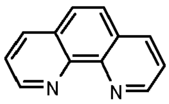

Formel (61)

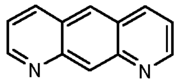

Formel (62)

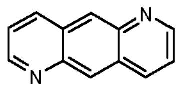

Formel (63)

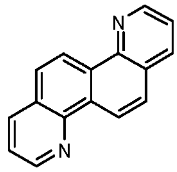

Formel (64)

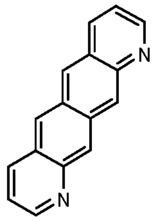

Formel (65)

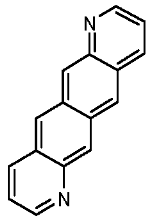

Formel (66)

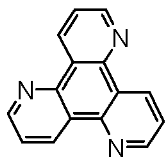

Formel (67)

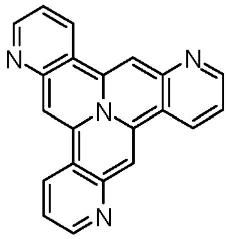

Formel (68)

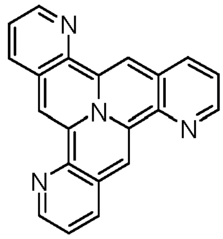

Formel (69)

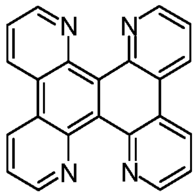

Formel (70)

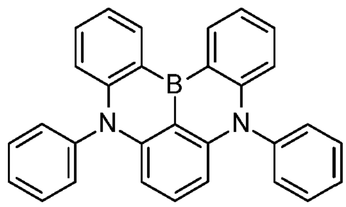

Formel (71)

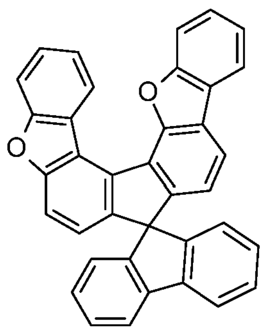

Formel (72)

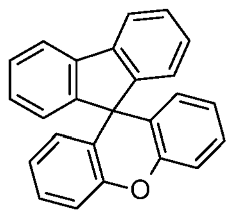

Formel (73)

.

**2.** Die elektronische Vorrichtung gemäß Anspruch 1, **dadurch gekennzeichnet, dass** wenigstens eine der beiden

folgenden Bedingungen (I) oder (II) erfüllt sein muss, wobei bevorzugt ist, wenn Bedingung (I) erfüllt ist:

$$S_1^K(FE) - S_1^K(S) \geq X \quad \text{(I)}$$

$$S_1^{max}(FE) - S_1^{max}(S) \geq Y \quad \text{(II)}$$

wobei für die verwendeten Parameter gilt:

X, Y, sind jeweils -0,5 eV
$S_1^K(FE)$ ist die Energie des ersten angeregten Singulett-Zustandes des fluoreszierenden Emitters, die aus der Kante des ersten Maximums auf der Seite der kurzen Wellenlänge des normierten Photolumineszenzspektrums des fluoreszierenden Emitters ermittelt wird;
$S_1^K(S)$ ist die Energie des ersten angeregten Zustandes des Sensitizers, die aus der Kante des ersten Maximums auf der Seite der kurzen Wellenlänge des normierten Photolumineszenzspektrums des Sensitizers ermittelt wird;
$S_1^{max}(FE)$ ist die Energie des ersten angeregten Singulett-Zustandes des fluoreszierenden Emitters, die aus der Lage des ersten Maximums bei kleinen Wellenlängen des Photolumineszenzspektrums des fluoreszierenden Emitters ermittelt wird;
$S_1^{max}(S)$ ist die Energie des ersten angeregten Zustandes des Sensitizers, die aus der Lage des ersten Maximums bei kleinen Wellenlängen des Photolumineszenzspektrums des Sensitizers ermittelt wird;
wobei die Photolumineszenzspektren des Sensitizers und des fluoreszierenden Emitters bei einer Konzentration von 1 mg in 100 ml Toluol bei Raumtemperatur aus Lösung bestimmt werden.

3. Die Vorrichtung gemäß Anspruch 2, **dadurch gekennzeichnet, dass** X und Y -0,4 eV sind, bevorzugt -0,3 eV, ganz bevorzugt -0,2 eV, ganz besonders bevorzugt -0,1 eV, insbesondere bevorzugt 0,0 eV und am meisten bevorzugt 0,1 eV sind.

4. Die Vorrichtung gemäß Anspruch 2 oder 3, **dadurch gekennzeichnet, dass** die beiden Bedingung (I) und (II) erfüllt sind.

5. Die Vorrichtung gemäß einem oder mehreren der Ansprüche 1 bis 4, **dadurch gekennzeichnet, dass** Anregungsenergie von dem Sensitizer auf den fluoreszierenden Emitter übertragen wird und der fluoreszierende Emitter vom Sensitizer aufgenommene Anregungsenergie durch Fluoreszenz emittiert.

6. Die Vorrichtung gemäß einem oder mehreren der Ansprüche 1 bis 5, **dadurch gekennzeichnet, dass** das Photolumineszenzemissionsspektrum des Sensitizers mit dem Absorptionsspektrum des fluoreszierenden Emitters überlappt.

7. Die Vorrichtung gemäß einem oder mehreren der Ansprüche 1 bis 6, **dadurch gekennzeichnet, dass** die *Metal-to-Ligand-Charge-Transfer (MLCT)* Bande des Photolumineszenzspektrums des Sensitizers mit dem Absorptionsspektrum des fluoreszierenden Emitters überlappt.

8. Die Vorrichtung gemäß einem oder mehreren der Ansprüche 1 bis 7, **dadurch gekennzeichnet, dass** der Betrag des Abstands zwischen der Triplett-*Metal-to-Ligand-Charge-Transfer* ($^3$MLCT)-Bande des Photolumineszenzspektrums des Sensitizers und dem Absorptionsmaximum des fluoreszierenden Emitters die folgende Bedingung (III) erfüllt

$$\left|\lambda_{em}^{3MLCT}(S) - \lambda_{abs}^{max}(FE)\right| \leq V \quad \text{(III)}$$

wobei V gleich 0,5 eV ist, bevorzugt ist ein V von 0,4 eV, ganz bevorzugt ist ein V von 0,3 eV, besonders bevorzugt ist ein V von 0,2 eV und ganz besonders bevorzugt ist ein V von 0,15 eV;

und wobei $\lambda_{em}^{3MLCT}(S)$ die Triplett-*Metal-to-Ligand-Charge-Transfer* ($^3$MLCT)-Bande des Photolumineszenzspektrums des Sensitizers ist und sich aus der Kante im Photolumineszenzspektrum des Sensitizers ergibt und $\lambda_{abs}^{max}(FE)$ die Peakabsorptionswellenlänge des ersten Maximums bei langen Wellenlängen des fluoreszierenden Emitters darstellt, wobei die Werte jeweils in Elektronenvolt berechnet sind.

9. Die Vorrichtung gemäß einem oder mehreren der Ansprüche 1 bis 8, **dadurch gekennzeichnet, dass** die folgende Bedingung (IV) erfüllt ist

$$\lambda_{em}^{3MLCT}(S) - \lambda_{abs}^{max}(FE) \leq W \qquad \text{(IV)}$$

wobei W gleich 0,5 eV ist, bevorzugt ist W kleiner oder gleich 0,4 eV, ganz bevorzugt ist W gleich 0,3 eV, insbesondere bevorzugt ist W gleich 0,2 eV;

und wobei $\lambda_{em}^{3MLCT}(S)$ die Triplett-*Metal-to-Ligand-Charge-Transfer* ($^3$MLCT)-Bande des Photolumineszenzspektrums des Sensitizers ist und sich aus der Kante im Photolumineszenzspektrum des Sensitizers ergibt und $\lambda_{abs}^{max}(FE)$ die Peakabsorptionswellenlänge des ersten Maximums bei langen Wellenlängen des fluoreszierenden Emitters darstellt, wobei die Werte jeweils in Elektronenvolt berechnet sind.

10. Die Vorrichtung gemäß einem oder mehreren der Ansprüche 1 bis 9, **dadurch gekennzeichnet, dass** die aromatischen und heteroaromatischen Grundkörper durch sterisch anspruchsvolle Substituenten substituiert sind, die vorzugsweise ausgewählt sind aus Alkylgruppen mit 3 bis 20 C-Atomen, bevorzugt mit 4 bis 10 C-Atomen, in denen auch H-Atome durch F ersetzt sein können, Alkoxygruppen mit 3 bis 20 C-Atomen, bevorzugt mit 4 bis 10 C-Atomen, Aralkylgruppen mit 7 bis 30 C-Atomen, und aromatische Ringsysteme mit 6 bis 30 C-Atomen, wobei in den Aralkylgruppen und aromatischen Ringsystemen die Arylgruppen auch durch ein oder mehrere Alkylgruppen mit 1 bis 10 C-Atomen substituiert sein können, und wobei auch mehrere benachbarte Substituenten ein Ringsystem miteinander bilden können.

11. Die Vorrichtung gemäß einem oder mehreren der Ansprüche 1 bis 10, **dadurch gekennzeichnet, dass** es sich bei dem fluoreszierenden Emitter um eine rein organische Verbindung ohne Metalle oder Metallionen handelt, die aus der Gruppe der Pyrene, Perylene, Rubrene, Anthracene, Fluorene und Indenofluorene ausgewählt ist.

12. Die Vorrichtung gemäß einem oder mehreren der Ansprüche 1 bis 11, **dadurch gekennzeichnet, dass** es sich bei dem fluoreszierenden Emitter um eine rein organische Verbindung ohne Metalle oder Metallionen handelt, die mit aromatischen Gruppen substituiert vorliegen kann.

13. Die Vorrichtung gemäß einem oder mehreren der Ansprüche 1 bis 12, **dadurch gekennzeichnet, dass** sich sowohl der Sensitizer als auch der fluoreszierende Emitter in derselben Schicht befinden.

14. Die Vorrichtung gemäß einem oder mehreren der Ansprüche 1 bis 13, **dadurch gekennzeichnet, dass** sich der Sensitizer und der fluoreszierende Emitter in der Emissionsschicht befinden.

15. Die Vorrichtung gemäß einem oder mehreren der Ansprüche 1 bis 14, **dadurch gekennzeichnet, dass** die Schicht, in der sich der Sensitizer und der fluoreszierende Emitter befinden, ein weiteres Material enthält, die ausgewählt ist aus der Gruppe der Elektronentransportmaterialien, Lochleitermaterialien, Quantenmaterialien (vorzugsweise Quantenpunkte), bipolaren Hosts, Wide Band Gap Materialien, phosphoreszierende Emitter, fluoreszierende Emitter, Materialien, die eine verzögerte Fluoreszenz aufweisen.

16. Die Vorrichtung gemäß einem oder mehreren der Ansprüche 1 bis 15, **dadurch gekennzeichnet, dass** die Schicht, in der sich der Sensitizer und der fluoreszierende Emitter befinden, kein weiteres Material enthält.

17. Die Vorrichtung gemäß einem oder mehreren der Ansprüche 1 bis 12, **dadurch gekennzeichnet, dass** sich der Sensitizer und der fluoreszierende Emitter in unterschiedlichen Schichten befindend, die aneinandergrenzen.

18. Die Vorrichtung gemäß Anspruch 17, **dadurch gekennzeichnet, dass** die Vorrichtung einen Bereich mit der Schichtenfolge $[SL/FEL]_n$-SL enthält, wobei n eine ganze Zahl von 1 bis 5 ist, SL ist eine Schicht enthaltend den Sensitizer und FEL ist eine Schicht enthaltend den fluoreszierenden Emitter, und wobei die Sensitizer in den unterschiedlichen Schichten SL verschieden voneinander sein können und wobei die fluoreszierenden Emitter in den unterschiedlichen Schichten FEL verschieden voneinander sein können.

**19.** Zusammensetzung enthaltend wenigstens einen Sensitizer sowie wenigstens einen fluoreszierenden Emitter, wobei der Sensitizer eine phosphoreszierende Verbindung ist und wobei es sich bei dem fluoreszierenden Emitter um eine sterisch abgeschirmte Verbindung handelt, die einen *Shielding Factor* (SF) von größer oder gleich 0,5, bevorzugt größer oder gleich 0,6 und besonders bevorzugt größer oder gleich 0,65 aufweist,

wobei es sich bei dem Sensitizer um eine phosphoreszierende Verbindung aus der Gruppe der Organometallkomplexe handelt, die Cu, Ir, Pt, Rh, Ru, Os, oder Pd und bevorzugt Ir und Pt enthalten, und
wobei es sich bei dem fluoreszierenden Emitter um eine rein organische Verbindung ohne Metalle oder Metallionen handelt, die entweder ausgewählt ist aus der Gruppe der kondensierten Aromaten mit 6 bis 60 aromatischen Ringatomen, wobei der aromatische Grundkörper aus den in Anspruch 1 aufgeführten Gruppen der Formeln (1) bis (50) ausgewählt ist, oder aus Verbindungen mit einem heteroaromatischen Grundkörper der in Anspruch 1 aufgeführten Gruppen der Formeln (51) bis (73).

**20.** Die Zusammensetzung gemäß Anspruch 19, **dadurch gekennzeichnet, dass** die Zusammensetzung wenigstens ein weiteres Material enthält, das ausgewählt ist aus der Gruppe der Elektronentransportmaterialien, Elektroneninjektionsmaterialien, Elektronenblockiermaterialien, Lochtransportmaterialien, Lochinjektionsmaterialien, Lochblockiermaterialien, n-Dotanden, p-Dotanden, Quantenmaterialien (vorzugsweise Quantenpunkte), Host- oder Matrixmaterialien, wide band gap Materialien, phosphoreszierenden Emittern, fluoreszierenden Emittern oder Emittern, die eine verzögerte Fluoreszenz zeigen.

**21.** Formulierung enthaltend eine Zusammensetzung sowie wenigstens ein Lösungsmittel, wobei die Zusammensetzung wenigstens einen Sensitizer sowie wenigstens einen fluoreszierenden Emitter enthält, wobei der Sensitizer eine phosphoreszierende Verbindung ist und wobei es sich bei dem fluoreszierenden Emitter um eine sterisch abgeschirmte Verbindung handelt, die einen *Shielding Factor* (SF) von größer oder gleich 0,5, bevorzugt größer oder gleich 0,6 und besonders bevorzugt größer oder gleich 0,65 aufweist,

wobei es sich bei dem Sensitizer um eine phosphoreszierende Verbindung aus der Gruppe der Organometallkomplexe handelt, die Cu, Ir, Pt, Rh, Ru, Os, oder Pd und bevorzugt Ir und Pt enthalten, und
wobei es sich bei dem fluoreszierenden Emitter um eine rein organische Verbindung ohne Metalle oder Metallionen handelt, die entweder ausgewählt ist aus der Gruppe der kondensierten Aromaten mit 6 bis 60 aromatischen Ringatomen, wobei der aromatische Grundkörper aus den in Anspruch 1 aufgeführten Gruppen der Formeln (1) bis (50) ausgewählt ist, oder aus Verbindungen mit einem heteroaromatischen Grundkörper der in Anspruch 1 aufgeführten Gruppen der Formeln (51) bis (73).

**22.** Formulierung gemäß Anspruch 21, **dadurch gekennzeichnet, dass** die Zusammensetzung wenigstens ein weiteres Material enthält, das ausgewählt ist aus der Gruppe der Elektronentransportmaterialien, Elektroneninjektionsmaterialien, Elektronenblockiermaterialien, Lochtransportmaterialien, Lochinjektionsmaterialien, Lochblockiermaterialien, n-Dotanden, p-Dotanden, Quantenmaterialien (vorzugsweise Quantenpunkte), Host- oder Matrixmaterialien, wide band gap Materialien, phosphoreszierenden Emittern, fluoreszierenden Emittern oder Emittern, die eine verzögerte Fluoreszenz zeigen.

## Claims

**1.** Fluorescent electronic device containing a sensitiser and a fluorescent emitter, where the sensitiser is a phosphorescent compound and where the fluorescent emitter is a sterically shielded compound which has a shielding factor (SF) of greater than or equal to 0.5, particularly preferably greater than or equal to 0.6 and especially preferably greater than or equal to 0.65, where the shielding factor (SF) is determined by the method described in the description,

where the sensitiser is a phosphorescent compound from the group of the organometallic complexes containing Cu, Ir, Pt, Rh, Ru, Os or Pd and preferably Ir and Pt, and
where the fluorescent emitter is a purely organic compound without metals or metal ions which is selected either from the group of the condensed aromatic compounds having 6 to 60 aromatic ring atoms where the aromatic skeleton is selected from the groups of the formulae (1) to (50) shown below:

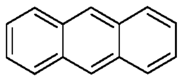
formula (1)

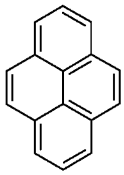
formula (2)

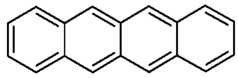
formula (3)

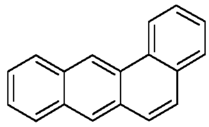
formula (4)

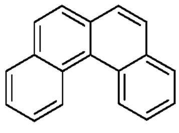
formula (5)

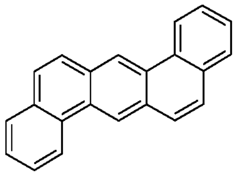
formula (6)

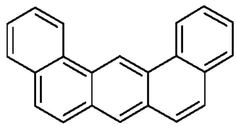
formula (7)

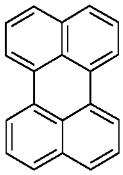
formula (8)

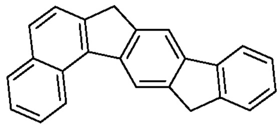
formula (9)

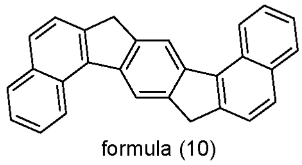
formula (10)

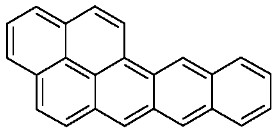
formula (11)

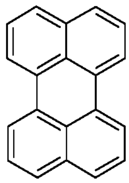
formula (12)

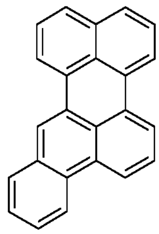
formula (13)

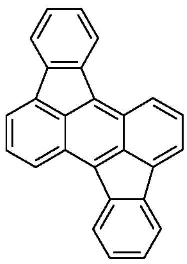
formula (14)

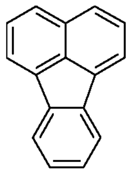
formula (15)

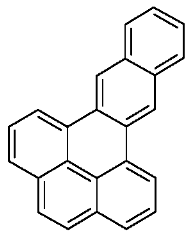
formula (16)

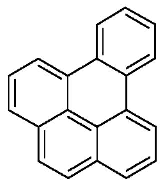
formula (17)

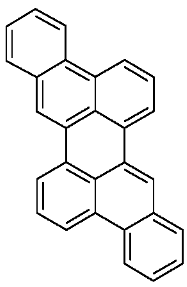
formula (18)

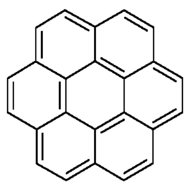
formula (19)

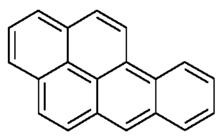
formula (20)

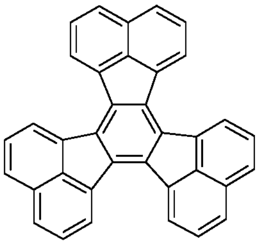

formula (21)

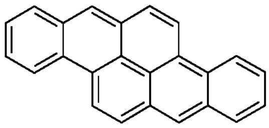

formula (22)

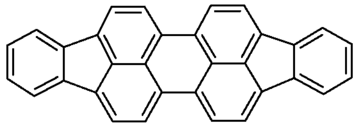

formula (23)

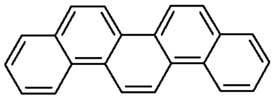

formula (24)

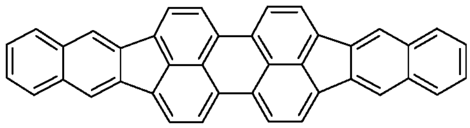

formula (25)

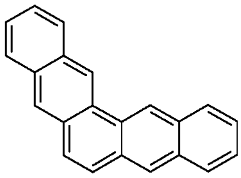

formula (26)

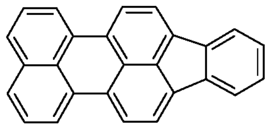

formula (27)

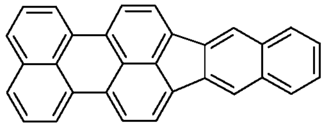

formula (28)

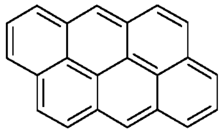

formula (29)

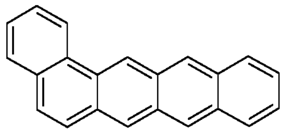

formula (30)

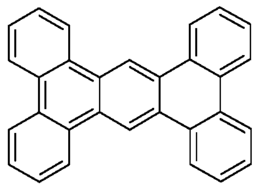

formula (31)

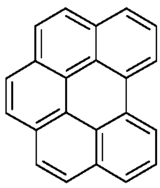

formula (32)

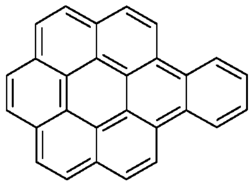

formula (33)

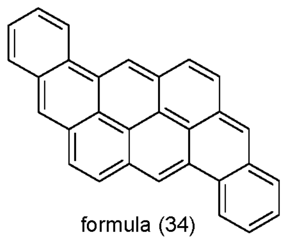

formula (34)

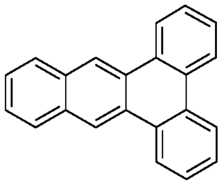

formula (35)

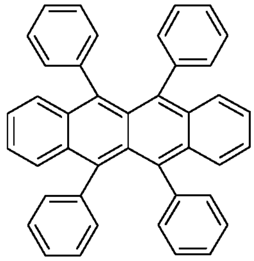

formula (36)

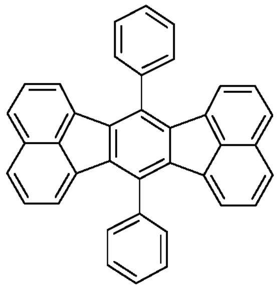

formula (37)

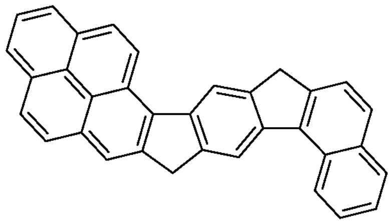

formula (38)

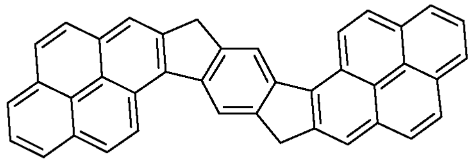

formula (39)

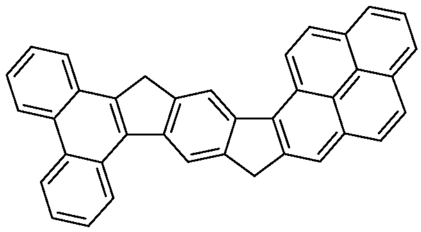

formula (40)

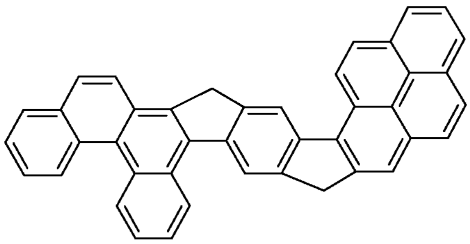

formula (41)

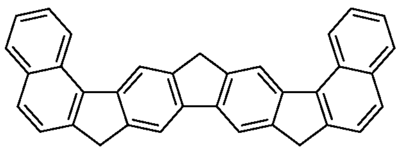

formula (42)

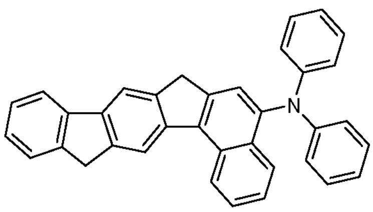

formula (43)

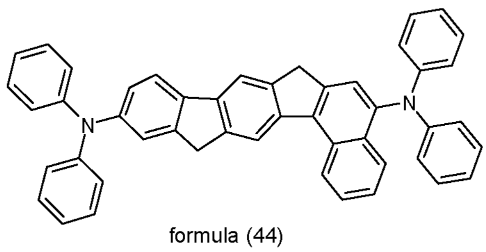

formula (44)

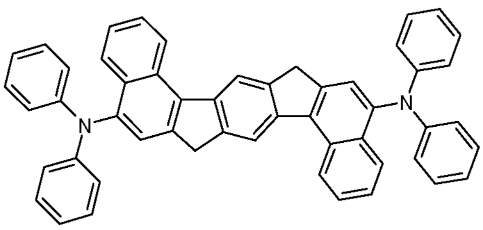

formula (45)

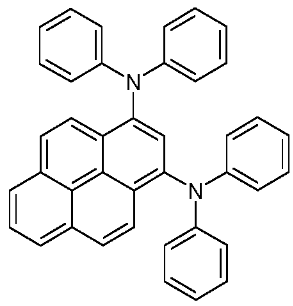

formula (46)

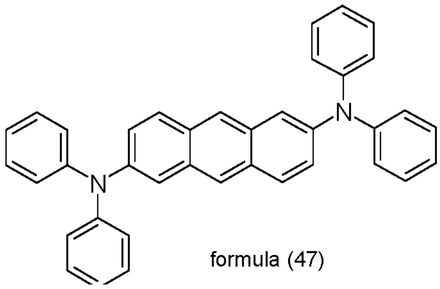

formula (47)

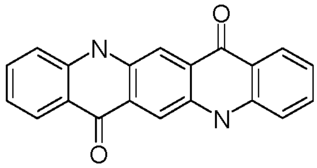

formula (48)

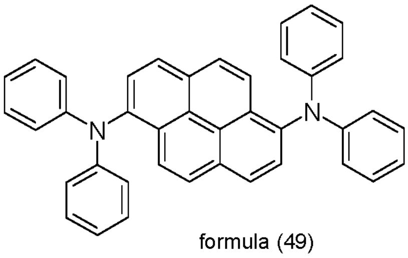

formula (49)

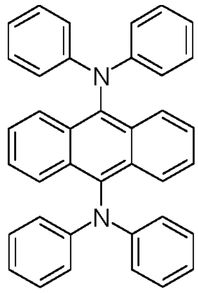

formula (50) ;

or from compounds having a heteroaromatic skeleton from the groups of the formulae (51) to (73) shown below:

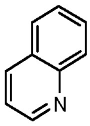

formula (51)

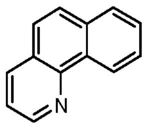

formula (52)

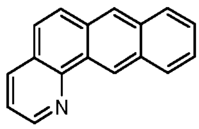

formula (53)

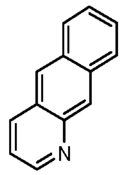

formula (54)

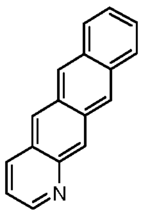

formula (55)

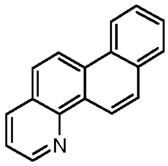

formula (56)

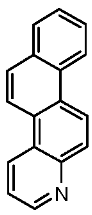

formula (57)

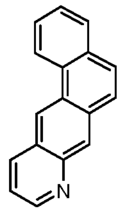

formula (58)

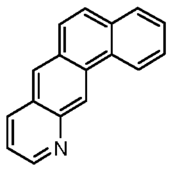

formula (59)

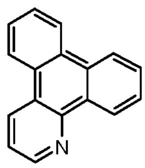

formula (60)

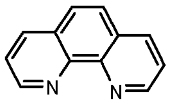

formula (61)

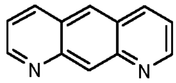

formula (62)

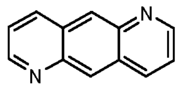

formula (63)

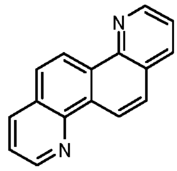

formula (64)

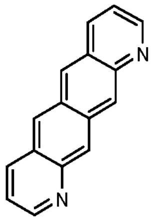

formula (65)

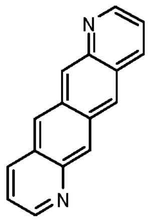

formula (66)

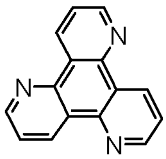

formula (67)

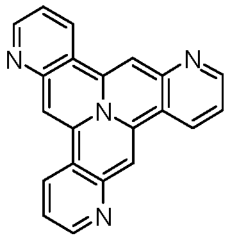

formula (68)

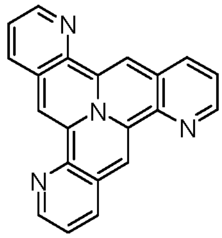

formula (69)

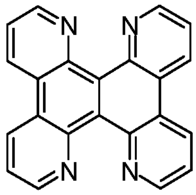

formula (70)

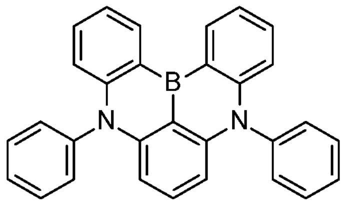

formula (71)

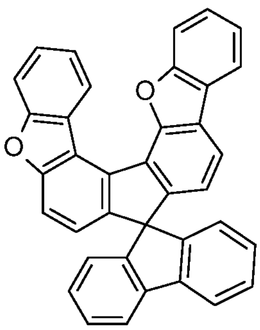

formula (72)

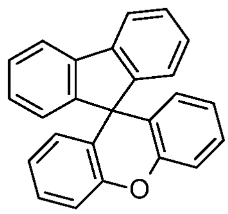

formula (73)

.

**2.** Electronic device according to Claim 1, **characterised in that** at least one of the two following conditions (I) or (II)

must be satisfied, where it is preferred if condition (I) is satisfied:

$$S_1^K(FE) - S_1^K(S) \geq X \quad \text{(I)}$$

$$S_1^{max}(FE) - S_1^{max}(S) \geq Y \quad \text{(II)}$$

where the following applies to the parameters used:

X, Y are each -0.5 eV
$S_1^K(FE)$ is the energy of the first excited singlet state of the fluorescent emitter, which is determined from the edge of the first maximum on the side of the short wavelength of the standardised photoluminescence spectrum of the fluorescent emitter;
$S_1^K(S)$ is the energy of the first excited state of the sensitiser, which is determined from the edge of the first maximum on the side of the short wavelength of the standardised photoluminescence spectrum of the sensitiser;
$S_1^{max}(FE)$ is the energy of the first excited singlet state of the fluorescent emitter, which is determined from the position of the first maximum at small wavelengths of the photoluminescence spectrum of the fluorescent emitter;
$S_1^{max}(S)$ is the energy of the first excited state of the sensitiser, which is determined from the position of the first maximum at small wavelengths of the photoluminescence spectrum of the sensitiser;
where the photoluminescence spectra of the sensitiser and of the fluorescent emitter are determined from solution at a concentration of 1 mg in 100 ml of toluene at room temperature.

3. Device according to Claim 2, **characterised in that** X and Y are -0.4 eV, preferably -0.3 eV, very preferably -0.2 eV, very particularly preferably -0.1 eV, especially preferably 0.0 eV and most preferably 0.1 eV.

4. Device according to Claim 2 or 3, **characterised in that** both conditions (I) and (II) are satisfied.

5. Device according to one or more of Claims 1 to 4, **characterised in that** excitation energy is transferred from the sensitiser to the fluorescent emitter, and the fluorescent emitter emits excitation energy taken up from the sensitiser by fluorescence.

6. Device according to one or more of Claims 1 to 5, **characterised in that** the photoluminescence emission spectrum of the sensitiser overlaps with the absorption spectrum of the fluorescent emitter.

7. Device according to one or more of Claims 1 to 6, **characterised in that** the metal-to-ligand charge transfer (MLCT) band of the photoluminescence spectrum of the sensitiser overlaps with the absorption spectrum of the fluorescent emitter.

8. Device according to one or more of Claims 1 to 7, **characterised in that** the modulus of the separation between the triplet metal-to-ligand charge transfer ($^3$MLCT) band of the photoluminescence spectrum of the sensitiser and the absorption maximum of the fluorescent emitter satisfies the following condition (III)

$$\left|\lambda_{em}^{3MLCT}(S) - \lambda_{abs}^{max}(FE)\right| \leq V \quad \text{(III)}$$

where V is equal to 0.5 eV, a V of 0.4 eV is preferred, a V of 0.3 eV is very preferred, a V of 0.2 eV is particularly preferred and a V of 0.15 eV is very particularly preferred;

and where $\lambda_{em}^{3MLCT}(S)$ is the triplet metal-to-ligand charge transfer ($^3$MLCT) band of the photoluminescence spectrum of the sensitiser and arises from the edge in the photoluminescence spectrum of the sensitiser, and $\lambda_{abs}^{max}(FE)$ represents the peak absorption wavelength of the first maximum at long wavelengths of the fluorescent emitter, where the values are in each case calculated in electron volts.

9. Device according to one or more of Claims 1 to 8, **characterised in that** the following condition (IV) is satisfied

$$\lambda_{em}^{3MLCT}(S) - \lambda_{abs}^{max}(FE) \leq W \qquad \text{(IV)}$$

where W is equal to 0.5 eV, W is preferably less than or equal to 0.4 eV, W is very preferably equal to 0.3 eV, W is especially preferably equal to 0.2 eV;

and where $\lambda_{em}^{3MLCT}(S)$ is the triplet metal-to-ligand charge transfer ($^3$MLCT) band of the photoluminescence spectrum of the sensitiser and arises from the edge in the photoluminescence spectrum of the sensitiser, and $\lambda_{abs}^{max}(FE)$ represents the peak absorption wavelength of the first maximum at long wavelengths of the fluorescent emitter, where the values are in each case calculated in electron volts.

**10.** Device according to one or more of Claims 1 to 9, **characterised in that** the aromatic and heteroaromatic skeletons are substituted by sterically demanding substituents, which are preferably selected from alkyl groups having 3 to 20 C atoms, preferably having 4 to 10 C atoms, in which, in addition, H atoms may be replaced by F, alkoxy groups having 3 to 20 C atoms, preferably having 4 to 10 C atoms, aralkyl groups having 7 to 30 C atoms, and aromatic ring systems having 6 to 30 C atoms, where the aryl groups in the aralkyl groups and aromatic ring systems may also be substituted by one or more alkyl groups having 1 to 10 C atoms, and where, in addition, a plurality of adjacent substituents may form a ring system with one another.

**11.** Device according to one or more of Claims 1 to 10, **characterised in that** the fluorescent emitter is a purely organic compound without metals or metal ions which is selected from the group of the pyrenes, perylenes, rubrenes, anthracenes, fluorenes and indenofluorenes.

**12.** Device according to one or more of Claims 1 to 11, **characterised in that** the fluorescent emitter is a purely organic compound without metals or metal ions which may be present substituted by aromatic groups.

**13.** Device according to one or more of Claims 1 to 12, **characterised in that** both the sensitiser and the fluorescent emitter are located in the same layer.

**14.** Device according to one or more of Claims 1 to 13, **characterised in that** the sensitiser and the fluorescent emitter are located in the emission layer.

**15.** Device according to one or more of Claims 1 to 14, **characterised in that** the layer in which the sensitiser and the fluorescent emitter are located comprises a further material selected from the group of the electron-transport materials, hole-conductor materials, quantum materials (preferably quantum dots), bipolar hosts, wide band gap materials, phosphorescent emitters, fluorescent emitters, materials which have delayed fluorescence.

**16.** Device according to one or more of Claims 1 to 15, **characterised in that** the layer in which the sensitiser and the fluorescent emitter are located does not comprise any further material.

**17.** Device according to one or more of Claims 1 to 12, **characterised in that** the sensitiser and the fluorescent emitter are located in different layers which are adjacent to one another.

**18.** Device according to Claim 17, **characterised in that** the device contains a region having the layer sequence $[SL/FEL]_n$-SL, where n is an integer from 1 to 5, SL is a layer comprising the sensitiser and FEL is a layer comprising the fluorescent emitter, and where the sensitisers in the various layers SL can be different from one another and where the fluorescent emitters in the various layers FEL can be different from one another.

**19.** Composition comprising at least one sensitiser and at least one fluorescent emitter, where the sensitiser is a phosphorescent compound and where the fluorescent emitter is a sterically shielded compound which has a shielding factor (SF) of greater than or equal to 0.5, preferably greater than or equal to 0.6 and particularly preferably greater than or equal to 0.65,

where the sensitiser is a phosphorescent compound from the group of the organometallic complexes containing Cu, Ir, Pt, Rh, Ru, Os or Pd and preferably Ir and Pt, and
where the fluorescent emitter is a purely organic compound without metals or metal ions which is selected either from the group of the condensed aromatic compounds having 6 to 60 aromatic ring atoms where the aromatic

skeleton is selected from the groups of the formulae (1) to (50) shown in Claim 1 or from compounds having a heteroaromatic skeleton from the groups of the formulae (51) to (73) shown in Claim 1.

**20.** Composition according to Claim 19, **characterised in that** the composition comprises at least one further material selected from the group of the electron-transport materials, electron-injection materials, electron-blocking materials, hole-transport materials, hole-injection materials, hole-blocking materials, n-dopants, p-dopants, quantum materials (preferably quantum dots), host or matrix materials, wide band gap materials, phosphorescent emitters, fluorescent emitters or emitters which exhibit a delayed fluorescence.

**21.** Formulation comprising a composition and at lest one solvent, where the composition comprises at least one sensitiser and at least one fluorescent emitter, where the sensitiser is a phosphorescent compound and where the fluorescent emitter is a sterically shielded compound which has a shielding factor (SF) of greater than or equal to 0.5, preferably greater than or equal to 0.6 and particularly preferably greater than or equal to 0.65,

where the sensitiser is a phosphorescent compound from the group of the organometallic complexes containing Cu, Ir, Pt, Rh, Ru, Os or Pd and preferably Ir and Pt, and
where the fluorescent emitter is a purely organic compound without metals or metal ions which is selected either from the group of the condensed aromatic compounds having 6 to 60 aromatic ring atoms where the aromatic skeleton is selected from the groups of the formulae (1) to (50) shown in Claim 1 or from compounds having a heteroaromatic skeleton from the groups of the formulae (51) to (73) shown in Claim 1.

**22.** Formulation according to Claim 21, **characterised in that** the composition comprises at least one further material selected from the group of the electron-transport materials, electron-injection materials, electron-blocking materials, hole-transport materials, hole-injection materials, hole-blocking materials, n-dopants, p-dopants, quantum materials (preferably quantum dots), host or matrix materials, wide band gap materials, phosphorescent emitters, fluorescent emitters or emitters which exhibit a delayed fluorescence.

## Revendications

**1.** Dispositif électronique fluorescent contenant un sensibilisateur et un émetteur fluorescent, où le sensibilisateur est un composé phosphorescent et où l'émetteur fluorescent est un composé stériquement blindé qui présente un facteur de blindage (SF) supérieur ou égal à 0,5, particulièrement préférablement supérieur ou égal à 0,6 et spécialement préférablement supérieur ou égal à 0,65, le facteur de blindage (SF) étant déterminé par la méthode décrite dans la description,

où le sensibilisateur est un composé phosphorescent issu du groupe constitué par les complexes organométalliques contenant Cu, Ir, Pt, Rh, Ru, Os ou Pd et préférablement Ir et Pt, et
où l'émetteur fluorescent est un composé purement organique sans métaux ni ions métalliques qui est choisi dans le groupe constitué par les composés aromatiques condensés ayant de 6 à 60 atomes de cycle aromatique, où le squelette aromatique est choisi parmi les groupements de formules (1) à (50) illustrées ci-après :

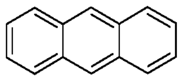

formule (1)

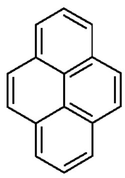

formule (2)

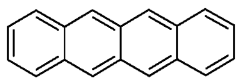

formule (3)

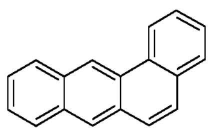

formule (4)

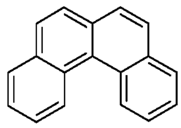

formule (5)

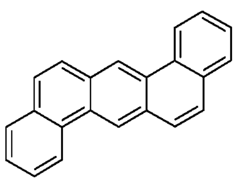

formule (6)

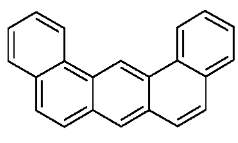

formule (7)

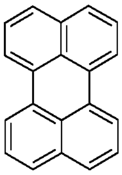
formule (8)

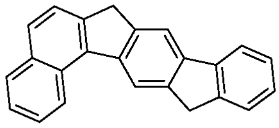
formule (9)

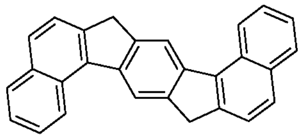
formule (10)

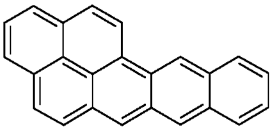
formule (11)

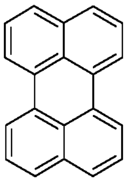
formule (12)

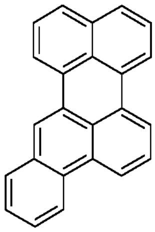
formule (13)

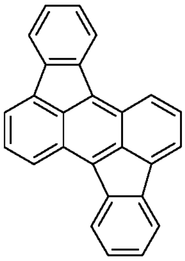
formule (14)

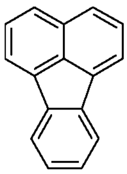
formule (15)

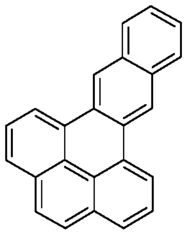
formule (16)

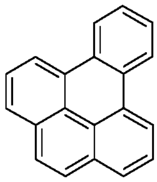
formule (17)

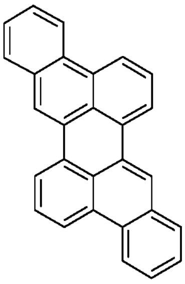
formule (18)

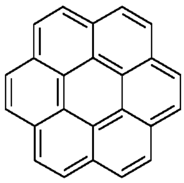
formule (19)

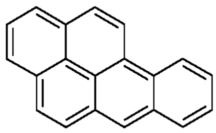
formule (20)

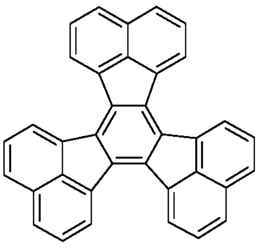
formule (21)

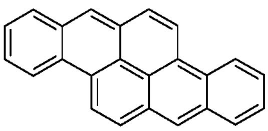
formule (22)

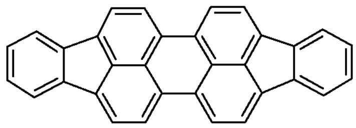
formule (23)

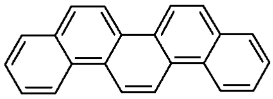

formule (24)

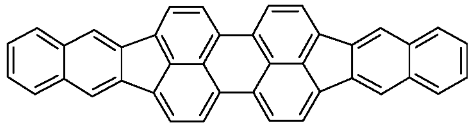

formule (25)

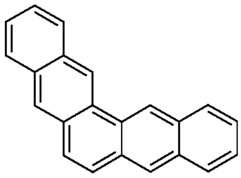

formule (26)

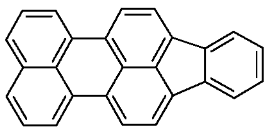

formule (27)

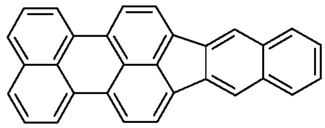

formule (28)

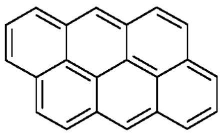

formule (29)

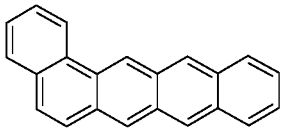

formule (30)

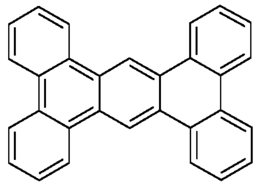

formule (31)

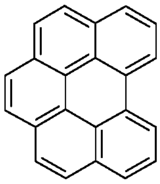

formule (32)

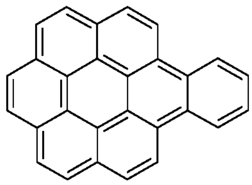

formule (33)

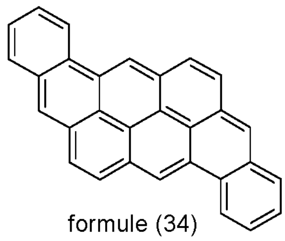

formule (34)

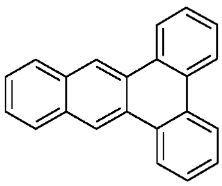

formule (35)

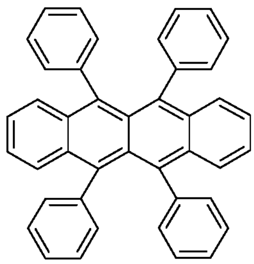

formule (36)

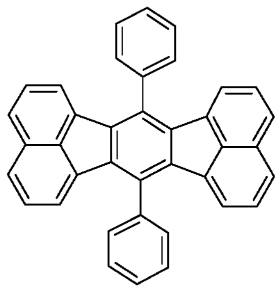

formule (37)

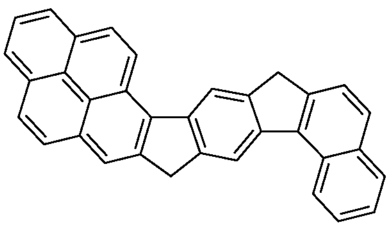

formule (38)

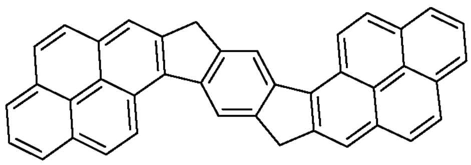

formule (39)

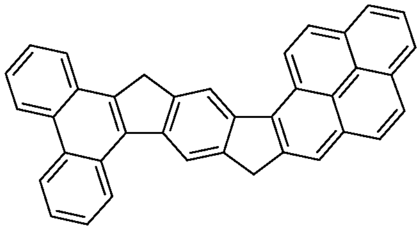

formule (40)

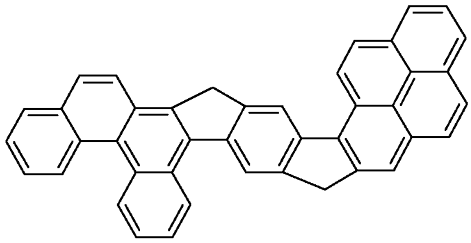

formule (41)

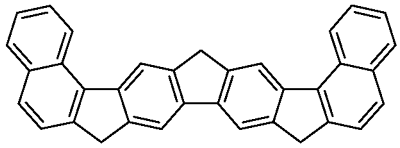

formule (42)

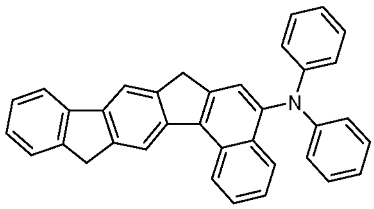

formule (43)

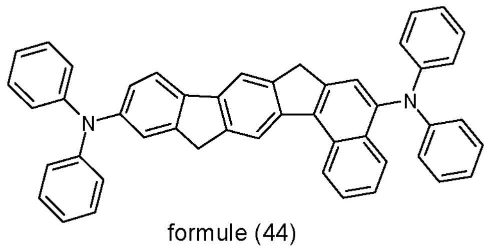

formule (44)

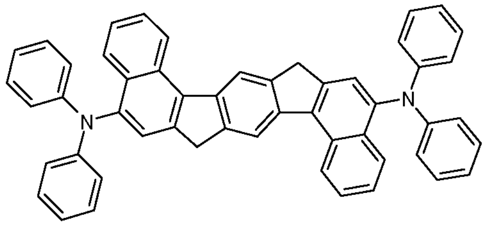

formule (45)

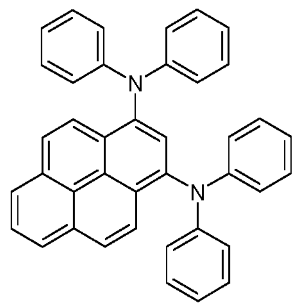

formule (46)

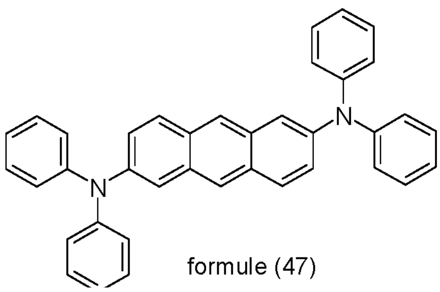

formule (47)

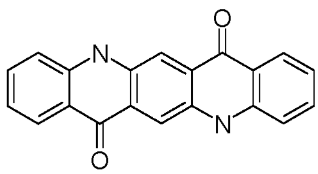

formule (48)

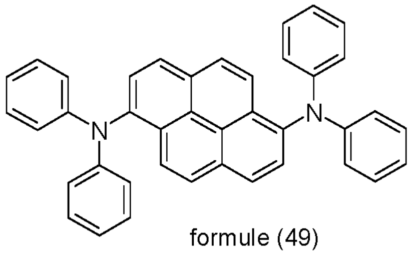

formule (49)

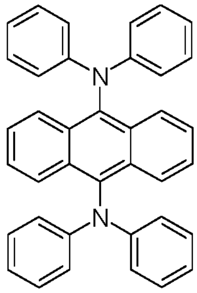

formule (50) ;

ou bien les composés ayant un squelette hétéroaromatique choisi parmi les groupements de formules (51) à (73) illustrées ci-après :

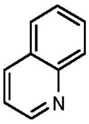

formule (51)

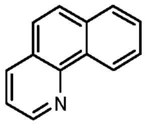

formule (52)

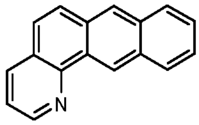

formule (53)

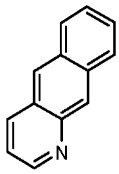

formule (54)

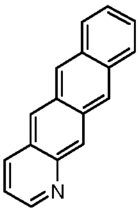

formule (55)

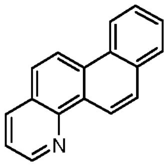

formule (56)

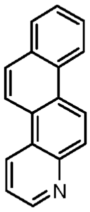

formule (57)

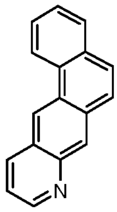

formule (58)

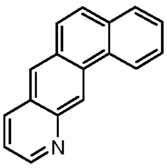

formule (59)

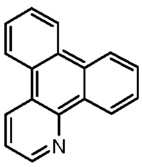

formule (60)

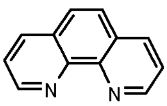

formule (61)

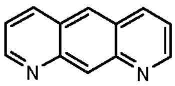

formule (62)

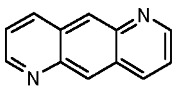

formule (63)

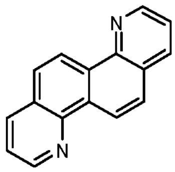

formule (64)

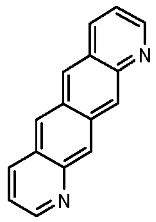

formule (65)

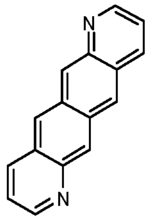

formule (66)

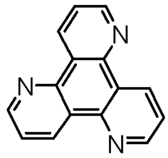

formule (67)

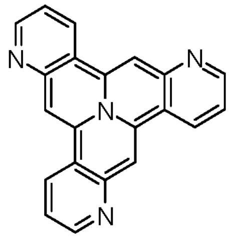

formule (68)

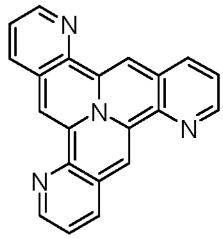

formule (69)

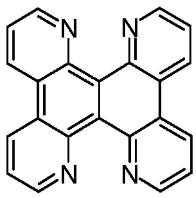

formule (70)

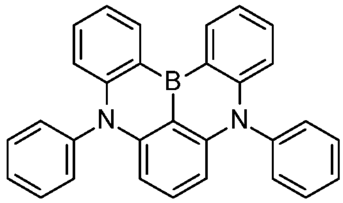

formule (71)

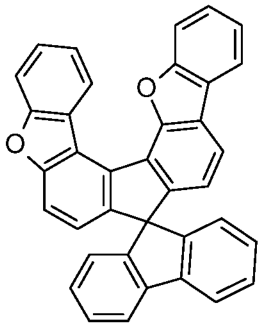

formule (71)

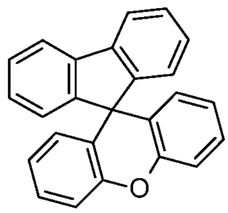

formule (71)

2. Dispositif selon la revendication 1, **caractérisé en ce que** au moins l'une parmi les deux conditions (I) ou (II) suivantes doit être satisfaite, où l'on préfère que la condition (I) soit satisfaite :

$$S_1^K(FE) - S_1^K(S) \geq X \quad \text{(I)}$$

$$S_1^{max}(FE) - S_1^{max}(S) \geq Y \quad \text{(II)}$$

où ce qui suit s'applique aux paramètres utilisés :

X, Y valent chacun -0,5 eV

$S_1^K(FE)$ est l'énergie du premier état singulet excité de l'émetteur fluorescent, qui est déterminée à partir du bord du premier maximum du côté de la longueur d'onde courte du spectre de photoluminescence normalisé de l'émetteur fluorescent ;

$S_1^K(S)$ est l'énergie du premier état excité du sensibilisateur, qui est déterminée à partir du bord du premier maximum du côté de la longueur d'onde courte du spectre de photoluminescence normalisé du sensibilisateur ;

$S_1^{max}(FE)$ est l'énergie du premier état singulet excité de l'émetteur fluorescent, qui est déterminée à partir de la position du premier maximum aux petites longueurs d'onde du spectre de photoluminescence de l'émetteur fluorescent ;

$S_1^{max}(S)$ est l'énergie du premier état excité du sensibilisateur, qui est déterminée à partir de la position du premier maximum aux petites longueurs d'onde du spectre de photoluminescence du sensibilisateur ;

où les spectres de photoluminescence du sensibilisateur et de l'émetteur fluorescent sont déterminés à partir d'une solution à une concentration de 1 mg dans 100 ml de toluène à température ambiante.

**3.** Dispositif selon la revendication 2, **caractérisé en ce que** X et Y valent -0,4 eV, préférablement -0,3 eV, très préférablement -0,2 eV, très particulièrement préférablement -0,1 eV, spécialement préférablement 0,0 eV et tout préférablement 0,1 eV.

**4.** Dispositif selon la revendication 2 ou 3, **caractérisé en ce que** les deux conditions (I) et (II) sont satisfaites.

**5.** Dispositif selon l'une ou plusieurs parmi les revendications 1 à 4, **caractérisé en ce que** l'énergie d'excitation est transférée du sensibilisateur à l'émetteur fluorescent, et l'émetteur fluorescent émet l'énergie d'excitation reprise du sensibilisateur par fluorescence.

**6.** Dispositif selon l'une ou plusieurs parmi les revendications 1 à 5, **caractérisé en ce que** le spectre d'émission de photoluminescence du sensibilisateur se superpose au spectre d'absorption de l'émetteur fluorescent.

**7.** Dispositif selon l'une ou plusieurs parmi les revendications 1 à 6, **caractérisé en ce que** la bande de transfert de charge métal-ligand (MLCT) du spectre de photoluminescence du sensibilisateur se superpose au spectre d'absorption de l'émetteur fluorescent.

**8.** Dispositif selon l'une ou plusieurs parmi les revendications 1 à 7, **caractérisé en ce que** le module de la séparation entre la bande de triplet de transfert de charge métal-ligand ($^3$MLCT) du spectre de photoluminescence du sensibilisateur et le maximum d'absorption de l'émetteur fluorescent satisfait à la condition (III) suivante :

$$\left|\lambda_{em}^{3MLCT}(S) - \lambda_{abs}^{max}(FE)\right| \leq V \qquad \text{(III)}$$

où V est égal à 0,5 eV, un V de 0,4 eV est préféré, un V de 0,3 eV est très préféré, un V de 0,2 eV est particulièrement préféré et un V de 0,15 eV est très particulièrement préféré ;

et où $\lambda_{em}^{3MLCT}(S)$ est la bande de triplet de transfert de charge métal-ligand ($^3$MLCT) du spectre de photoluminescence du sensibilisateur et provient du bord du spectre de photoluminescence du sensibilisateur, et $\lambda_{abs}^{max}(FE)$ représente la longueur d'onde d'absorption maximale du premier maximum aux grandes longueurs d'onde de l'émetteur fluorescent, les valeurs étant dans chaque cas calculées en électronvolts.

**9.** Dispositif selon l'une ou plusieurs parmi les revendications 1 à 8, **caractérisé en ce que** la condition (IV) suivante est satisfaite :

$$\lambda_{em}^{3MLCT}(S) - \lambda_{abs}^{max}(FE) \leq W \qquad \text{(IV)}$$

où W est égal à 0,5 eV, W est préférablement inférieur ou égal à 0,4 eV, W est très préférablement égal à 0,3 eV, W est spécialement préférablement égal à 0,2 eV ;

et où $\lambda_{em}^{3MLCT}(S)$ est la bande de triplet de transfert de charge métal-ligand ($^3$MLCT) du spectre de photoluminescence du sensibilisateur et provient du bord du spectre de photoluminescence du sensibilisateur, et

$\lambda_{abs}^{max}(FE)$ représente la longueur d'onde d'absorption maximale du premier maximum aux grandes longueurs d'onde de l'émetteur fluorescent, les valeurs étant dans chaque cas calculées en électronvolts.

**10.** Dispositif selon l'une ou plusieurs parmi les revendications 1 à 9, **caractérisé en ce que** les squelettes aromatiques et hétéroaromatiques sont substitués par des substituants stériquement exigeants, qui sont préférablement choisis parmi des groupements alkyle ayant de 3 à 20 atomes de C, préférablement ayant de 4 à 10 atomes de C, où, de plus, des atomes de H peuvent être remplacés par F, des groupements alcoxy ayant de 3 à 20 atomes de C, préférablement ayant de 4 à 10 atomes de C, des groupements aralkyle ayant de 7 à 30 atomes de C, et des noyaux aromatiques ayant de 6 à 30 atomes de C, où les groupements aryle dans les groupements aralkyle et les noyaux aromatiques peuvent également être substitués par un ou plusieurs groupements alkyle ayant de 1 à 10 atomes de C, et où, de plus, une pluralité de substituants adjacents peuvent former un noyau les uns avec les autres.

**11.** Dispositif selon l'une ou plusieurs parmi les revendications 1 à 10, **caractérisé en ce que** l'émetteur fluorescent est un composé purement organique sans métaux ni ions métalliques qui est choisi dans le groupe constitué par les pyrènes, pérylènes, rubrènes, anthracènes, fluorènes et indénofluorènes.

**12.** Dispositif selon l'une ou plusieurs parmi les revendications 1 à 11, **caractérisé en ce que** l'émetteur fluorescent est un composé purement organique sans métaux ni ions métalliques qui peut être présent sous forme substituée par des groupements aromatiques.

**13.** Dispositif selon l'une ou plusieurs parmi les revendications 1 à 12, **caractérisé en ce que** le sensibilisateur ainsi que l'émetteur fluorescent sont situés dans la même couche.

**14.** Dispositif selon l'une ou plusieurs parmi les revendications 1 à 13, **caractérisé en ce que** le sensibilisateur et l'émetteur fluorescent sont situés dans la couche d'émission.

**15.** Dispositif selon l'une ou plusieurs parmi les revendications 1 à 14, **caractérisé en ce que** la couche dans laquelle le sensibilisateur et l'émetteur fluorescent sont situés comprend un autre matériau choisi dans le groupe constitué par les matériaux de transport d'électrons, les matériaux conducteurs de trous, les matériaux quantiques (préférablement les points quantiques), les hôtes bipolaires, les matériaux à large bande interdite, les émetteurs phosphorescents, les émetteurs fluorescents, les matériaux qui ont une fluorescence retardée.

**16.** Dispositif selon l'une ou plusieurs parmi les revendications 1 à 15, **caractérisé en ce que** la couche dans laquelle le sensibilisateur et l'émetteur fluorescent sont situés ne comprend aucun autre matériau.

**17.** Dispositif selon l'une ou plusieurs parmi les revendications 1 à 12, **caractérisé en ce que** le sensibilisateur et l'émetteur fluorescent sont situés dans des couches différentes qui sont adjacentes les unes par rapport aux autres.

**18.** Dispositif selon la revendication 17, **caractérisé en ce que** le dispositif contient une région présentant la séquence de couches $[SL/FEL]_n$-SL, où n est un nombre entier allant de 1 à 5, SL est une couche comprenant le sensibilisateur et FEL est une couche comprenant l'émetteur fluorescent, et où les sensibilisateurs dans les diverses couches SL peuvent être différents les uns des autres et où les émetteurs fluorescents dans les diverses couches FEL peuvent être différents les uns des autres.

**19.** Composition comprenant au moins un sensibilisateur et au moins un émetteur fluorescent, où le sensibilisateur est un composé phosphorescent et où l'émetteur fluorescent est un composé stériquement blindé qui présente un facteur de blindage (SF) supérieur ou égal à 0,5, préférablement supérieur ou égal à 0,6 et particulièrement préférablement supérieur ou égal à 0,65,

où le sensibilisateur est un composé phosphorescent issu du groupe constitué par les complexes organométalliques contenant Cu, Ir, Pt, Rh, Ru, Os ou Pd et préférablement Ir et Pt, et
où l'émetteur fluorescent est un composé purement organique sans métaux ni ions métalliques qui est choisi dans le groupe constitué par les composés aromatiques condensés ayant de 6 à 60 atomes de cycle aromatique, où le squelette aromatique est choisi parmi les groupements de formules (1) à (50) illustrées dans la revendication 1, ou bien les composés ayant un squelette hétéroaromatique choisi parmi les groupements de formules (51) à (73) illustrées dans la revendication 1.

**20.** Composition selon la revendication 19, **caractérisée en ce que** la composition comprend au moins un autre matériau choisi dans le groupe constitué par les matériaux de transport d'électrons, les matériaux d'injection d'électrons, les matériaux de blocage d'électrons, les matériaux de transport de trous, les matériaux d'injection de trous, les matériaux de blocage de trous, les dopants de type N, les dopants de type P, les matériaux quantiques (préférablement les points quantiques), les matériaux hôtes ou de matrice, les matériaux à large bande interdite, les émetteurs phosphorescents, les émetteurs fluorescents, ou les émetteurs qui présentent une fluorescence retardée.

**21.** Formulation comprenant une composition et au moins un solvant, où la composition comprend au moins un sensibilisateur et au moins un émetteur fluorescent, où le sensibilisateur est un composé phosphorescent et où l'émetteur fluorescent est un composé stériquement blindé qui présente un facteur de blindage (SF) supérieur ou égal à 0,5, préférablement supérieur ou égal à 0,6 et particulièrement préférablement supérieur ou égal à 0,65,

où le sensibilisateur est un composé phosphorescent issu du groupe constitué par les complexes organométalliques contenant Cu, Ir, Pt, Rh, Ru, Os ou Pd et préférablement Ir et Pt, et
où l'émetteur fluorescent est un composé purement organique sans métaux ni ions métalliques qui est choisi dans le groupe constitué par les composés aromatiques condensés ayant de 6 à 60 atomes de cycle aromatique, où le squelette aromatique est choisi parmi les groupements de formules (1) à (50) illustrées dans la revendication 1, ou bien les composés ayant un squelette hétéroaromatique choisi parmi les groupements de formules (51) à (73) illustrées dans la revendication 1.

**22.** Formulation selon la revendication 21, **caractérisée en ce que** la composition comprend au moins un autre matériau choisi dans le groupe constitué par les matériaux de transport d'électrons, les matériaux d'injection d'électrons, les matériaux de blocage d'électrons, les matériaux de transport de trous, les matériaux d'injection de trous, les matériaux de blocage de trous, les dopants de type N, les dopants de type P, les matériaux quantiques (préférablement les points quantiques), les matériaux hôtes ou de matrice, les matériaux à large bande interdite, les émetteurs phosphorescents, les émetteurs fluorescents, ou les émetteurs qui présentent une fluorescence retardée.

Abbildung 1: PL Spektren in Lösung (Toluol) von FE-03 und PS-01

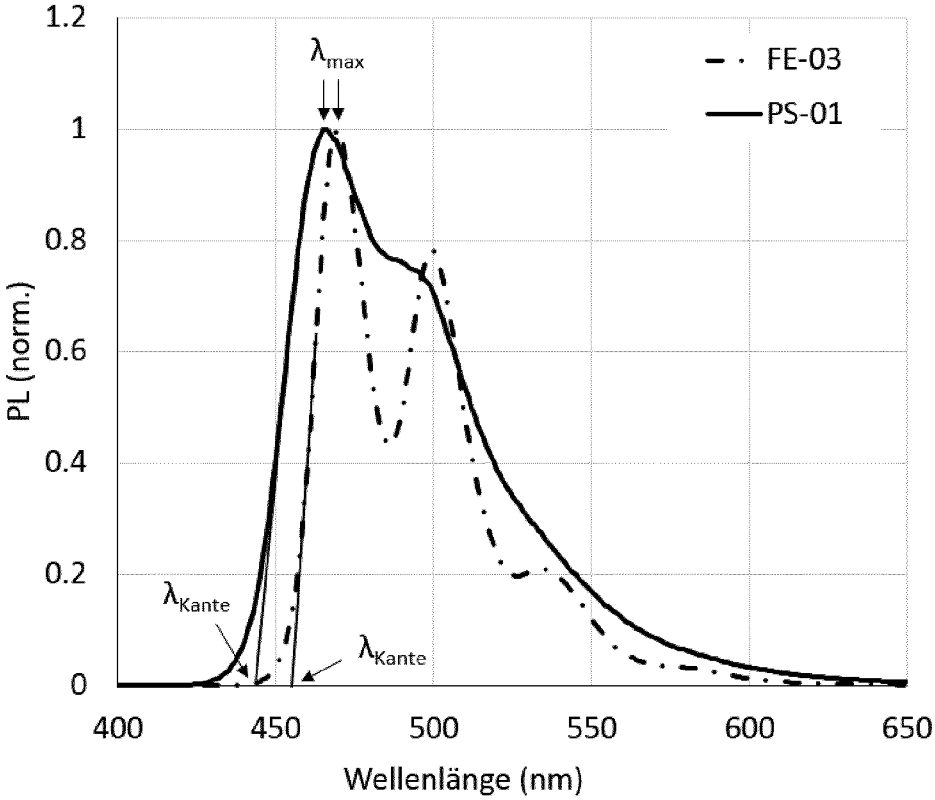

Abbildung 2: EL Spektrum von Experiment 6

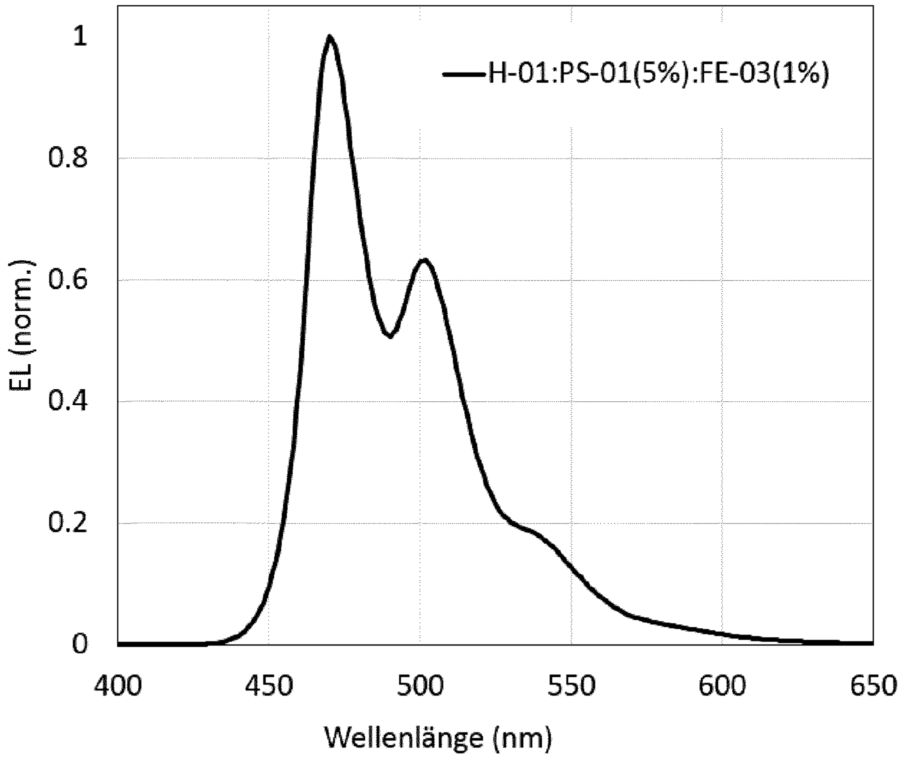

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2015091716 A1
- WO 2016193243 A1
- US 2011303903 A1
- WO 2015091716 A
- WO 0070655 A
- WO 200141512 A
- WO 200202714 A
- WO 200215645 A
- EP 1191612 A
- WO 2005033244 A
- WO 2005019373 A
- US 20050258742 A
- WO 2006056418 A
- WO 2007115970 A
- WO 2007115981 A
- WO 2008000727 A
- WO 2009050281 A
- WO 2009050290 A
- WO 2011051404 A
- WO 2011073149 A
- WO 2012121936 A
- US 20120305894 A
- WO 2012170571 A
- WO 2012170461 A
- WO 2012170463 A
- WO 2006121811 A
- WO 2007095118 A
- WO 2008156879 A
- WO 2010068876 A
- WO 2011106344 A
- WO 2012172482 A
- EP 3126371 A
- WO 2015014835 A
- WO 2015014944 A
- WO 2016020516 A
- US 20160072081 A
- WO 2010086089 A
- WO 2011044988 A
- WO 2014008982 A
- WO 2014023377 A
- WO 2014094961 A
- WO 2010069442 A
- WO 2012163471 A
- WO 2013020631 A
- US 20150243912 A
- WO 2008000726 A
- WO 2010015307 A
- WO 2010054731 A
- WO 2010054728 A
- WO 2010099852 A
- WO 2011032626 A
- WO 2011157339 A
- WO 2012007086 A
- WO 2015036074 A
- WO 2015104045 A
- WO 2015117718 A
- WO 2016015815 A
- WO 2004081017 A
- WO 2005042550 A
- US 20050170206 A
- WO 2009146770 A
- WO 2010102709 A
- WO 2011066898 A
- WO 2016124304 A
- WO 2017032439 A
- WO 2018019688 A
- EP 3184534 A
- WO 2018011186 A
- WO 2016193243 A
- WO 2011045337 A
- US 20150171350 A
- WO 2016079169 A
- WO 2018019687 A
- WO 2018041769 A
- WO 2018054798 A
- WO 2018069196 A
- WO 2018069197 A
- WO 2018069273 A
- WO 2010031485 A
- US 2013150581 A
- WO 2013017675 A
- WO 2013007707 A
- WO 2013001086 A
- WO 2012156378 A
- WO 2013072508 A
- EP 2543672 A
- WO 2014109814 A
- WO 2015135624 A1
- WO 2015135624 A
- EP 18194083
- WO 2004013080 A
- WO 2004093207 A
- WO 2006005627 A
- WO 2010006680 A

- WO 2014015935 A
- WO 2005039246 A
- US 20050069729 A
- JP 2004288381 A
- EP 1205527 A
- WO 2008086851 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 005111172 A
- WO 2006117052 A
- WO 2010015306 A
- EP 652273 A
- WO 2009062578 A
- WO 2010054729 A
- WO 2010054730 A
- US 20090136779 A
- WO 2010050778 A
- WO 2011042107 A
- WO 2011088877 A
- WO 2012143080 A
- WO 2012048781 A
- WO 2011116865 A
- WO 2011137951 A
- WO 2013064206 A
- WO 2014094963 A
- WO 2015192939 A
- WO 2015169412 A
- WO 2016015810 A
- WO 2016023608 A
- EP 16158460
- EP 16159829
- WO 2005011013 A
- US 2010102709 A1
- WO 2015007729 A1
- US 2012241681 A
- WO 11073149 A1
- WO 12172482 A1
- US 20060025642 A
- US 20060025617 A

**In der Beschreibung aufgeführte Nicht-Patentliteratur**

- Highly efficient white organic light-emitting devices based on a multiple-emissive-layer structure. **CHENG G et al.** THIN SOLID FILMS. ELSEVIER, 02. Juni 2008, vol. 516, 5133-5136
- Lambertian white topemitting organic light emitting device with carbon nanotube cathode. **FREITAG P et al.** JOURNAL OF APPLIED PHYSICS. AMERICAN INSTITUTE OF PHYSICS, 01. Dezember 2012, vol. 112, 114505-1, 114505-5
- **MICHEAL L. CONNOLLY.** Computation of Molecular Volume. *J. Am. Chem. Soc.,* 1985, vol. 107, 1118-1124
- **XU D ; ZHANG Y.** Generating Triangulated Macromolecular Surfaces by Euclidean Distance Transform. *PLoS ONE,* 2009, vol. 4 (12), e8140
- **C. H. CHEN et al.** Recent developments in organic electroluminescent materials. *Macromol. Symp.,* 1997, vol. 125, 1-48
- Recent progress of molecular organic electroluminescent materials and devices. *Mat. Sci. and Eng. R,* 2002, vol. 39, 143-222
- **B Y. LIU et al.** *Nature Reviews Materials,* 2018, vol. 3, 18020
- **Z. YANG et al.** *Chem. Soc. Rev.,* 2017, vol. 46, 915
- **M. S. ARNOLD et al.** *Appl. Phys. Lett.,* 2008, vol. 92, 053301
- *CHEMICAL ABSTRACTS,* 94928-86-6
- *CHEMICAL ABSTRACTS,* 80663-92-9
- *CHEMICAL ABSTRACTS,* 517-51-1
- *CHEMICAL ABSTRACTS,* 682806-51-5
- *Eur. J. Org. Chem.,* 2011, 4160
- *CHEMICAL ABSTRACTS,* 850797-15-8
- *CHEMICAL ABSTRACTS,* 850797-14-7